# EUROPEAN PATENT APPLICATION

(11) **EP 4 481 494 A2**
(43) Date of publication of application: **25.12.2024**
(21) Application number: 24182214.7
(22) Date of filing: 14.06.2024
(51) Int. Cl.: G03F 7/004, G03F 7/038

(54) **CHEMICALLY AMPLIFIED NEGATIVE RESIST COMPOSITION AND RESIST PATTERN FORMING PROCESS**

(30) Priority: 22.06.2023 JP 2023102388
(71) Applicant: SHIN-ETSU CHEMICAL CO., LTD., Tokyo 1000005 (JP)
(72) Inventor: Fukushima, Masahiro, NIIGATA-KEN (JP)
(74) Representative: Ter Meer Steinmeister & Partner

(57) **Abstract**

A chemically amplified negative resist composition comprising (A) a photoacid generator in the form of an onium salt of alkane sulfone type having a bulky substituent at α-position of the sulfo group and a bulky aromatic ring structure in the anion and (B) a base polymer is provided. The resist composition exhibits a high resolution during pattern formation and forms a pattern with satisfactory LER and fidelity.

## Description

### TECHNICAL FIELD

This invention relates to a chemically amplified negative resist composition and a resist pattern forming process using the same.

### BACKGROUND ART

To meet the demand for higher integration density and operating speed of LSIs, the effort to reduce the pattern rule is in rapid progress. Acid-catalyzed chemically amplified resist compositions are most often used in forming resist patterns with a feature size of 0.2 µm or less. High-energy radiation such as UV, deep-UV or EB is used as the light source for exposure of these resist compositions. In particular, while EB lithography is utilized as the ultra-fine microfabrication technique, it is also indispensable in processing photomask blanks to form photomasks for use in semiconductor device fabrication.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography because they exhibit strong absorption at a wavelength of around 200 nm. These polymers, however, are expected to form useful resist materials for the EB and EUV lithography for forming patterns of smaller size than the processing limit of ArF excimer laser because they offer high etching resistance.

One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. In recent years, the multibeam mask writing (MBMW) process is used in the processing of mask blanks to achieve further miniaturization. The resist used in the MBMW process is a low-sensitivity resist (or high-dose region) which is advantageous in roughness while a spotlight is brought to the optimization of the resist composition in the high-dose region.

Resist compositions for photolithography include positive ones in which exposed areas are dissolved away and negative ones in which exposed areas are left as a pattern. A viable composition is selected among them depending on the desired resist pattern. In general, the chemically amplified negative resist composition comprises a polymer which is normally soluble in an aqueous alkaline developer, an acid generator which is decomposed to generate an acid upon exposure to light, and a crosslinker which causes the polymer to crosslink in the presence of the acid serving as a catalyst, thus rendering the polymer insoluble in the developer (sometimes, the crosslinker is incorporated in the polymer). Most often a quencher is added for controlling the diffusion of the acid generated upon light exposure.

Typical of the alkali-soluble units to constitute polymers which dissolve in aqueous alkaline developer are units derived from phenols. A number of negative resist compositions of such type were developed, especially as adapted for exposure to KrF excimer laser light. These compositions have not been used in the ArF excimer laser lithography because the phenolic units are not transmissive to exposure light having a wavelength of 150 to 220 nm. Recently, these compositions are recognized attractive again as the negative resist composition for the short wavelength (e.g., EB or EUV) lithography capable of forming smaller size patterns. Exemplary compositions are described in Patent Documents 1 to 3.

Of many acid generators known in the art, Patent Document 4 describes a sulfonium salt capable of generating a sulfonic acid having an iodized aromatic group. This sulfonium salt aims to enhance the sensitization effect in the EUV lithography and is mainly handled as a quencher for fluorinated alkane sulfonic acids. The sulfonium salt has not been fully studied as the acid generator, especially for use in resist compositions comprising polyhydroxystyrene as a base polymer as used in the EB writing process in the processing of mask blanks.

Attempts were made to ameliorate resist sensitivity and pattern profile in a controlled way by properly selecting and combining components used in resist compositions and adjusting processing conditions. One outstanding problem is the diffusion of acid because acid diffusion has a significant impact on the resolution of a chemically amplified resist composition.

The quencher is, in fact, essential for controlling acid diffusion and improving resist performance, especially resolution. Studies have been made on the quencher while amines and weak acid onium salts have been generally used. The weak acid onium salts are exemplified in several patent documents. For example, Patent Document 5 describes that the addition of triphenylsulfonium acetate ensures to form a satisfactory resist pattern without T-top profile, a difference in line width between isolated and grouped patterns, and standing waves. Patent Document 6 describes the addition of ammonium salts of sulfonic acids or carboxylic acids for achieving improvements in sensitivity, resolution and exposure margin. Also, Patent Document 7 describes that a resist composition for KrF or EB lithography comprising a PAG capable of generating a fluorinated carboxylic acid is improved in resolution and process latitudes such as exposure margin and depth of focus. Patent Document 8 describes that a resist composition for F₂ lithography using F₂ laser comprising a PAG capable of generating a fluorinated carboxylic acid is improved in LER and overcomes the footing problem. These compositions are used in the KrF, EB and F₂ lithography processes.

Patent Document 9 describes a positive photosensitive composition for ArF lithography comprising a carboxylic acid onium salt. This system is based on the mechanism that a salt exchange occurs between a weak acid onium salt and a strong acid (sulfonic acid) generated by a PAG upon exposure, to form a weak acid and a strong acid onium salt. That is, the strong acid (sulfonic acid) having high acidity is replaced by a weak acid (carboxylic acid), thereby suppressing acid-catalyzed decomposition reaction of acid labile group and reducing or controlling the distance of acid diffusion. The onium salt apparently functions as a quencher.

In addition to further improvements in roughness, resist compositions are recently demanded which are capable of forming not only line-and-space (LS), isolated line (IL) and isolated space (IS) patterns of satisfactory profile, but also dot patterns of satisfactory profile. Patent Document 10 describes an acid generator capable of generating a bulky acid with controlled diffusion, from which patterns having satisfactory resolution and roughness are obtainable, but the formation of dot patterns is accompanied with corner rounding.

### Citation List

Patent Document 1: JP-A 2006-201532 (US 20060166133, EP 1684118)
Patent Document 2: JP-A 2006-215180
Patent Document 3: JP-A 2008-249762 (USP 9075306, EP 1975711)
Patent Document 4: JP 6645464
Patent Document 5: JP 3955384 (USP 6479210)
Patent Document 6: JP-A H11-327143
Patent Document 7: JP 4231622 (USP 6485883)
Patent Document 8: JP 4116340 (USP 7214467)
Patent Document 9: JP 4226803 (USP 6492091)
Patent Document 10: JP 6248882

### DISCLOSURE OF INVENTION

An object of the invention is to provide a chemically amplified negative resist composition which exhibits an improved resolution upon pattern formation and forms a pattern with reduced LER and high fidelity, and a resist pattern forming process using the same.

The inventor has found that when an onium salt of alkane sulfone type having a bulky substituent at α-position of the sulfo group and a bulky aromatic ring structure in the anion is added as an acid generator to a resist composition, the onium salt generates an acid having an appropriate acidity and the bulky anion structure restrains rotation of the linking group, which is effective for restraining excessive diffusion of the acid. A pattern with minimal LER is obtainable from the resist composition. A dot pattern of satisfactory rectangularity is obtainable by virtue of properly inhibited dissolution.

Accordingly, the invention provides a chemically amplified negative resist composition and resist pattern forming process, as defined below.
1. A chemically amplified negative resist composition comprising (A) a photoacid generator in the form of an onium salt having the formula (A) and (B) a base polymer containing a polymer comprising repeat units having the formula (B1), 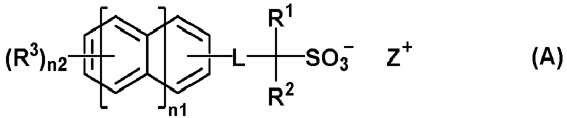 wherein n1 is an integer of 0 to 2, n2 is an integer of 2 to 5 in case of n1=0, an integer of 2 to 7 in case of n1=1, and an integer of 2 to 9 in case of n1=2,
   L is a single bond, ether bond, ester bond, sulfonate ester bond, carbonate bond or carbamate bond,
   R¹ and R² are each independently hydrogen or a C₃-C₂₀ branched or cyclic hydrocarbyl group which may contain a heteroatom, R¹ and R² are not hydrogen at the same time, and R¹ and R² may bond together to form a ring with the carbon atom to which they are attached,
   R³ is each independently iodine or a C₃-C₂₀ branched or cyclic hydrocarbyl group which may contain a heteroatom, at least one R³ being attached to the carbon atom adjoining the carbon atom to which L is attached, and
   Z⁺ is an onium cation, 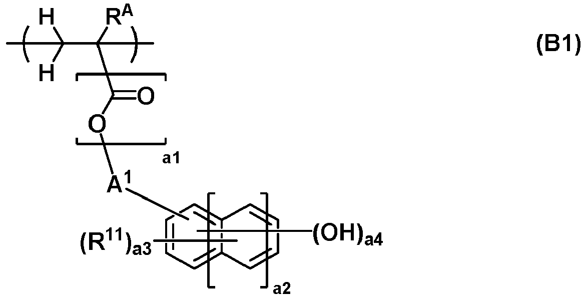
   wherein a1 is 0 or 1, a2 is an integer of 0 to 2, a3 is an integer satisfying 0 ≤ a3 ≤ 5+2(a2)-a4, and a4 is an integer of 1 to 3,
   R^{A} is hydrogen, fluorine, methyl or trifluoromethyl,
   R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
   A¹ is a single bond or a C₁-C₁₀ saturated hydrocarbylene group in which some -CH₂-may be replaced by -O-.
2. The negative resist composition of 1 wherein component (A) is an onium salt having the formula (A1): 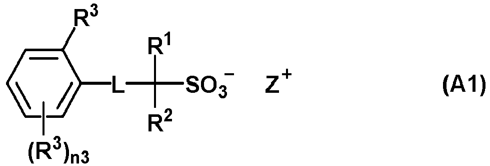 wherein L, R¹, R², R³ and Z⁺ are as defined above, n3 is an integer of 1 to 4.
3. The negative resist composition of 2 wherein component (A) is an onium salt having the formula (A2): 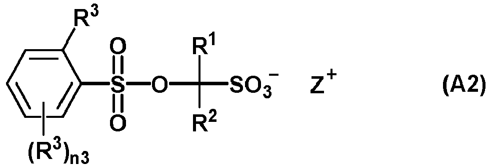 wherein n3, R¹, R², R³ and Z⁺ are as defined above.
4. The negative resist composition of any one of 1 to 3 wherein Z⁺ is a sulfonium cation having the formula (cation-1) or iodonium cation having the formula (cation-2): 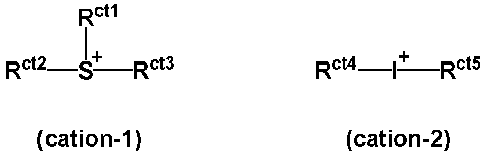 wherein R^{ct1} to R^{ct5} are each independently halogen or a C₁-C₃₀ hydrocarbyl group which may contain a heteroatom, R^{ct1} and R^{ct2} may bond together to form a ring with the sulfur atom to which they are attached.
5. The negative resist composition of any one of 1 to 4 wherein the polymer further comprises repeat units having the formula (B2): 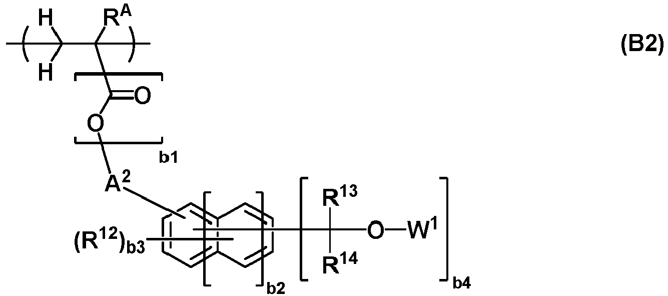 wherein b 1 is 0 or 1, b2 is an integer of 0 to 2, b3 is an integer satisfying 0 ≤ b3 ≤ 5+2(b2)-b4, b4 is an integer of 1 to 3,
   R^{A} is hydrogen, fluorine, methyl or trifluoromethyl,
   R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
   R¹³ and R¹⁴ are each independently hydrogen, a C₁-C₁₅ saturated hydrocarbyl group which may be substituted with a hydroxy or saturated hydrocarbyloxy moiety, or an optionally substituted aryl group, R¹³ and R¹⁴ are not hydrogen at the same time, R¹³ and R¹⁴ may bond together to form a ring with the carbon atom to which they are attached,
   A² is a single bond or C₁-C₁₀ saturated hydrocarbylene group in which some -CH₂may be replaced by -O-, and
   W¹ is hydrogen, a C₁-C₁₀ aliphatic hydrocarbyl group or an optionally substituted aryl group.
6. The negative resist composition of any one of 1 to 5 wherein the polymer further comprises repeat units of at least one type selected from repeat units having the formula (B3), repeat units having the formula (B4), and repeat units having the formula (B5): 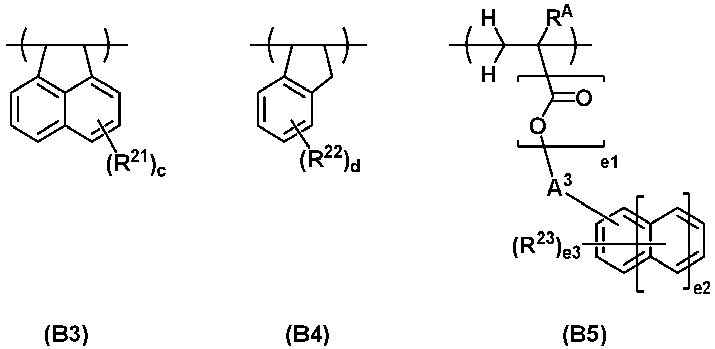 wherein c and d are each independently an integer of 0 to 4, e1 is 0 or 1, e2 is an integer of 0 to 5, and e3 is an integer of 0 to 2,
   R^{A} is hydrogen, fluorine, methyl or trifluoromethyl,
   R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
   R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, cyano group, C₁-C₂₀ saturated hydrocarbylsulfinyl group, or C₁-C₂₀ saturated hydrocarbylsulfonyl group, and
   A³ is a single bond or C₁-C₁₀ saturated hydrocarbylene group in which some -CH₂may be replaced by -O-.
7. The negative resist composition of 5 wherein the polymer further comprises repeat units of at least one type selected from repeat units having the formulae (B6) to (B13): 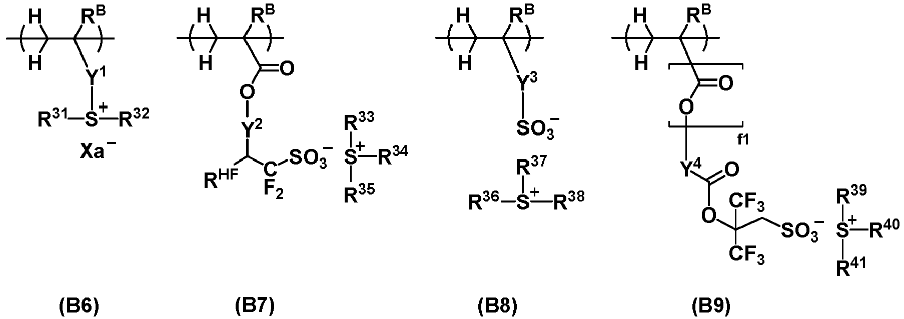 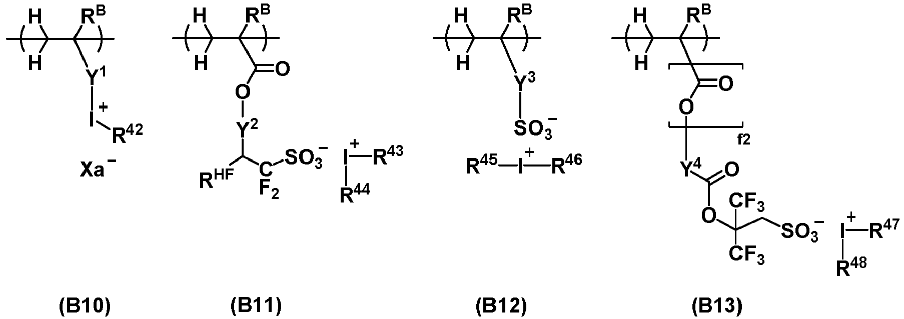 wherein R^{B} is each independently hydrogen or methyl,
   Y¹ is a single bond, a C₁-C₆ aliphatic hydrocarbylene group, phenylene group, naphthylene group or C₇-C₁₈ group obtained by combining the foregoing, *-O-Y¹¹-, *-C(=O)-O-Y¹¹-, or *-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
   Y² is a single bond or **-Y²¹-C(=O)-O-, Y²¹ is a C₁-C₂₀ hydrocarbylene group which may contain a heteroatom,
   Y³ is a single bond, methylene, ethylene, phenylene, fluorinated phenylene, trifluoromethyl-substituted phenylene, *-O-Y³¹-, *-C(=O)-O-Y³¹-, or *-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
   * designates a point of attachment to the carbon atom in the backbone, ** designates a point of attachment to the oxygen atom in the formula,
   Y⁴ is a single bond or C₁-C₃₀ hydrocarbylene group which may contain a heteroatom,
   f1 and f2 are each independently 0 or 1, f1 and f2 are 0 when Y⁴ is a single bond,
   R³¹ to R⁴⁸ are each independently halogen or a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
   R^{HF} is hydrogen or trifluoromethyl, and
   Xa⁻ is a non-nucleophilic counter ion.
8. The negative resist composition of 7 wherein the polymer further comprises repeat units having the formula (B 1-1), repeat units having the formula (B2-1) or repeat units having the formula (B2-2), and repeat units having the formula (B7): 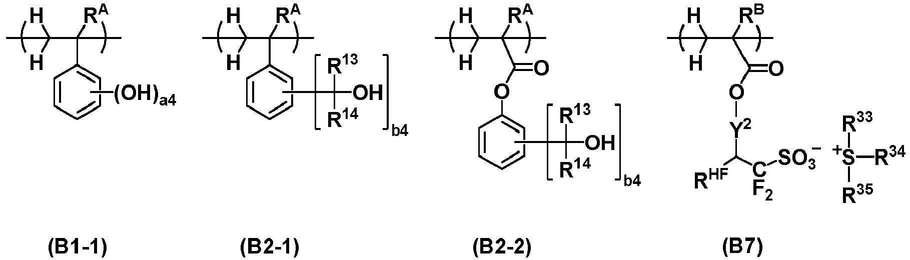 wherein a4, b4, R^{A}, R^{B}, Y², R¹³, R¹⁴, R³³, R³⁴, R³⁵, and R^{HF} are as defined above.
9. The negative resist composition of 7 wherein the base polymer (B) further contains a polymer comprising repeat units having formula (B1) and repeat units having formula (B2), but not repeat units having formulae (B6) to (B13).
10. The negative resist composition of any one of 1 to 9 wherein repeat units having an aromatic ring structure account for at least 60 mol% of the overall repeat units of the polymer in the base polymer.
11. The negative resist composition of any one of 1 to 10, further comprising (C) a crosslinker.
12. The negative resist composition of 5 which is free of a crosslinker.
13. The negative resist composition of any one of 1 to 12, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 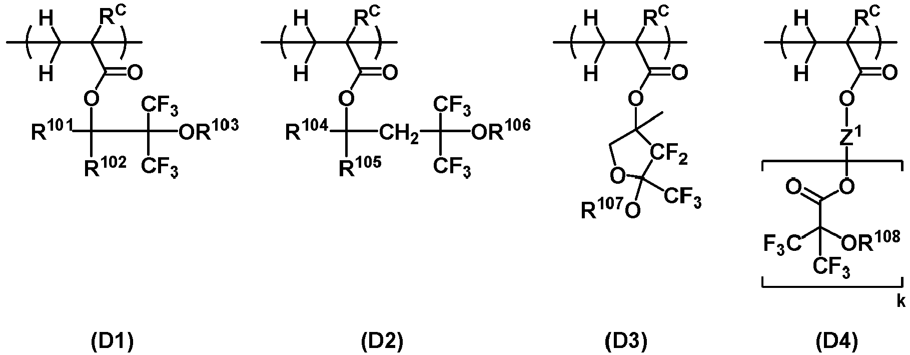 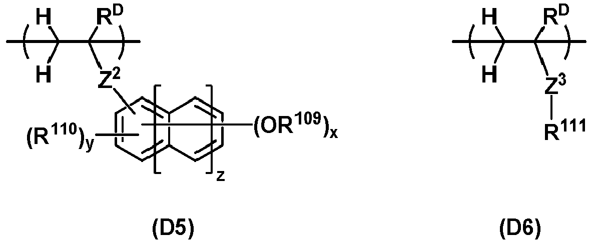 wherein x is an integer of 1 to 3, y is an integer satisfying 0 ≤ y ≤ 5+2z-x, z is 0 or 1, k is an integer of 1 to 3,
   R^{C} is each independently hydrogen, fluorine, methyl or trifluoromethyl,
   R^{D} is each independently hydrogen or methyl,
   R¹⁰¹, R¹⁰², R¹⁰⁴ and R¹⁰⁵ are each independently hydrogen or a C₁-C₁₀ saturated hydrocarbyl group,
   R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
   R¹⁰⁹ is hydrogen or a C₁-C₅ straight or branched hydrocarbyl group in which a heteroatom-containing moiety may intervene in a carbon-carbon bond,
   R¹¹⁰ is a C₁-C₅ straight or branched hydrocarbyl group in which a heteroatom-containing moiety may intervene in a carbon-carbon bond,
   R¹¹¹ is a C₁-C₂₀ saturated hydrocarbyl group in which at least one hydrogen is substituted by fluorine, and in which some -CH₂- may be replaced by an ester bond or ether bond,
   Z¹ is a C₁-C₂₀ (k+1)-valent hydrocarbon group or C₁-C₂₀ (k+1)-valent fluorinated hydrocarbon group,
   Z² is a single bond, *-C(=O)-O- or *-C(=O)-NH-, * designates a point of attachment to the carbon atom in the backbone,
   Z³ is a single bond, -O-, *-C(=O)=O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.
14. The negative resist composition of any one of 1 to 13, further comprising (E) a quencher.
15. The negative resist composition of 14 wherein the acid generator (A) and the quencher (E) are present in a weight ratio of less than 6/1.
16. The negative resist composition of any one of 1 to 15, further comprising (E) an organic solvent.
17. A resist pattern forming process comprising the steps of:
   applying the chemically amplified negative resist composition of any one of 1 to 16 onto a substrate to form a resist film thereon,
   exposing the resist film patternwise to high-energy radiation, and
   developing the exposed resist film in an alkaline developer.
18. The process of 17 wherein the high-energy radiation is EUV or EB.
19. The process of 17 or 18 wherein the substrate has the outermost surface of a material containing at least one element selected from chromium, silicon, tantalum, molybdenum, cobalt, nickel, tungsten, and tin.
20. The process of any one of 17 to 19 wherein the substrate is a mask blank of transmission or reflection type.
21. A mask blank of transmission or reflection type which is coated with the chemically amplified negative resist composition of any one of 1 to 16.

### ADVANTAGEOUS EFFECTS OF INVENTION

Owing to the onium salt having formula (A), the chemically amplified negative resist composition of the invention is effective for controlling acid diffusion during the exposure step. When the composition is coated as a resist film and processed to form a pattern, the resist film exhibits a very high resolution during pattern formation and forms a pattern with high fidelity and reduced LER. Owing to the repeat units having formula (B1), when the resist composition is coated onto a substrate to form a resist film, the adhesion of the composition to the substrate is improved. Also, the dissolution of the resist film in alkaline developer is controlled.

### DESCRIPTION OF PREFERRED EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. In chemical formulae, Me stands for methyl, Ac stands for acetyl, and the broken line (---) and asterisk (*) designate a point of attachment or valence bond. The terms "group" and "moiety" are interchangeable.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator
LER: line edge roughness

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Negative resist composition

One embodiment of the invention is a chemically amplified negative resist composition comprising (A) a photoacid generator in the form of an onium salt of alkane sulfone type having a bulky substituent at α-position of the sulfo group and a bulky aromatic ring structure in the anion, and (B) a base polymer containing a specific polymer.

### (A) Acid generator

The acid generator as component (A) is an onium salt having the formula (A).

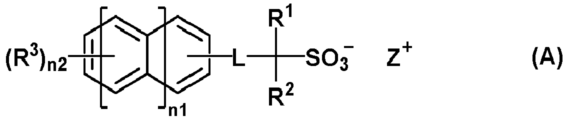

In formula (A), n1 is an integer of 0 to 2. The corresponding structure represents a benzene ring when n1=0, a naphthalene ring when n 1 = 1, and an anthracene ring when n1=2. The benzene ring corresponding to n1=0 is preferred from the aspect of solvent solubility. The subscript n2 is an integer of 2 to 5 in case of n1=0, an integer of 2 to 7 in case of n1=1, and is an integer of 2 to 9 in case of n1=2.

In formula (A), L is a single bond, ether bond, ester bond, sulfonate ester bond, carbonate bond or carbamate bond. Inter alia, an ester bond and sulfonate ester bond are preferred, with the sulfonate ester bond being most preferred.

In formula (A), R¹ and R² are each independently hydrogen or a C₃-C₂₀ branched or cyclic hydrocarbyl group which may contain a heteroatom. It is excluded that both R¹ and R² are hydrogen. When both R¹ and R² are hydrogen or straight hydrocarbyl groups, the groups in the proximity to -SO₃⁻ are less bulky, leading to a failure to restrain apparent acid diffusion and degradation of lithography properties.

The hydrocarbyl group represented by R¹ and R² may be saturated or unsaturated. Examples thereof include, but are not limited to, C₃-C₂₀ branched alkyl groups such as isopropyl, sec-butyl, tert-butyl, tert-pentyl, and 2-ethylhexyl; C₃-C₂₀ cyclic aliphatic hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, oxanorbornyl, tricyclo[5.2.1.0^{2,6}]decyl, and adamantyl; C₆-C₂₀ aryl groups such as phenyl, naphthyl and anthracenyl; and combinations thereof. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group contains hydroxy moiety, cyano moiety, fluorine, chlorine, bromine, iodine, carbonyl moiety, ether bond, ester bond, sulfonate ester bond, carbonate bond, lactone ring, sultone ring, carboxylic anhydride (-C(=O)-O-C(=O)-), or haloalkyl moiety. Suitable halogen atoms include fluorine, chlorine, bromine and iodine, with fluorine and iodine being preferred.

Also, R¹ and R² may bond together to form a ring with the carbon atom to which they are attached. Examples of the ring include cyclopropane, cyclobutane, cyclopentane, cyclohexane, norbornane, and adamantane rings. In the ring, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the ring contains hydroxy moiety, cyano moiety, fluorine, chlorine, bromine, iodine, carbonyl moiety, ether bond, ester bond, sulfonate ester bond, carbonate bond, lactone ring, sultone ring, carboxylic anhydride (-C(=O)-O-C(=O)-), or haloalkyl moiety.

In formula (A), R³ is each independently iodine or a C₃-C₂₀ branched or cyclic hydrocarbyl group which may contain a heteroatom, at least one R³ is attached to the carbon atom adjoining the carbon atom to which L is attached. Examples of the hydrocarbyl group are as exemplified above for the hydrocarbyl groups R¹ and R².

Examples of the structure that R³ forms with the aromatic ring in formula (A) are shown below, but not limited thereto. Herein, the broken line designates a point of attachment to L.

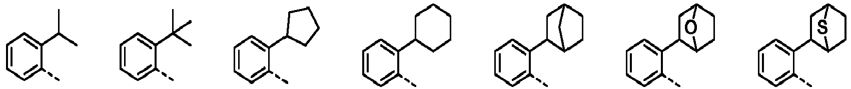

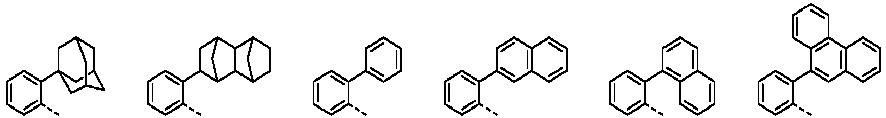

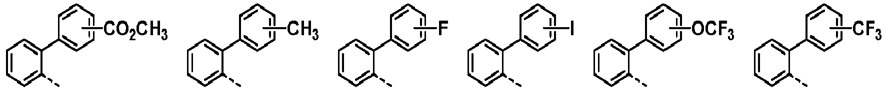

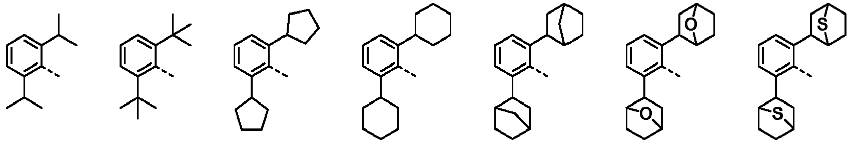

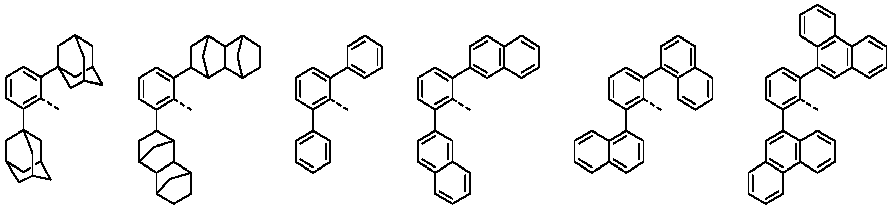

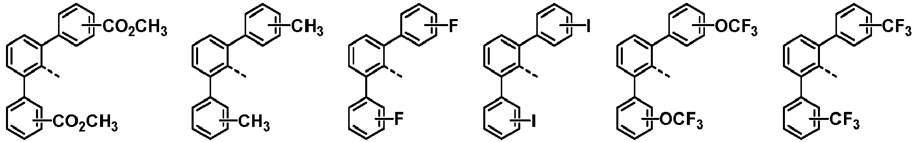

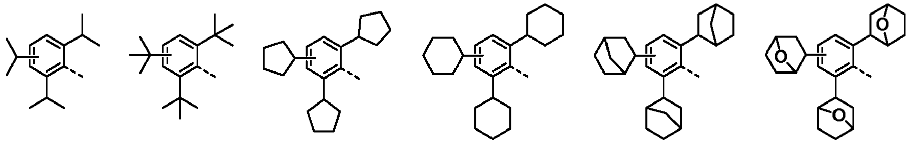

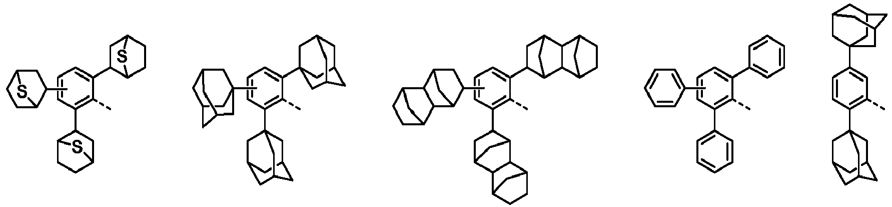

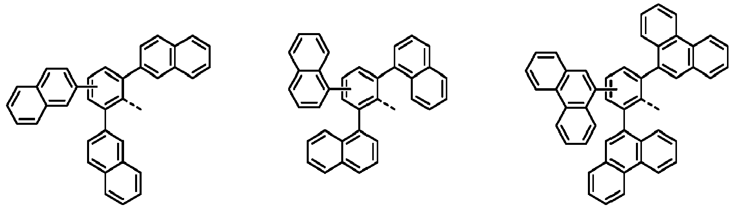

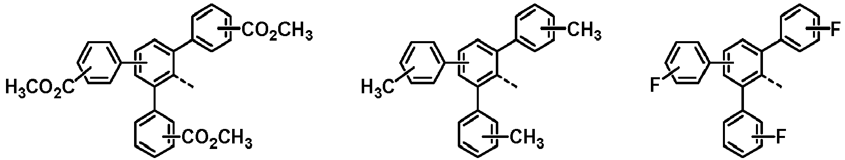

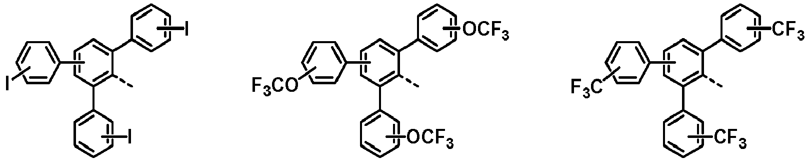

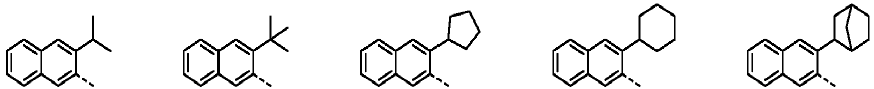

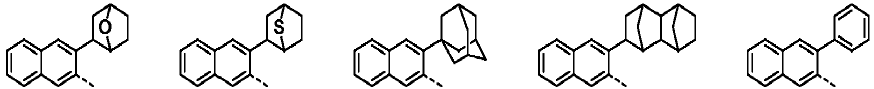

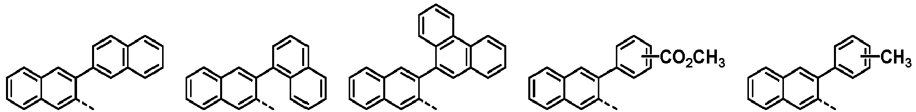

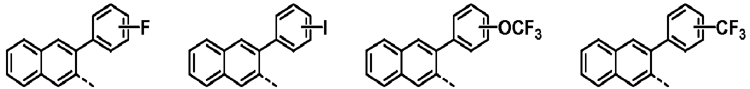

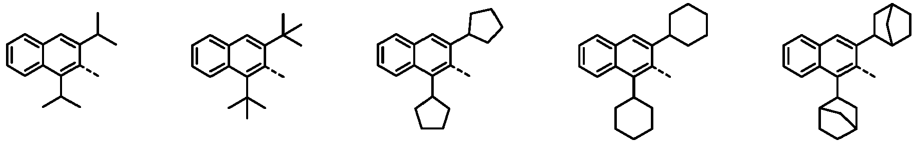

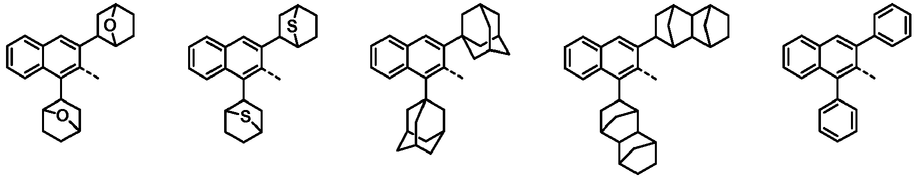

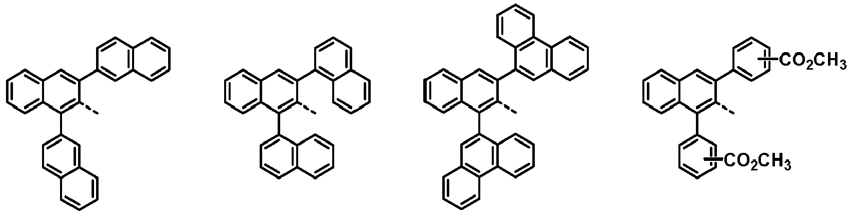

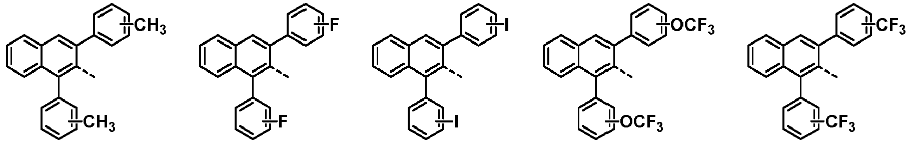

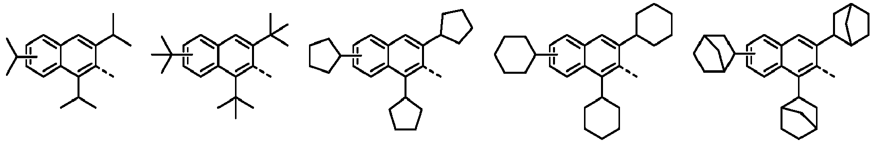

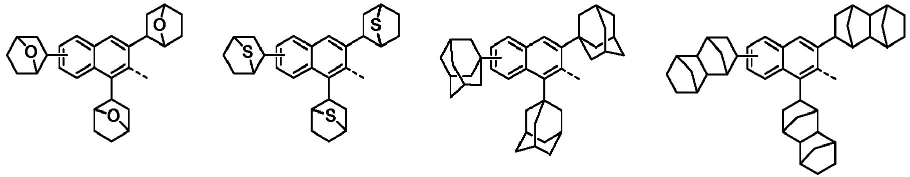

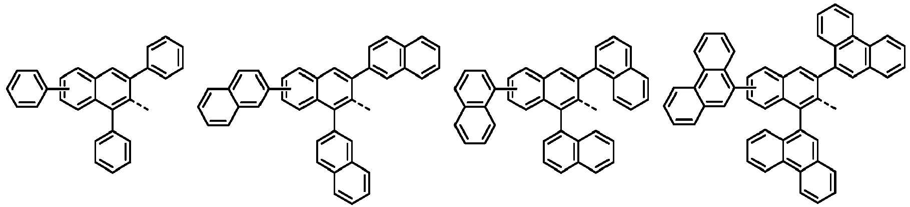

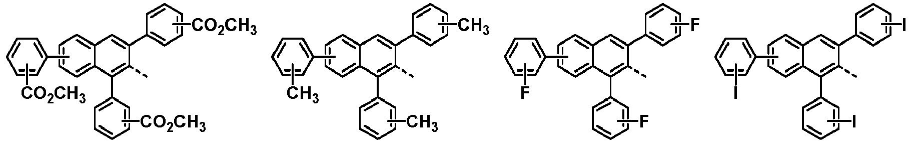

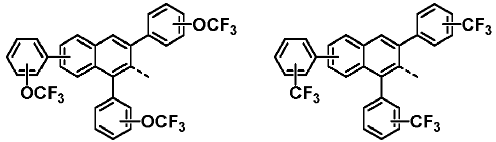

Of the onium salts having formula (A), those having the formula (A1) are preferred. 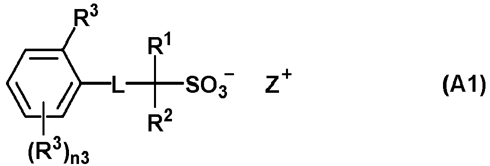 Herein L, R¹, R², R³ and Z⁺ are as defined above, n3 is an integer of 1 to 4.

Of the onium salts having formula (A1), those having the formula (A2) are more preferred. 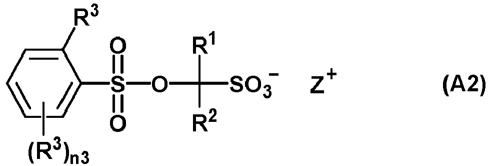 Herein n3, R¹, R², R³ and Z⁺ are as defined above.

Preferred examples of the anion in the onium salt having formula (A) are shown below, but not limited thereto.

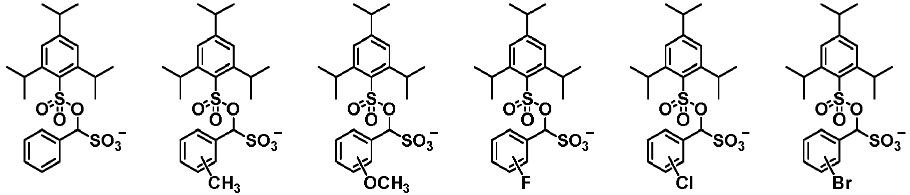

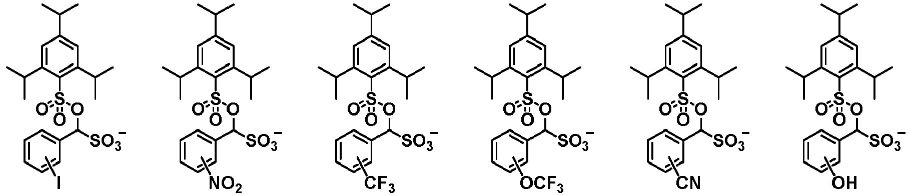

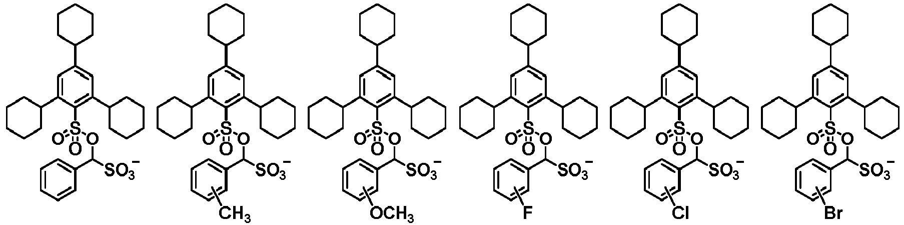

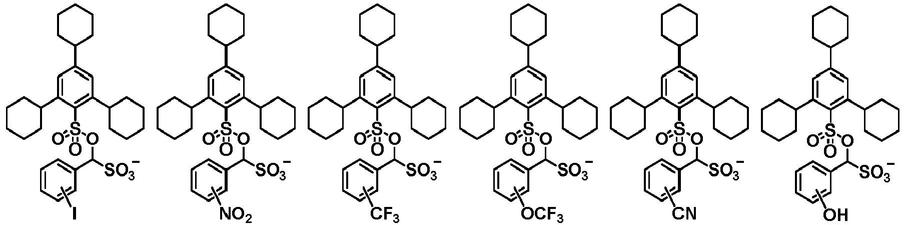

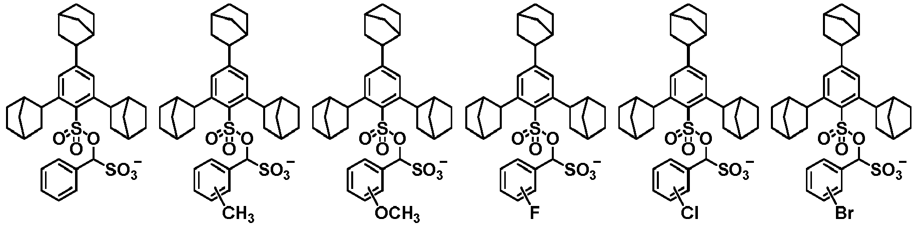

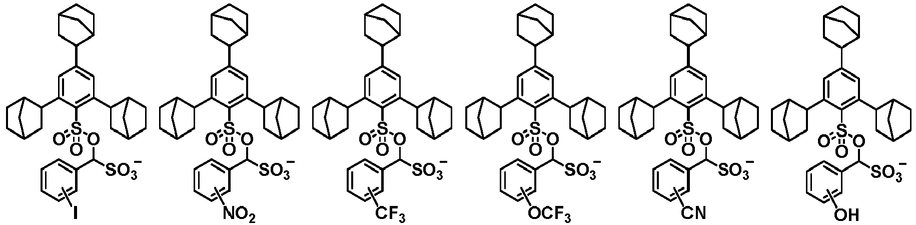

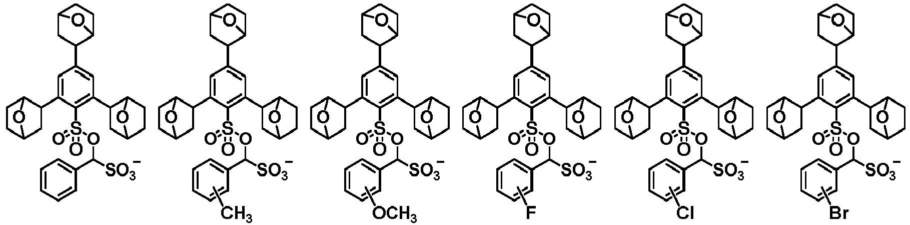

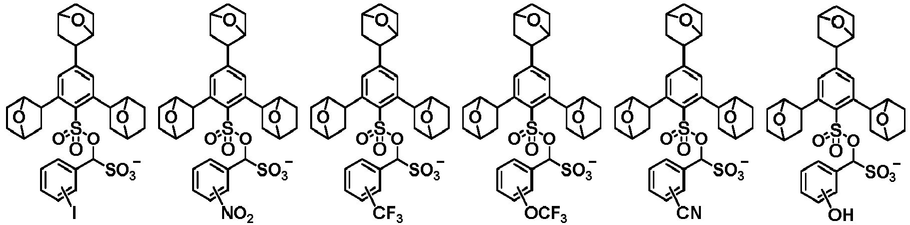

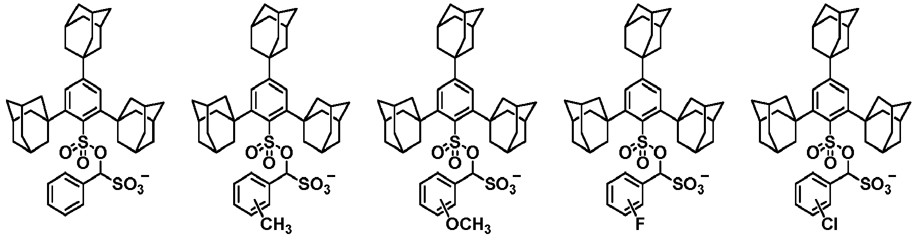

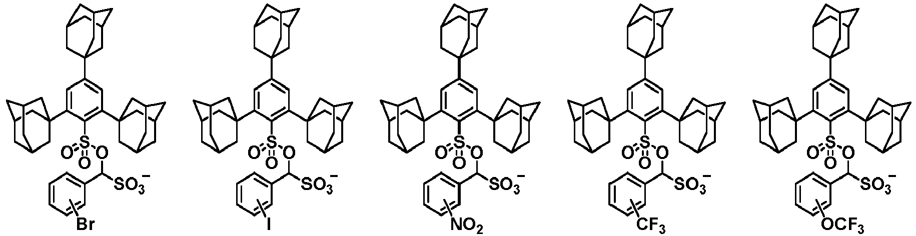

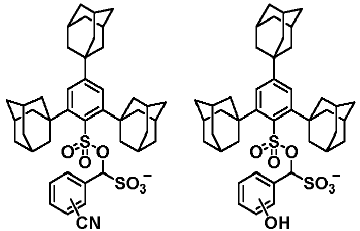

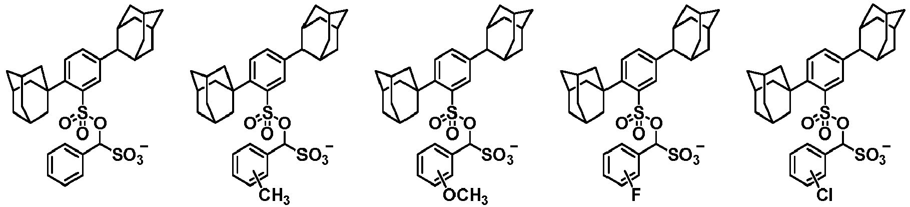

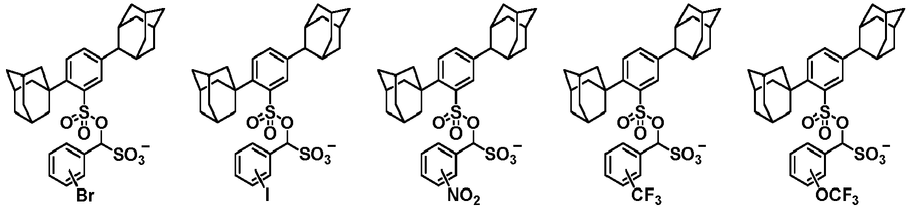

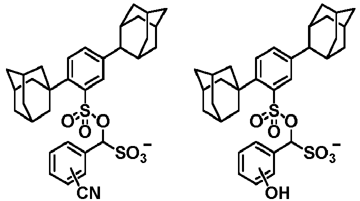

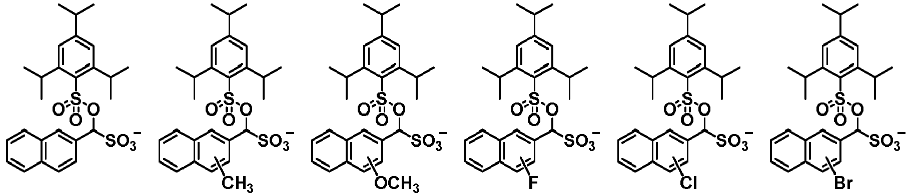

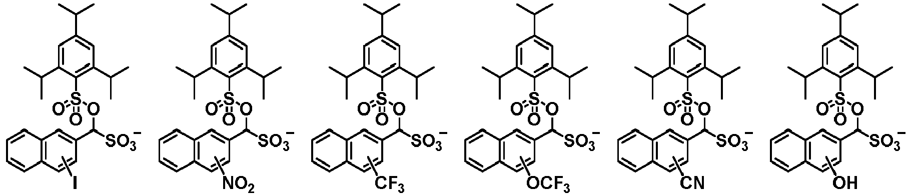

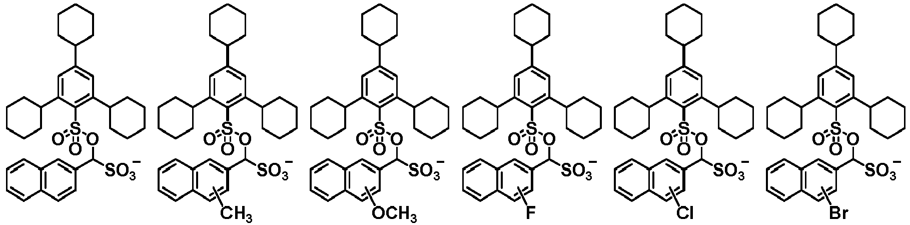

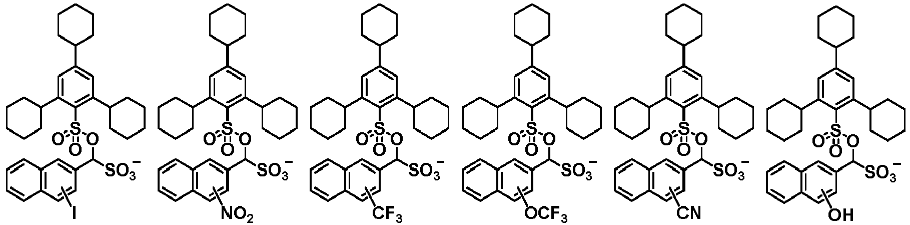

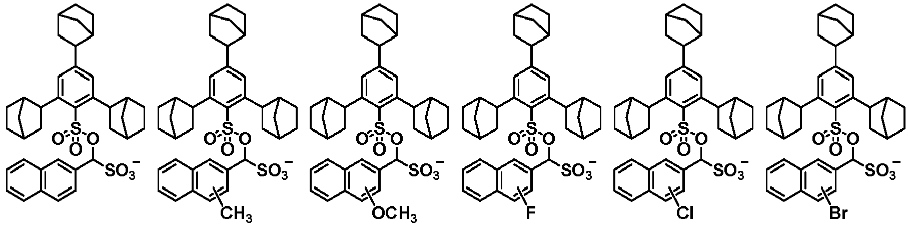

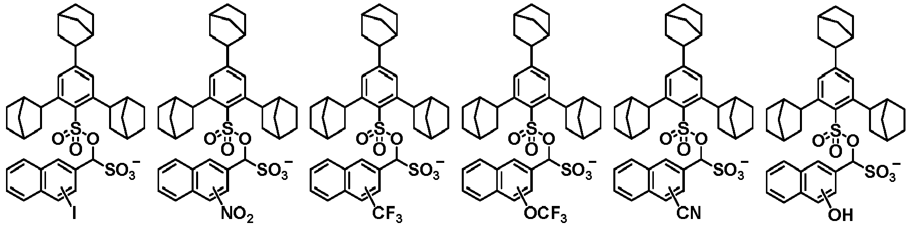

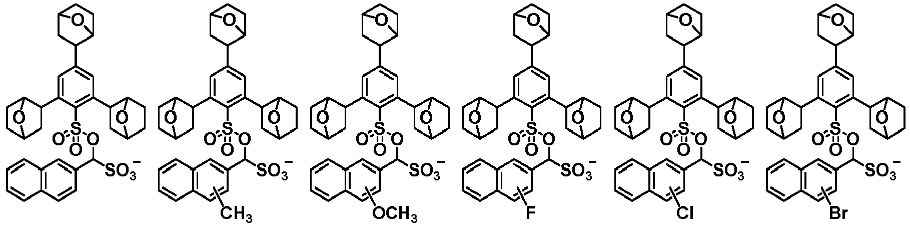

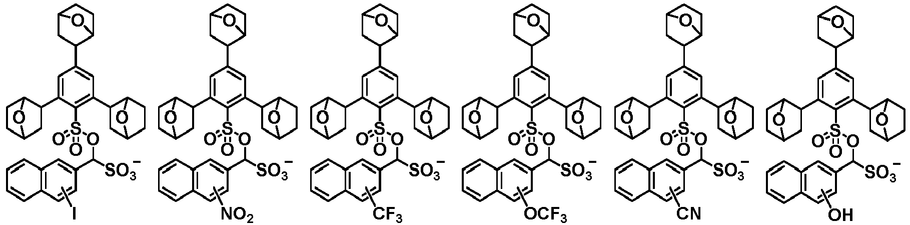

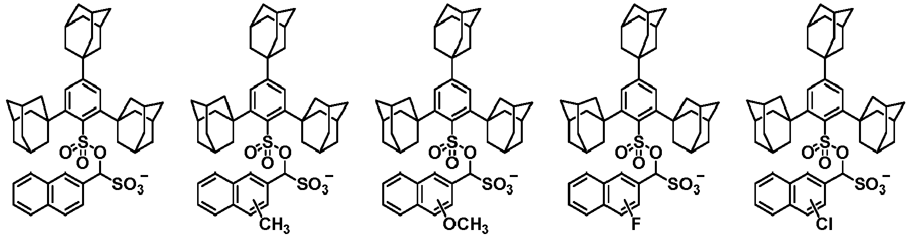

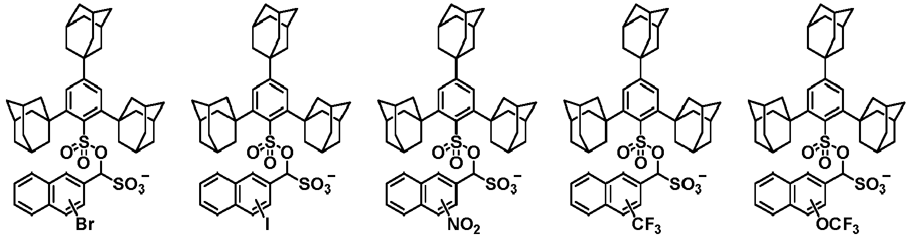

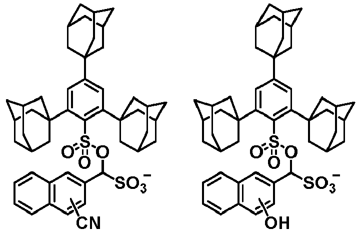

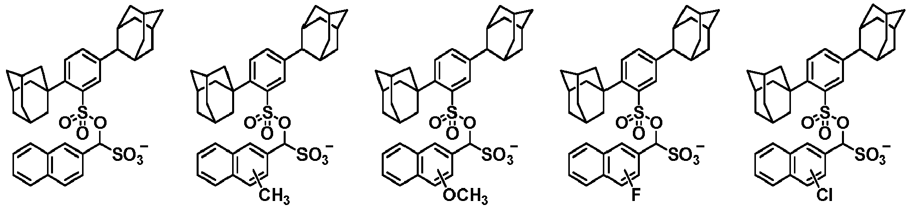

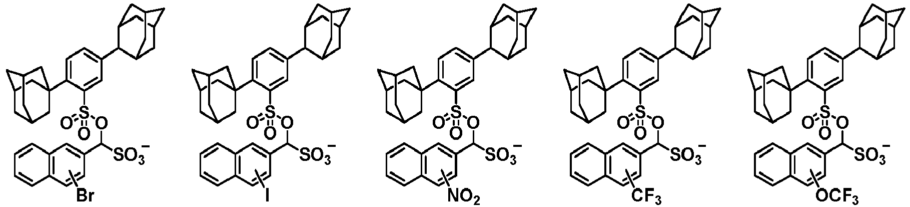

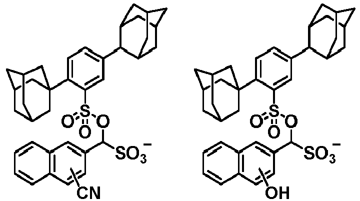

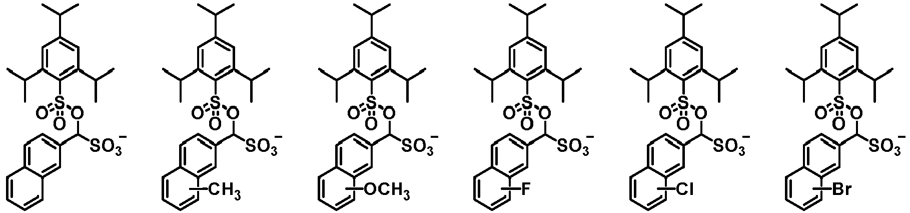

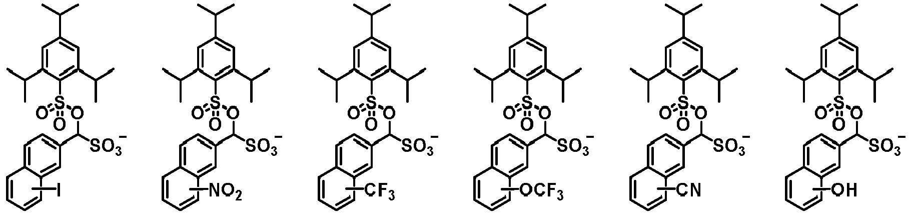

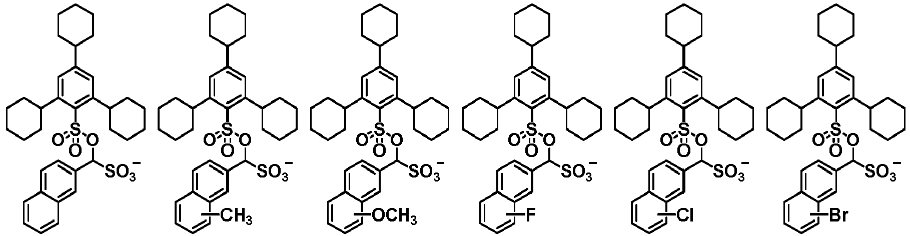

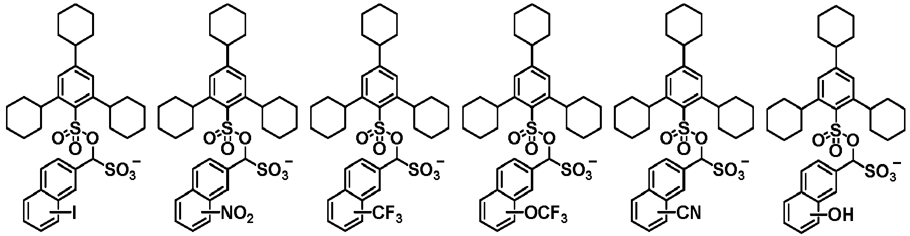

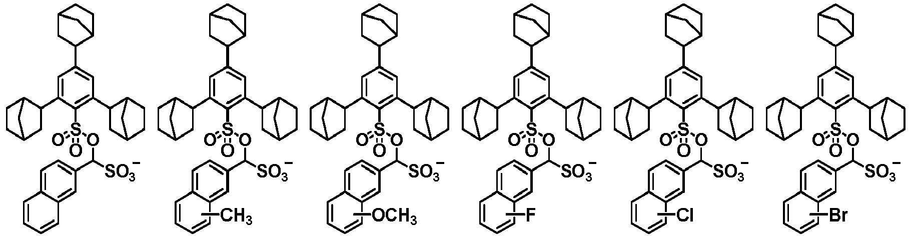

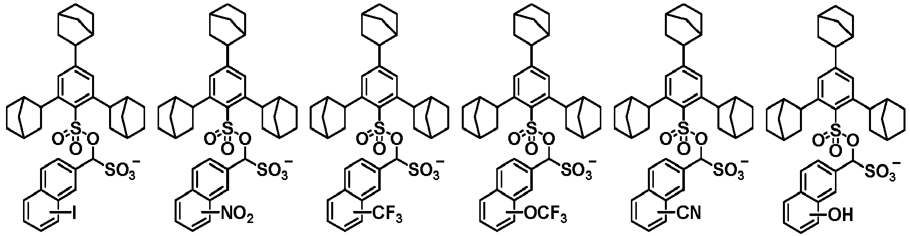

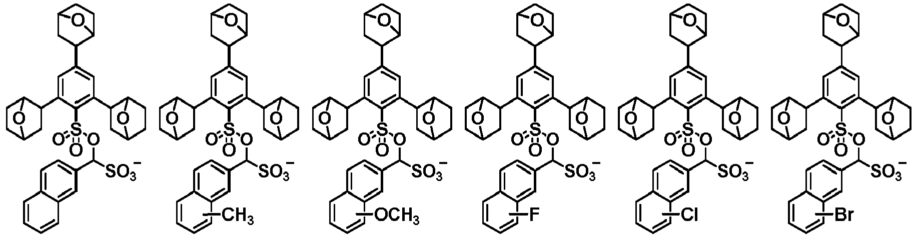

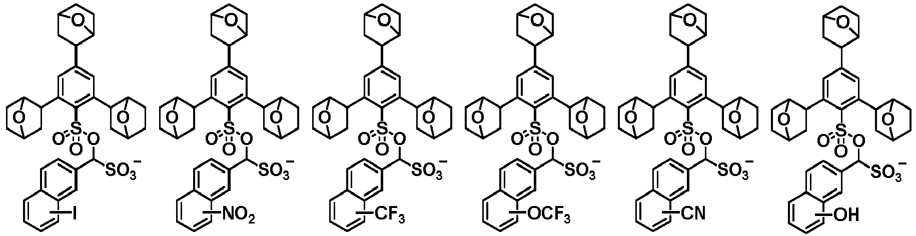

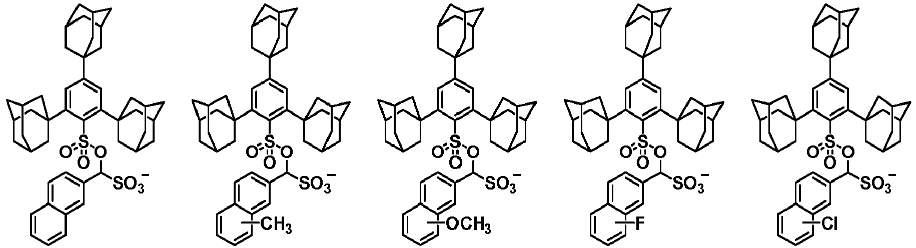

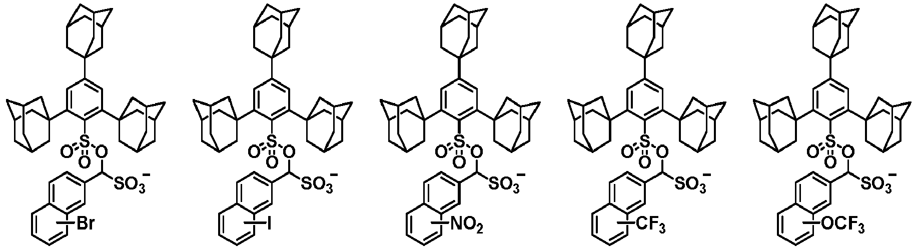

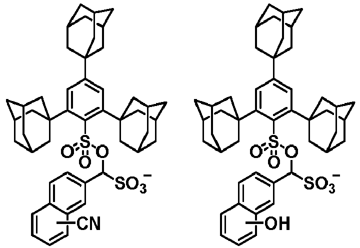

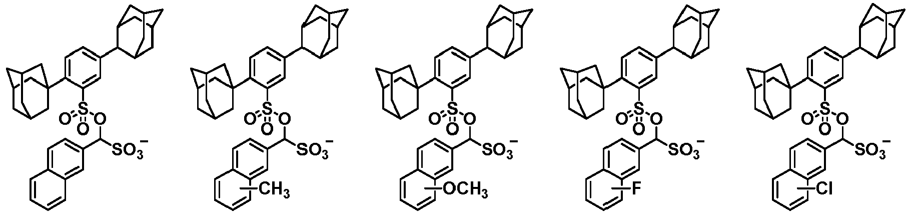

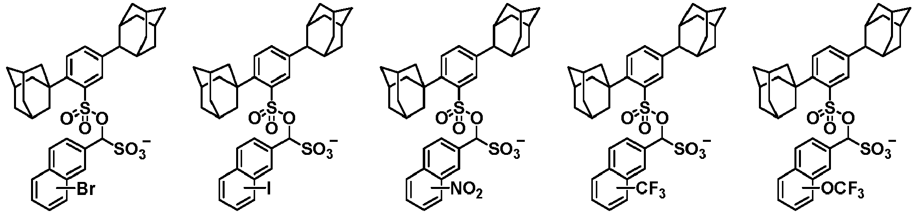

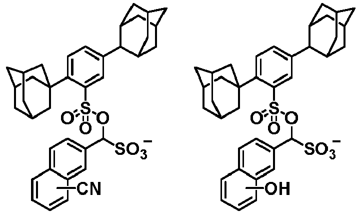

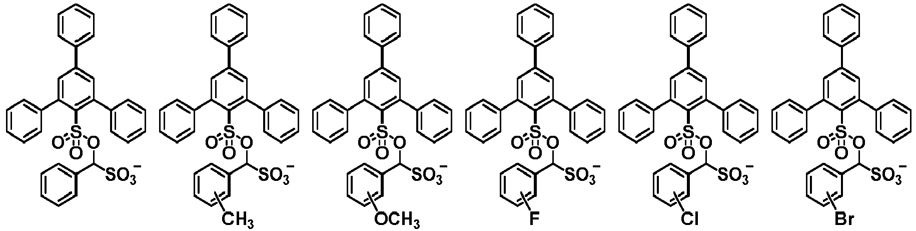

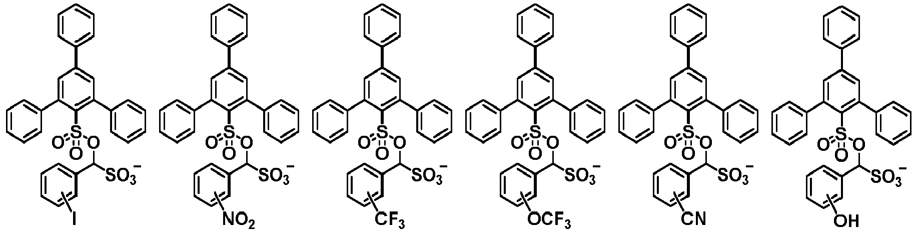

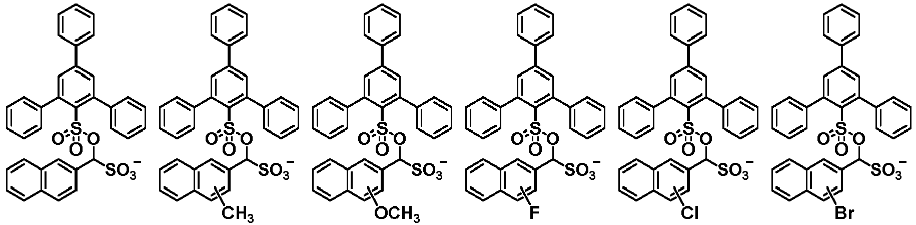

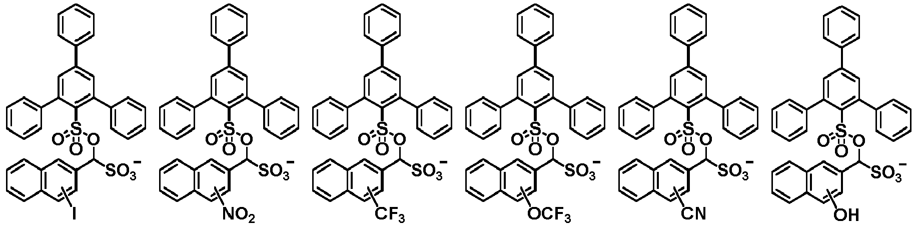

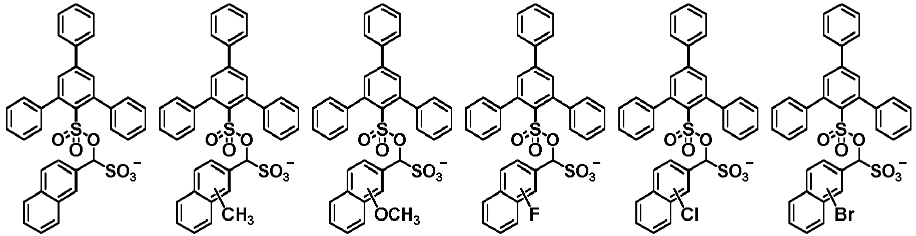

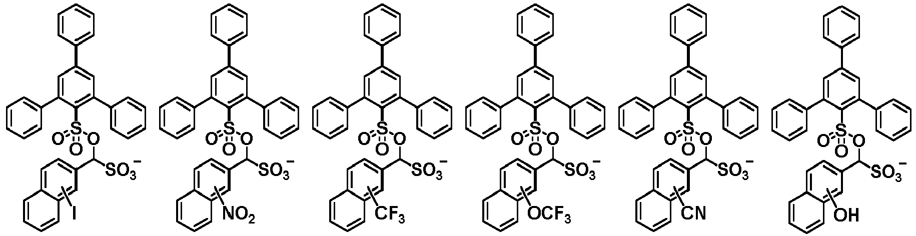

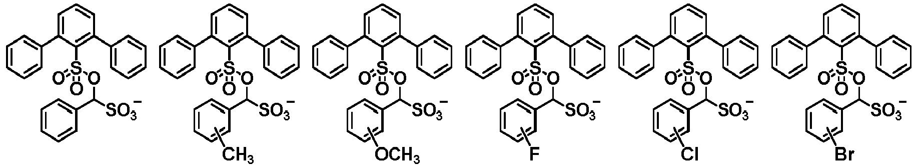

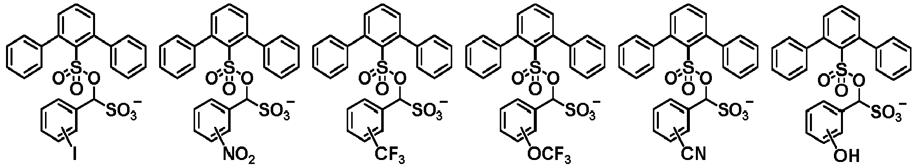

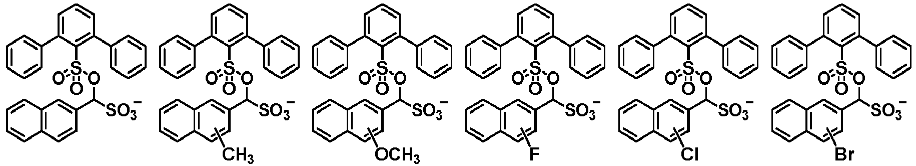

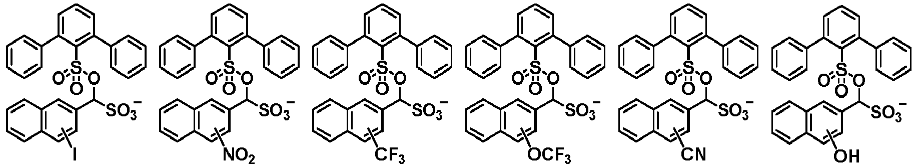

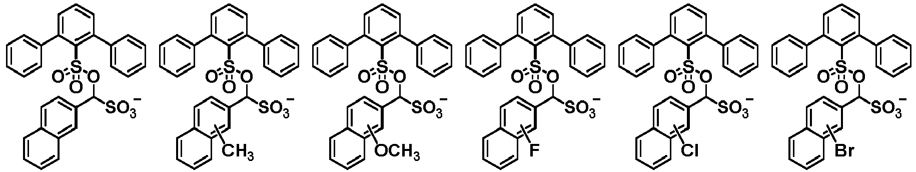

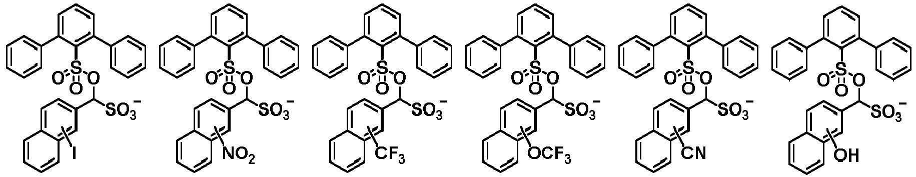

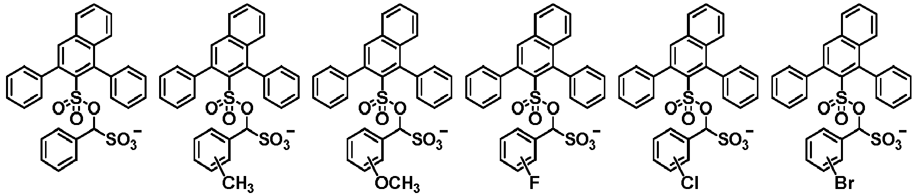

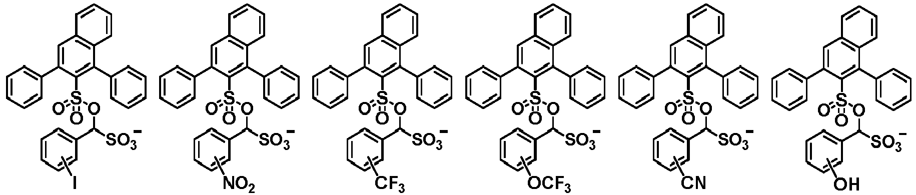

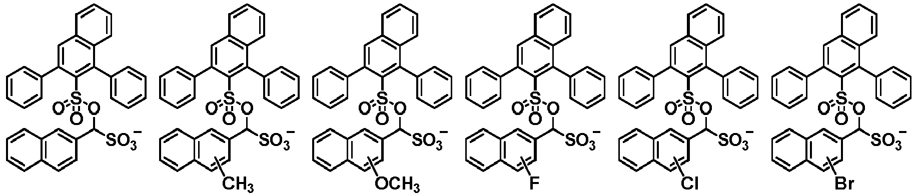

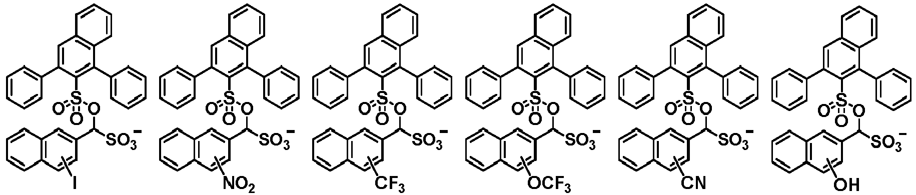

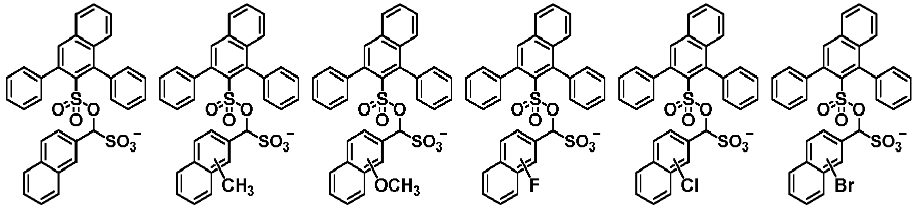

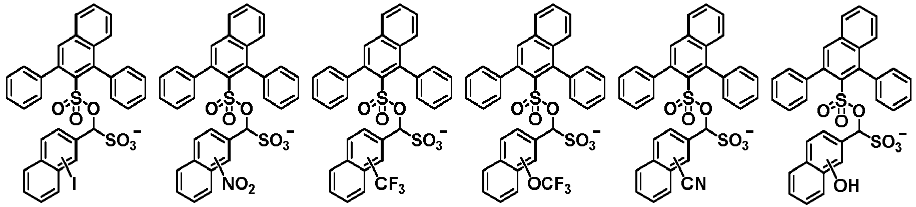

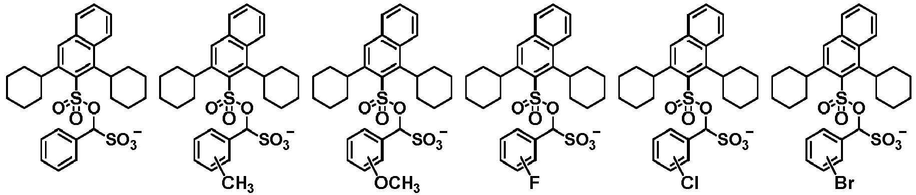

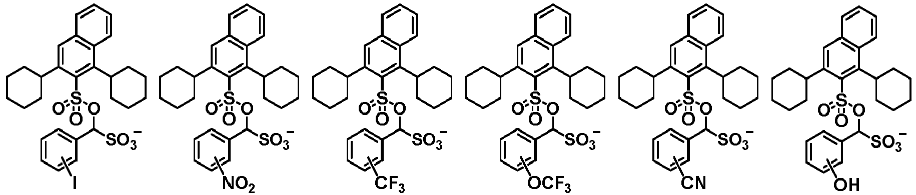

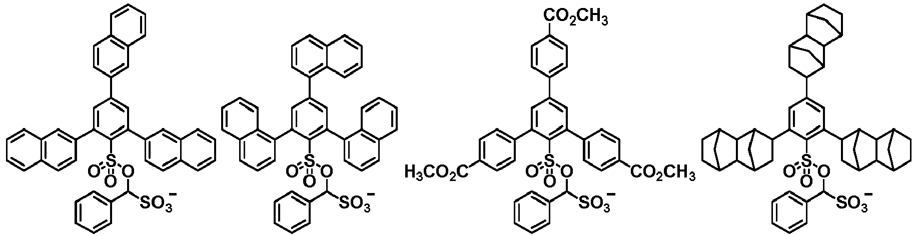

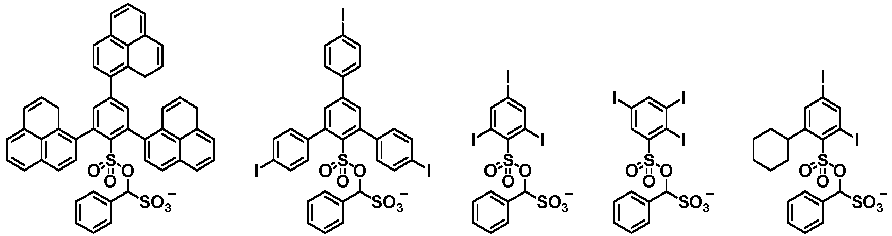

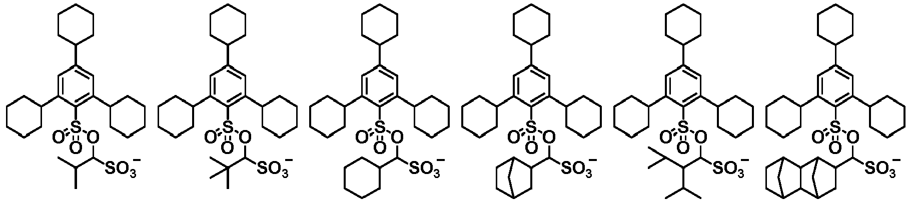

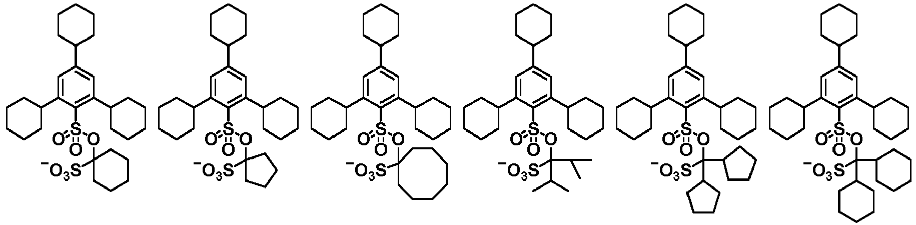

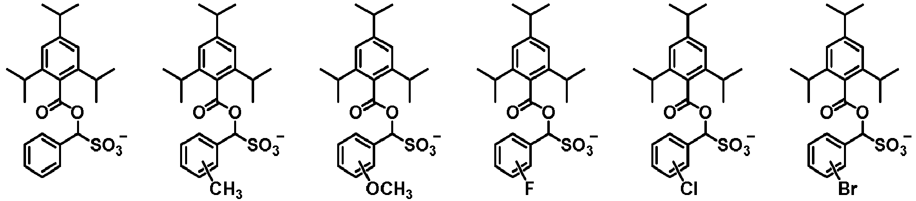

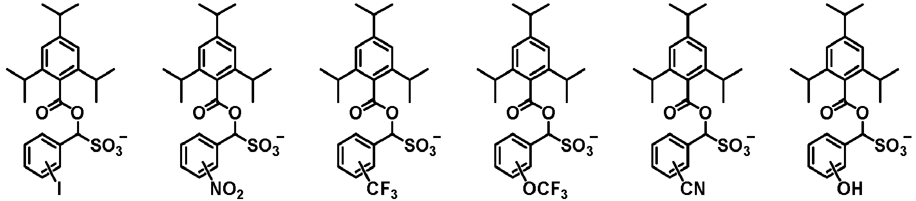

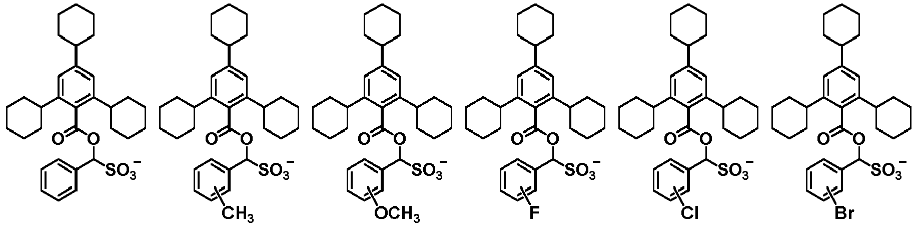

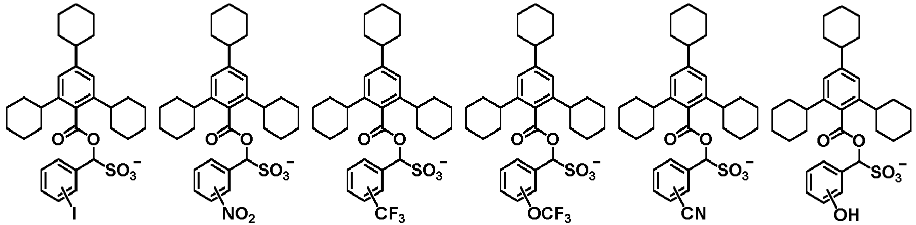

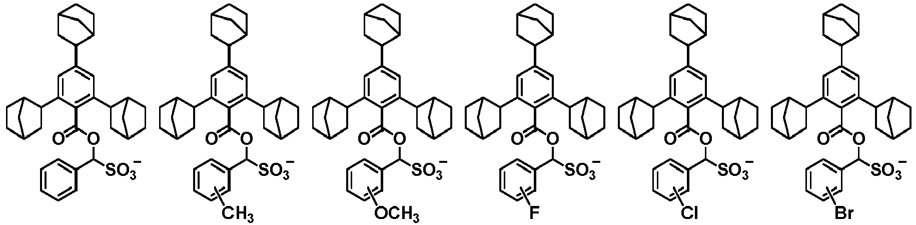

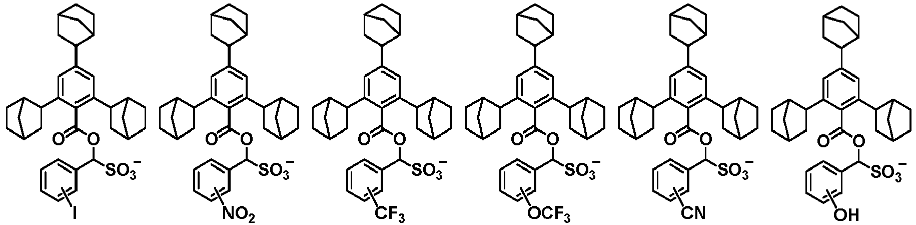

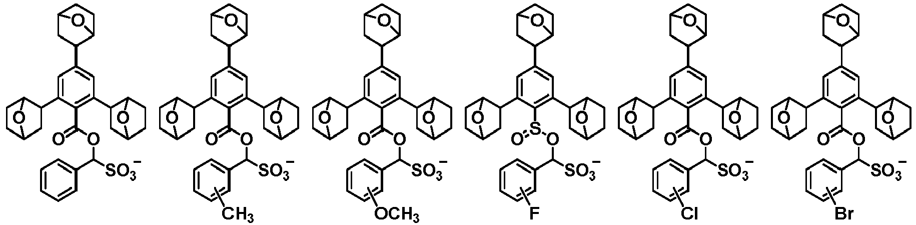

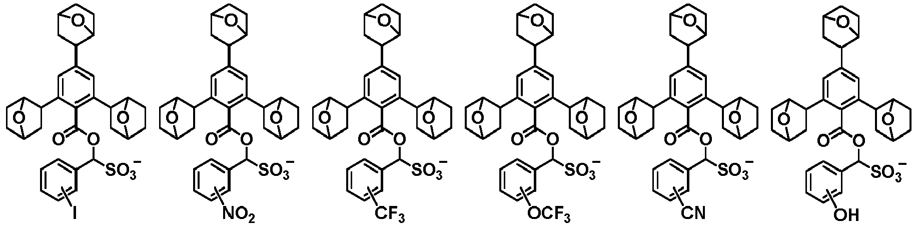

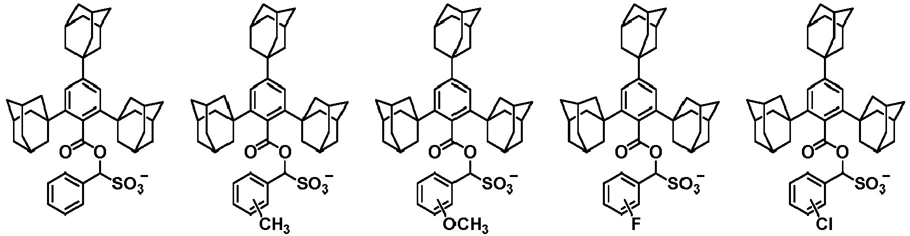

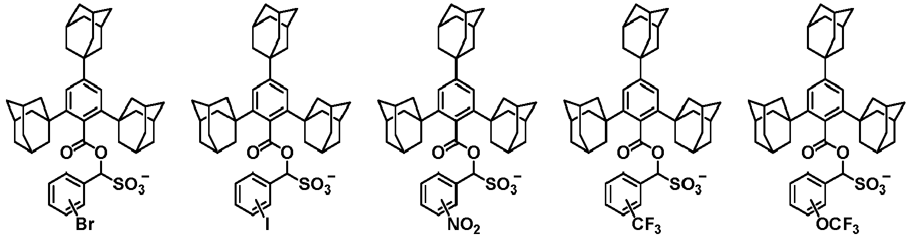

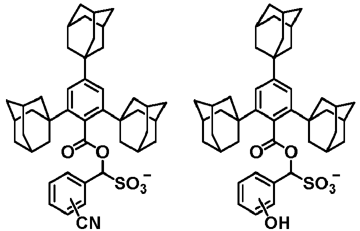

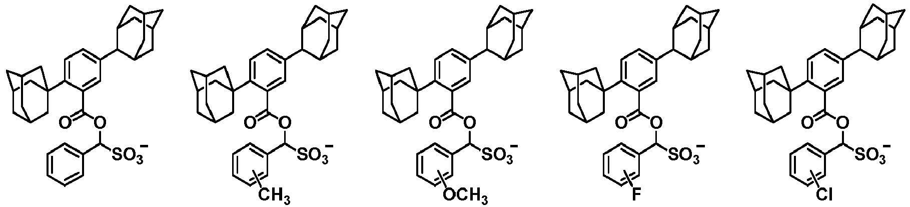

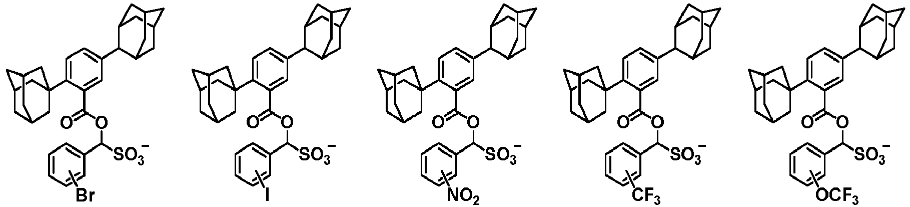

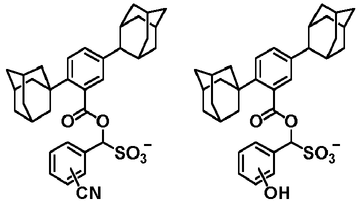

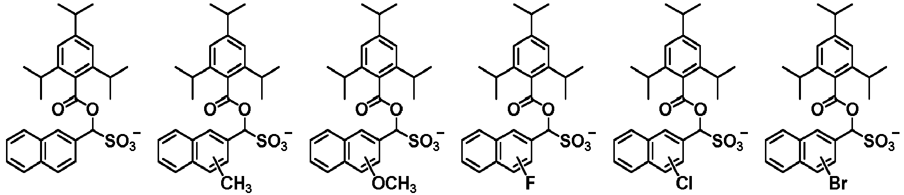

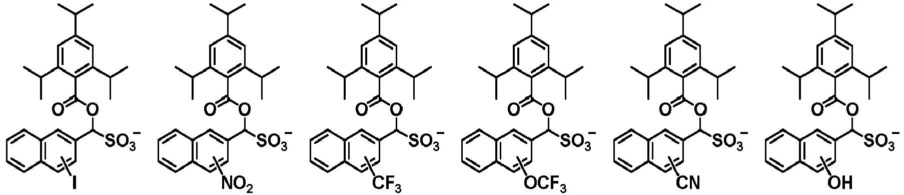

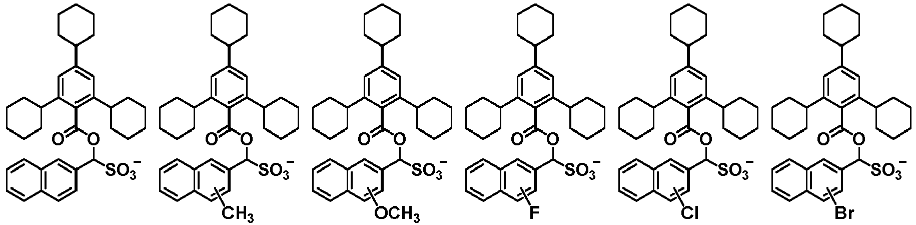

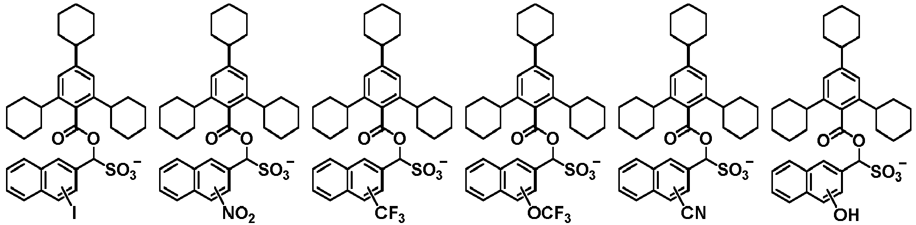

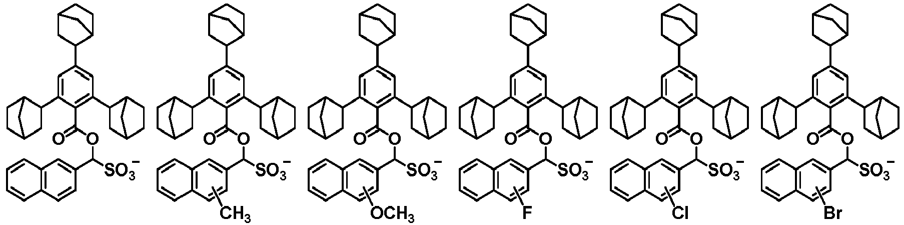

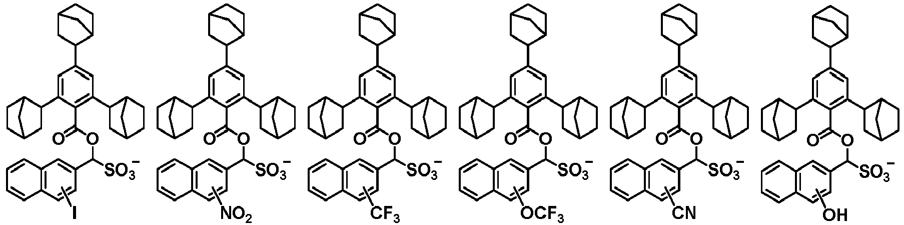

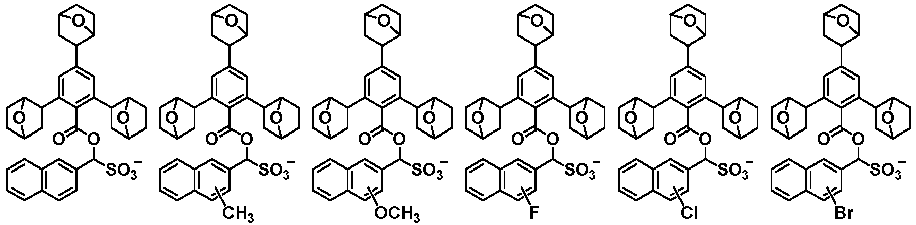

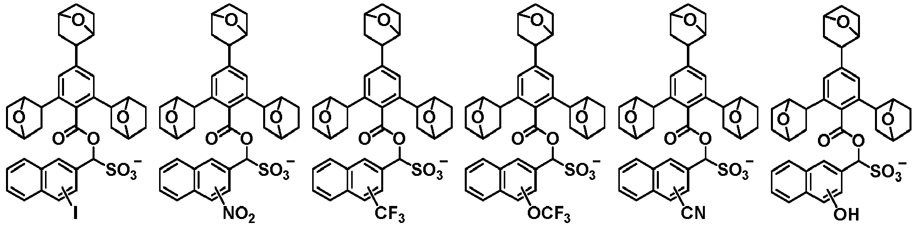

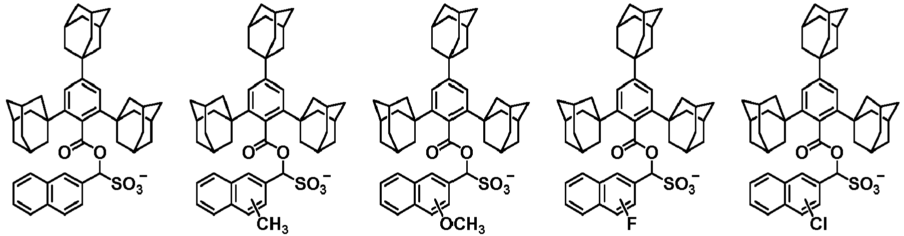

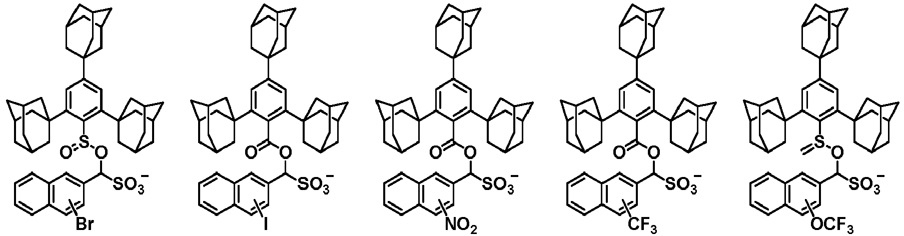

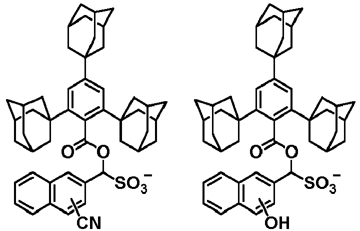

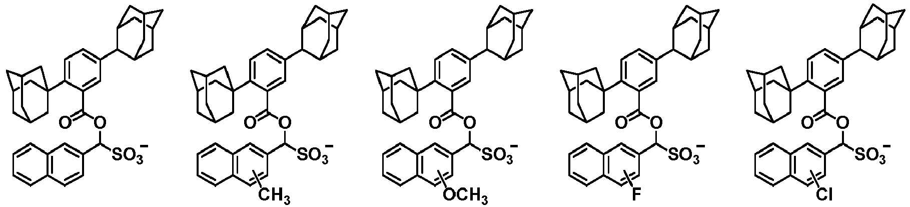

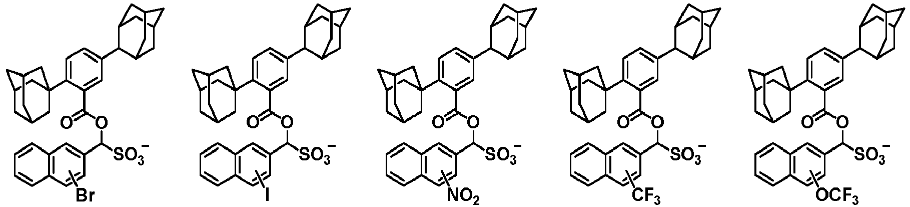

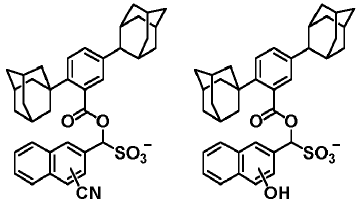

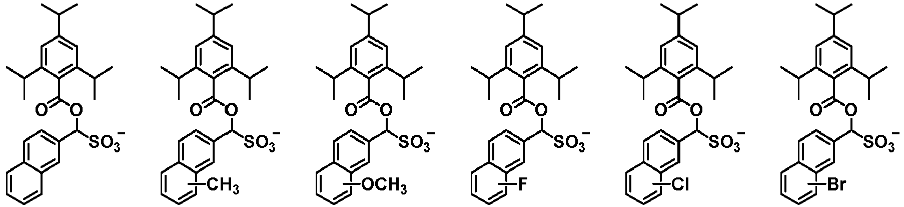

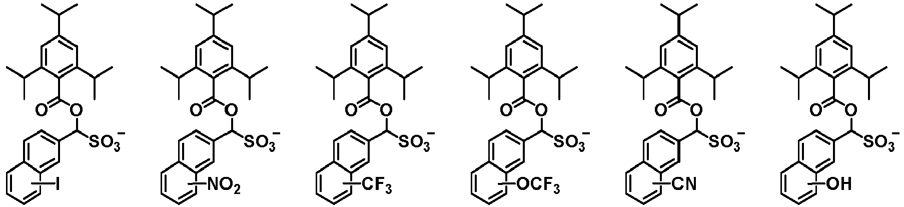

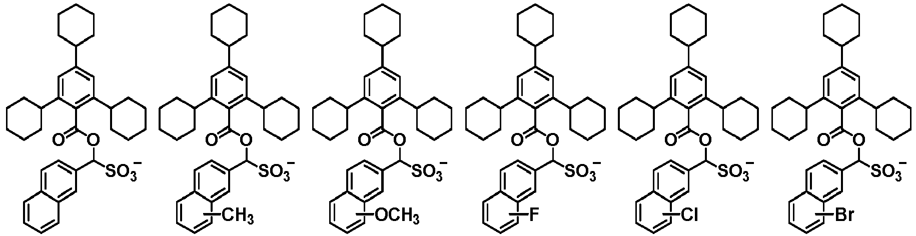

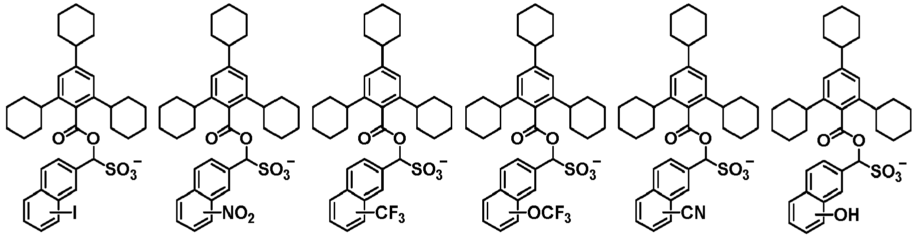

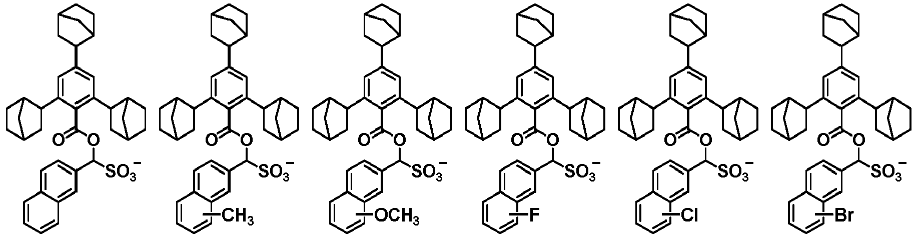

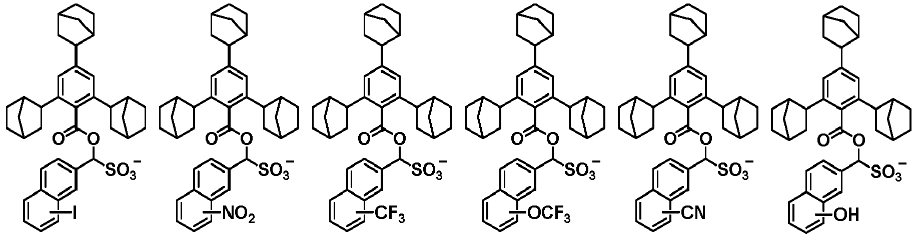

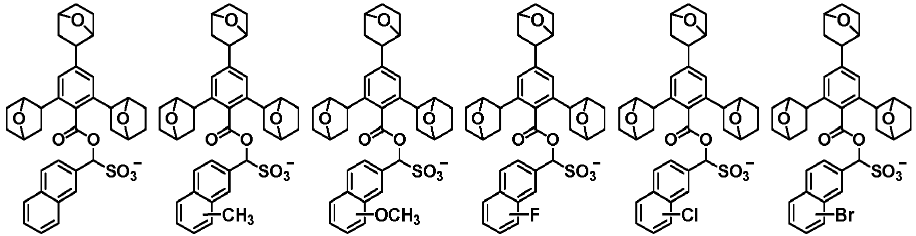

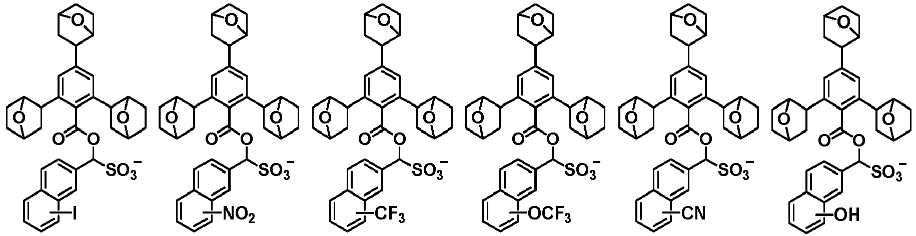

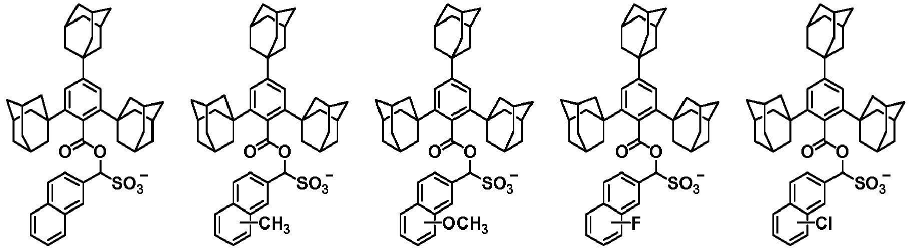

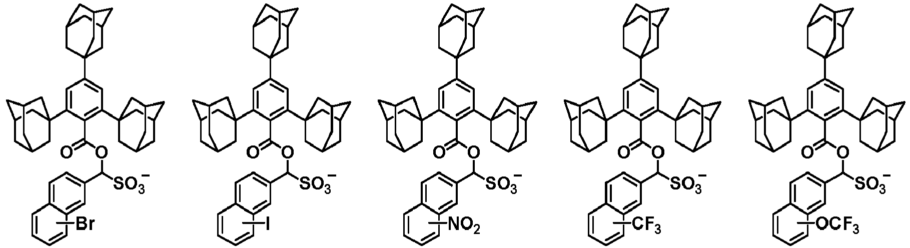

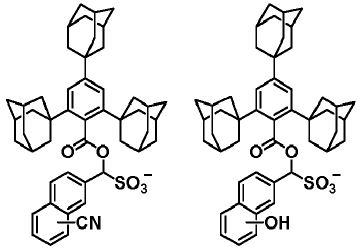

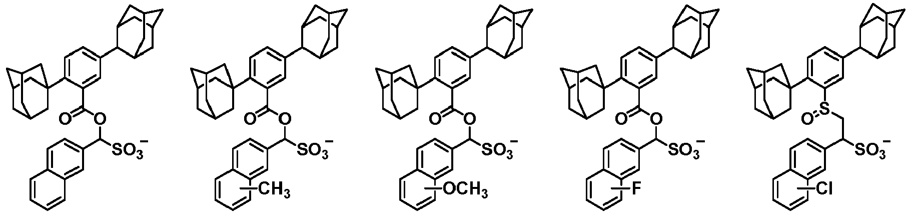

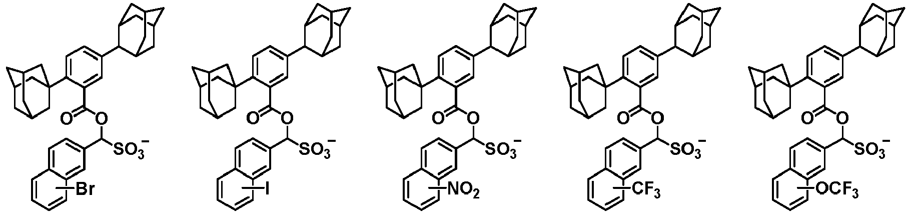

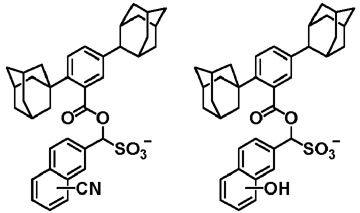

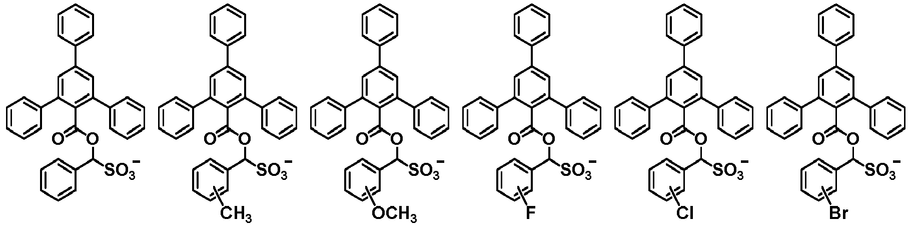

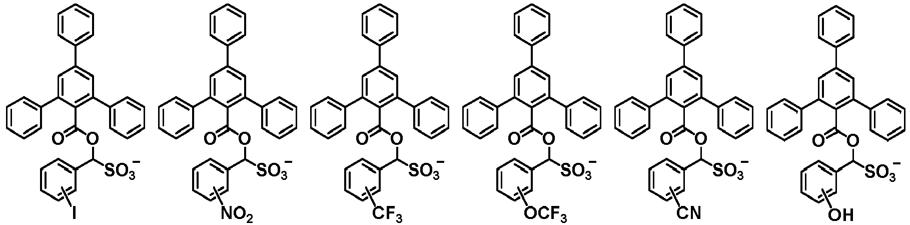

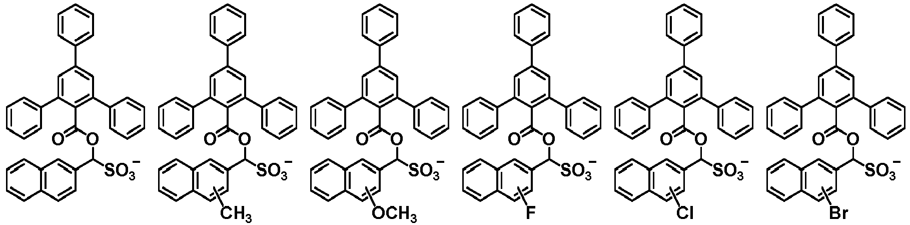

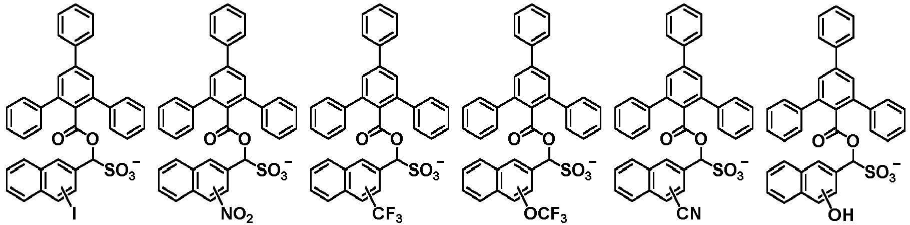

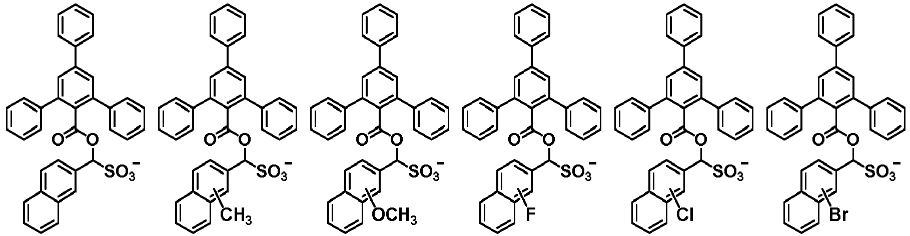

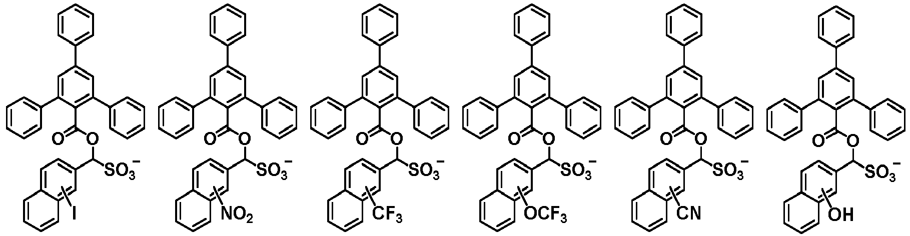

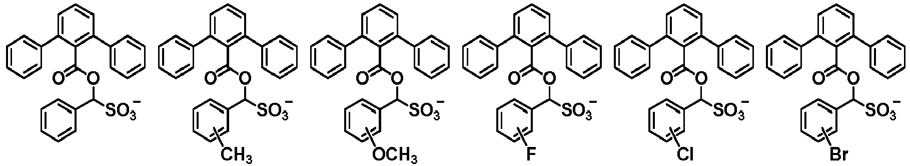

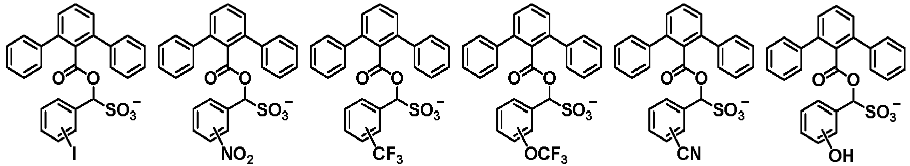

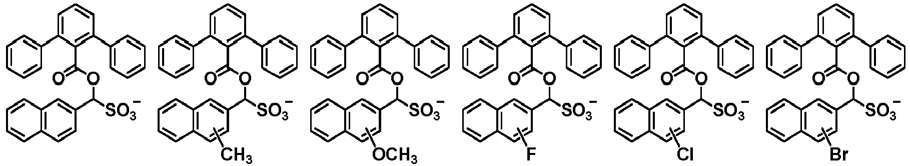

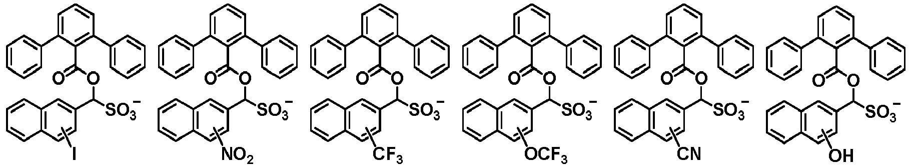

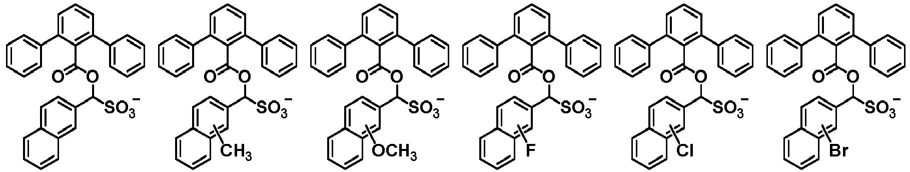

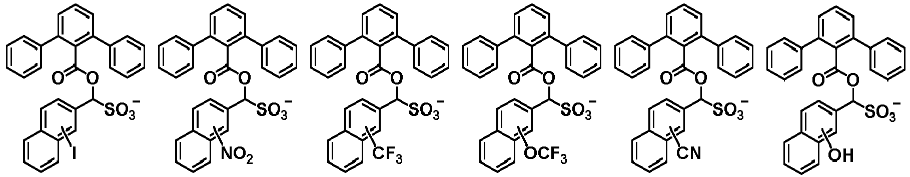

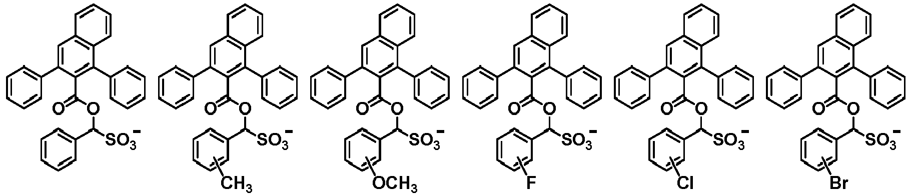

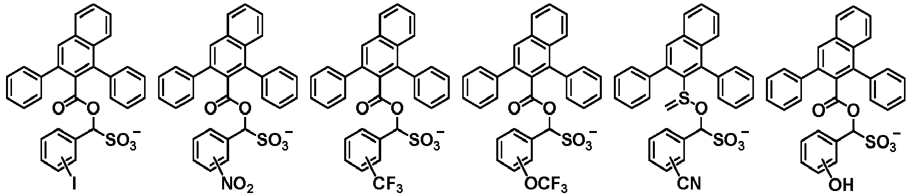

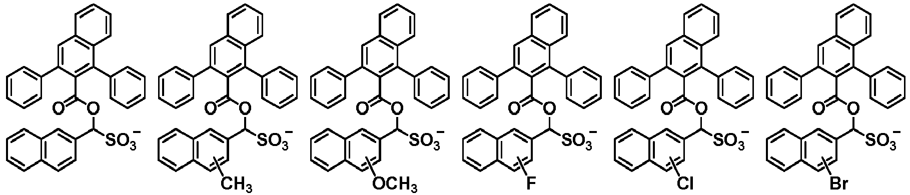

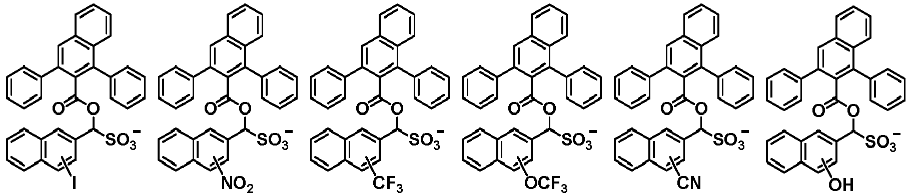

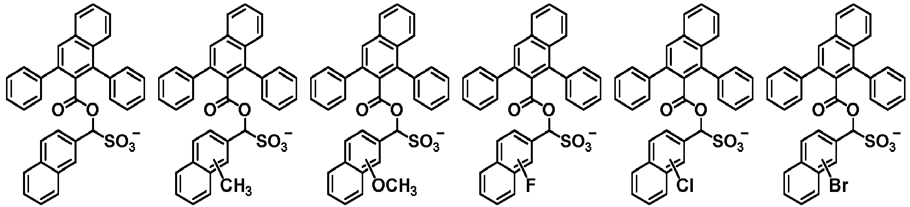

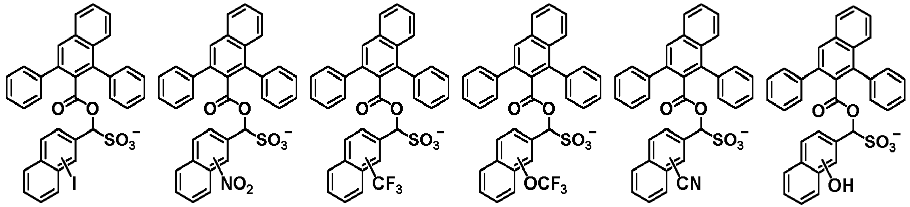

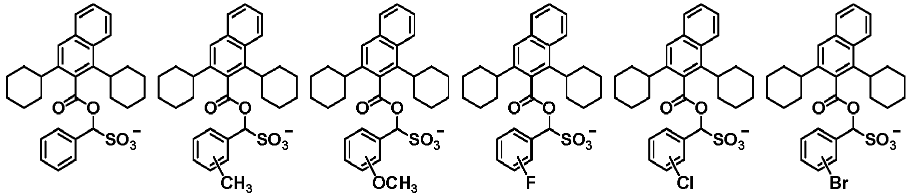

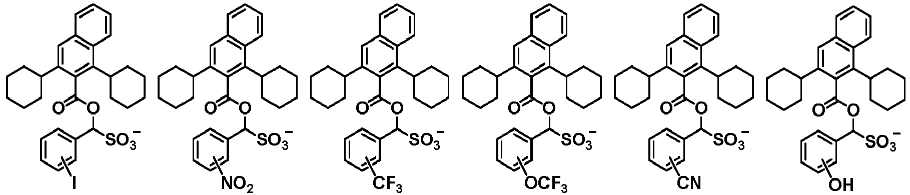

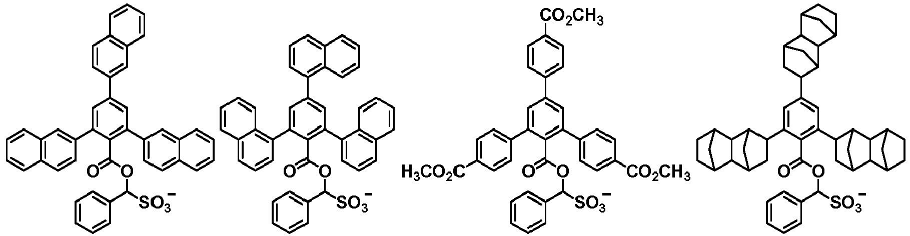

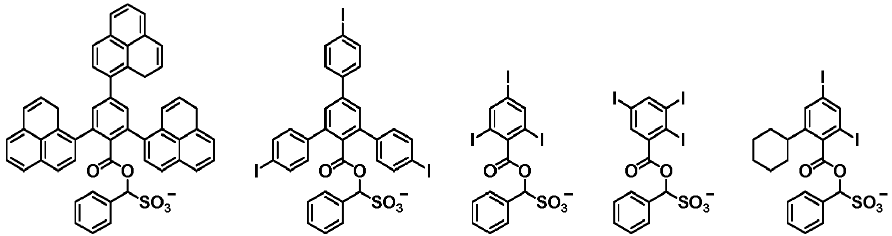

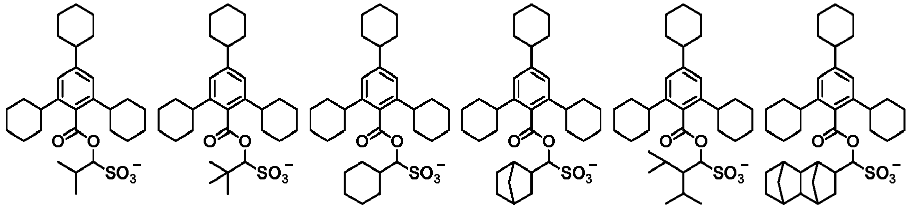

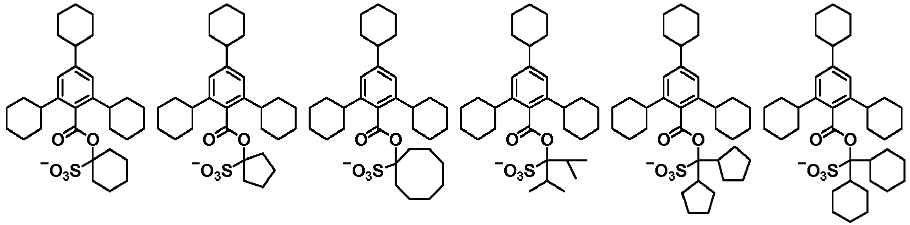

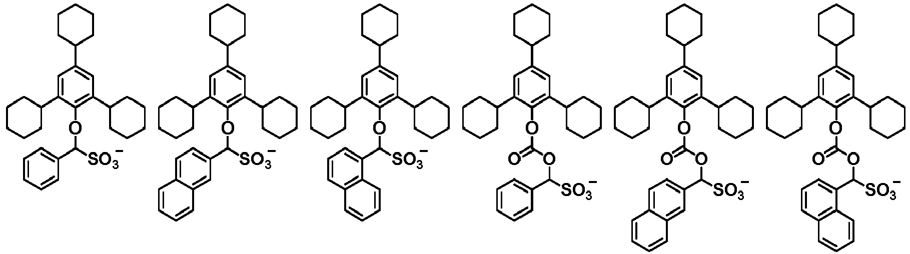

In formula (A), Z⁺ is an onium cation, preferably a sulfonium cation having the formula (cation-1) or an iodonium cation having the formula (cation-2).

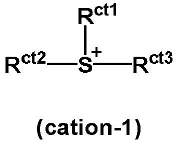

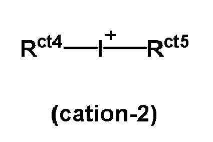

In formulae (cation-1) and (cation-2), R^{ct1} to R^{ct5} are each independently halogen or a C₁-C₃₀ hydrocarbyl group which may contain a heteroatom. Suitable halogen atoms include fluorine, chlorine, bromine, and iodine. The hydrocarbyl group may be saturated or unsaturated and straight, branched or cyclic. Examples thereof include C₁-C₃₀ alkyl groups such as methyl, ethyl, n-propyl, isopropyl, n-butyl, isobutyl, sec-butyl, and tert-butyl; C₃-C₃₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₃₀ alkenyl groups such as vinyl, allyl, propenyl, butenyl, and hexenyl; C₃-C₃₀ cyclic unsaturated hydrocarbyl groups such as cyclohexenyl; C₆-C₃₀ aryl groups such as phenyl, naphthyl and thienyl; C₇-C₃₀ aralkyl groups such as benzyl, 1-phenylethyl and 2-phenylethyl, and combinations thereof. Inter alia, aryl groups are preferred. In the hydrocarbyl group, some or all of the hydrogen atoms may be substituted by a moiety containing a heteroatom such as oxygen, sulfur, nitrogen or halogen and some constituent -CH₂- may be replaced by a moiety containing a heteroatom such as oxygen, sulfur or nitrogen, so that the group may contain a hydroxy, cyano, fluorine, chlorine, bromine, iodine, carbonyl, ether bond, ester bond, sulfonate ester bond, carbonate bond, lactone ring, sultone ring, carboxylic anhydride (-C(=O)-O-C(=O)-), or haloalkyl moiety.

Also, R^{ct1} and R^{ct2} may bond together to form a ring with the sulfur atom to which they are attached. Examples of the sulfonium cation having formula (cation-1) wherein R^{ct1} and R^{ct2} form a ring are shown below.

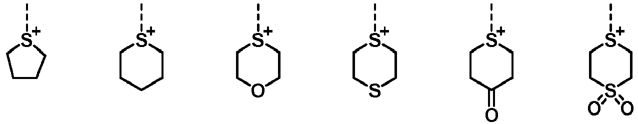

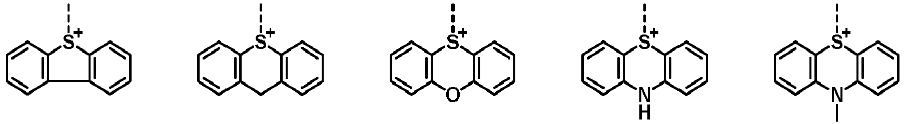

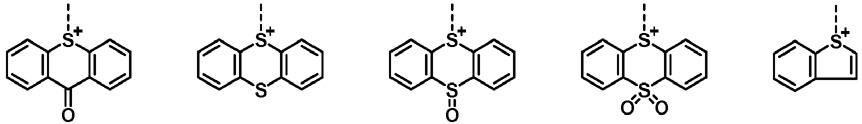

Herein the broken line designates a point of attachment to R^{ct3}.

Examples of the sulfonium cation having formula (cation-1) are shown below, but not limited thereto.

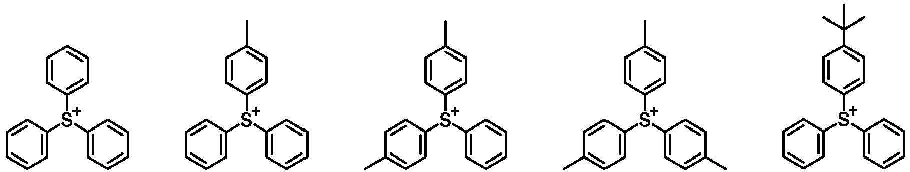

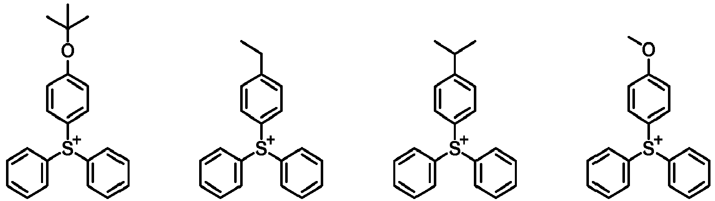

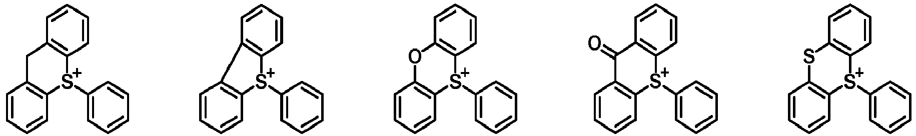

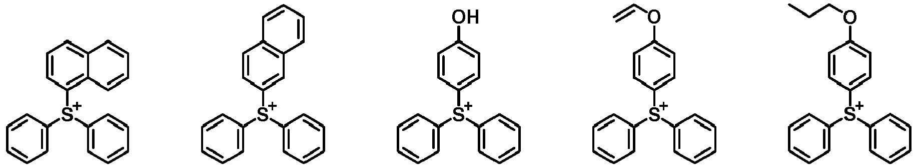

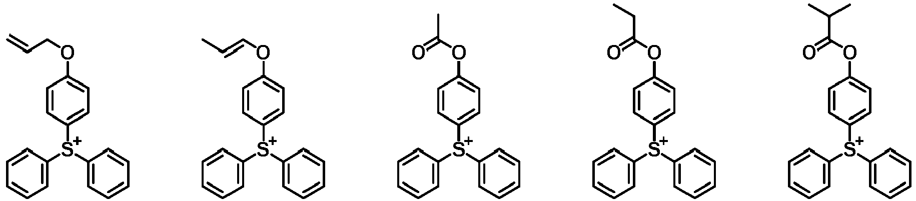

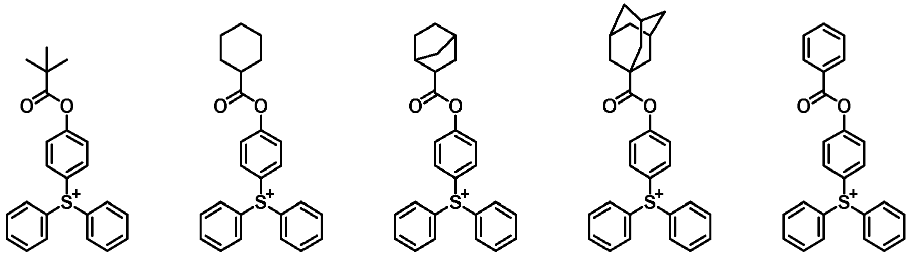

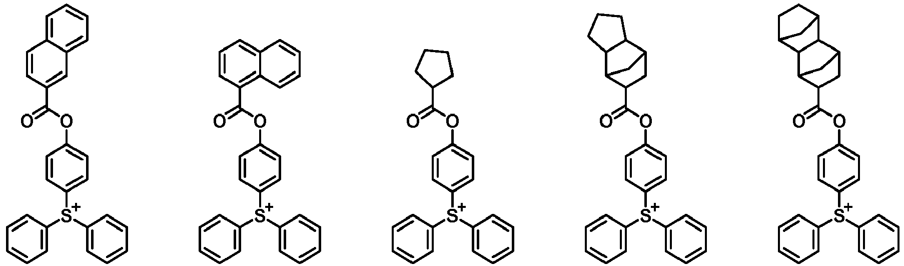

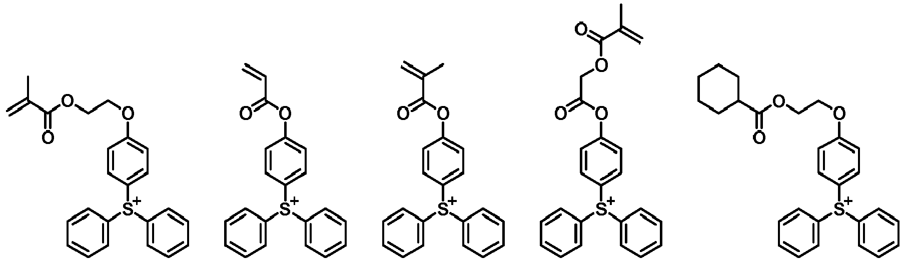

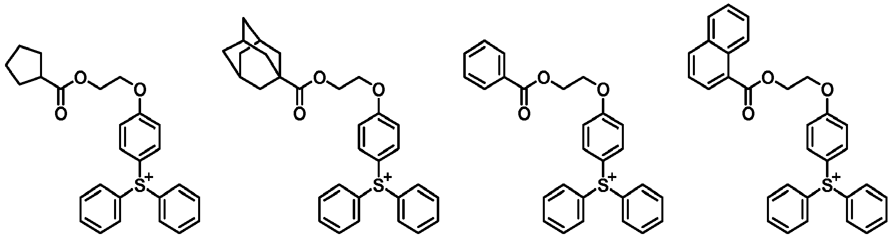

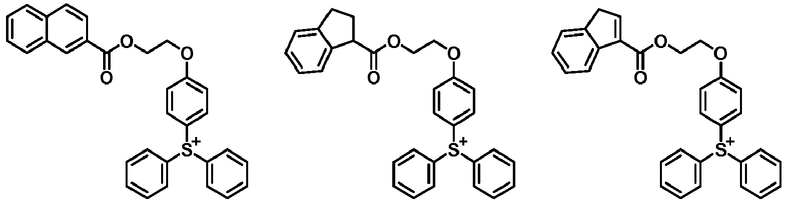

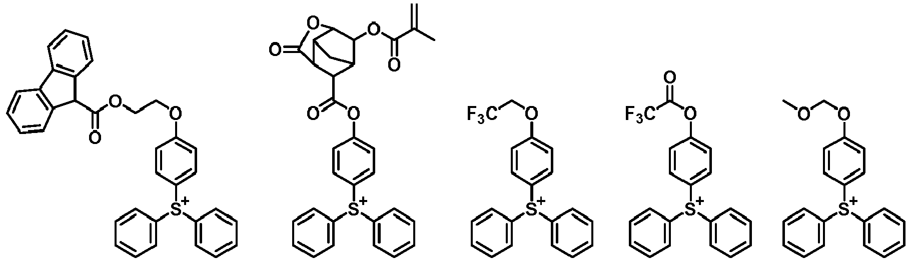

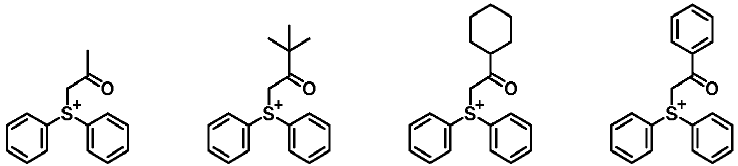

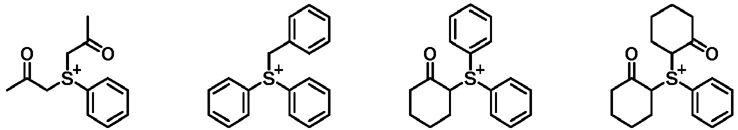

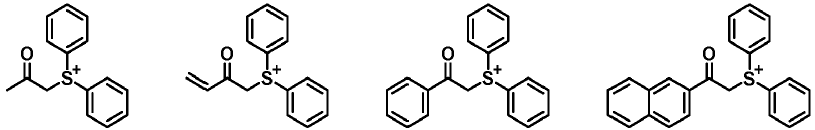

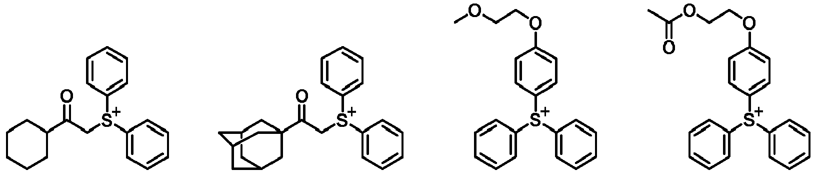

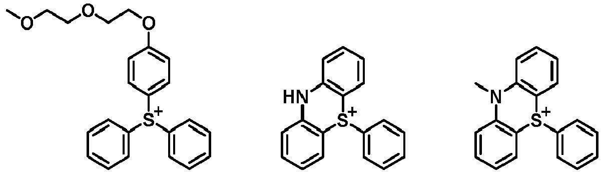

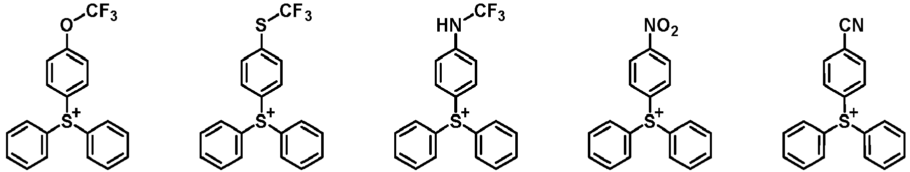

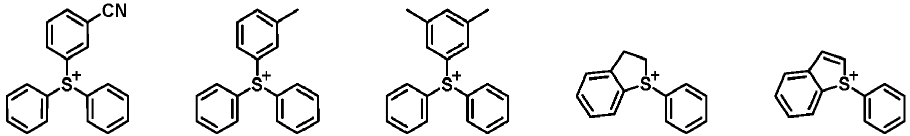

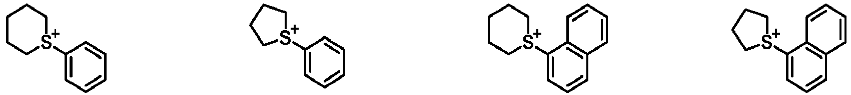

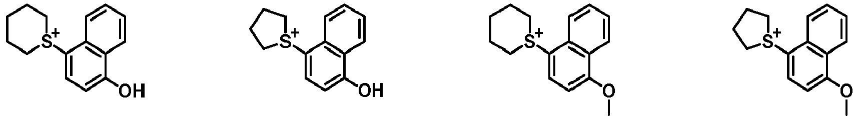

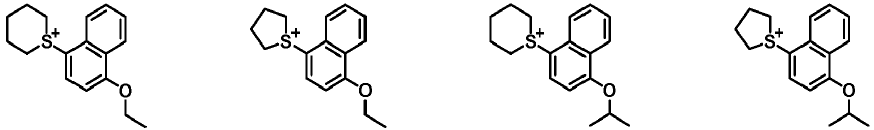

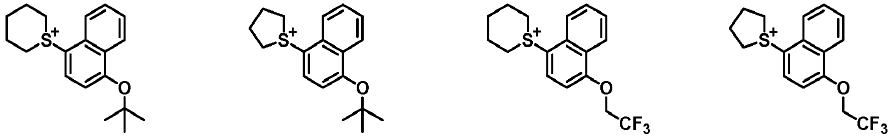

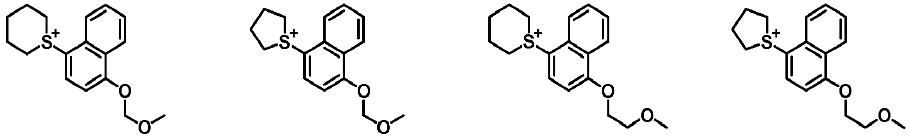

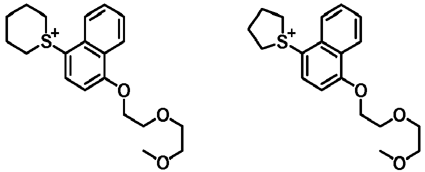

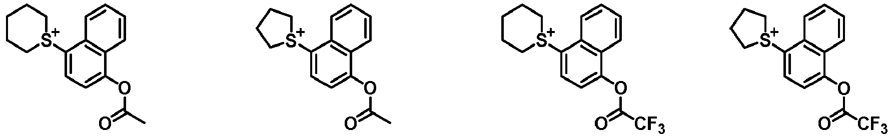

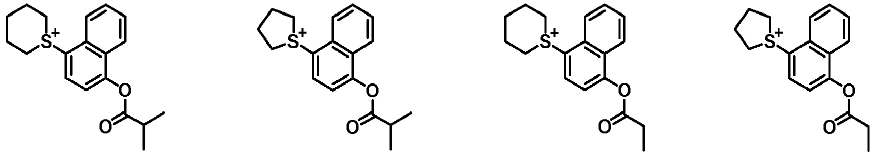

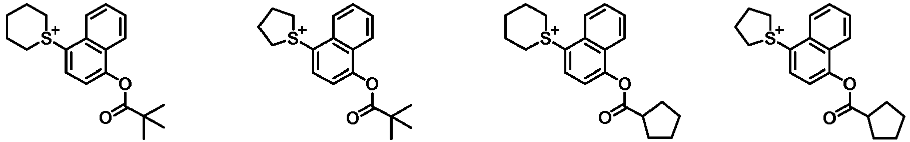

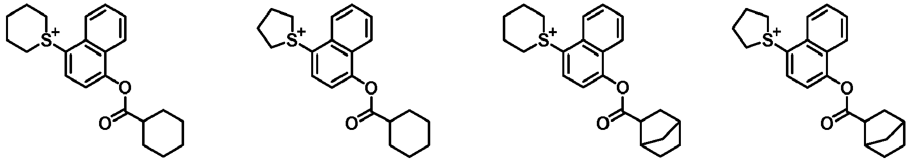

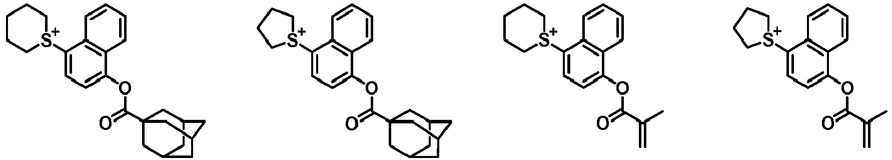

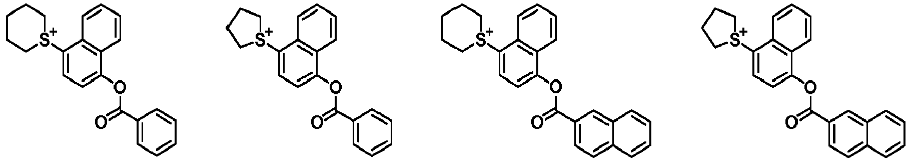

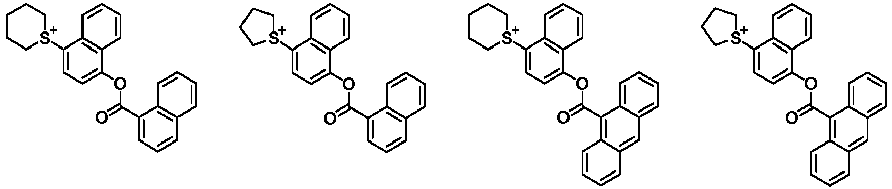

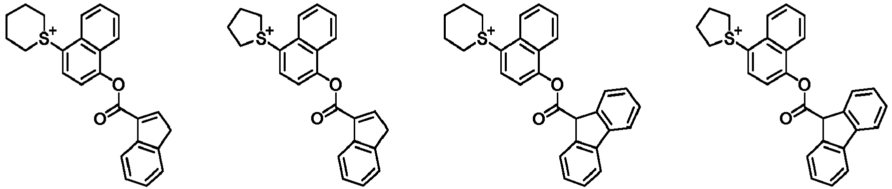

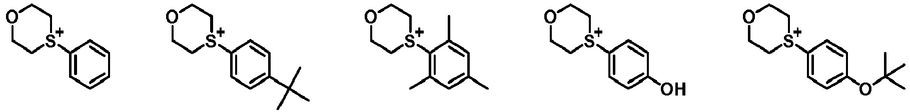

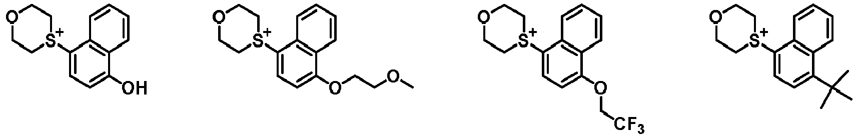

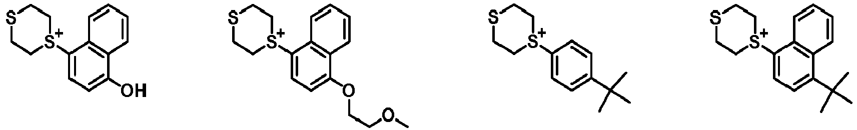

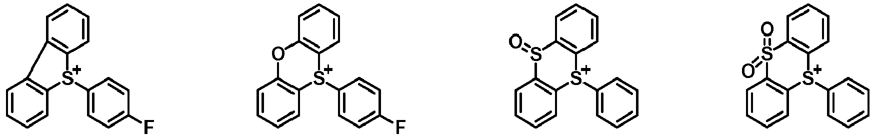

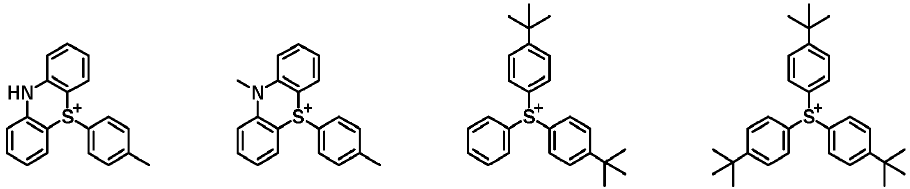

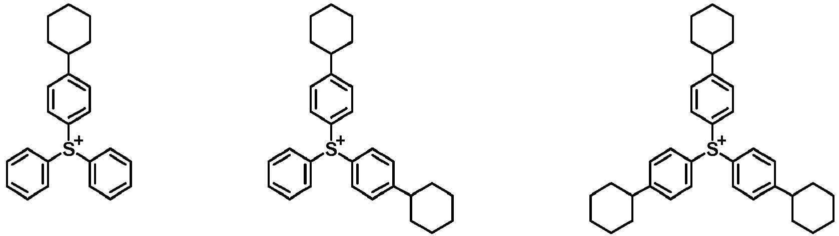

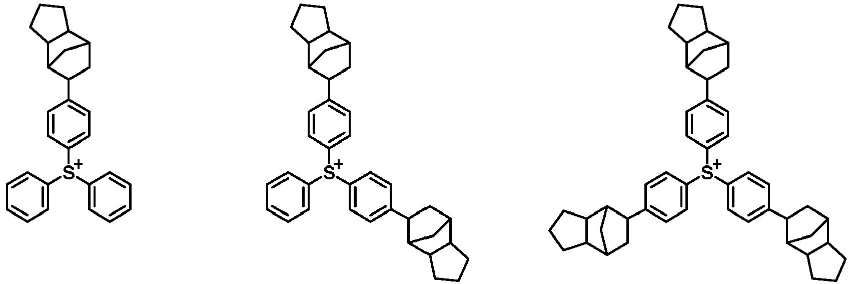

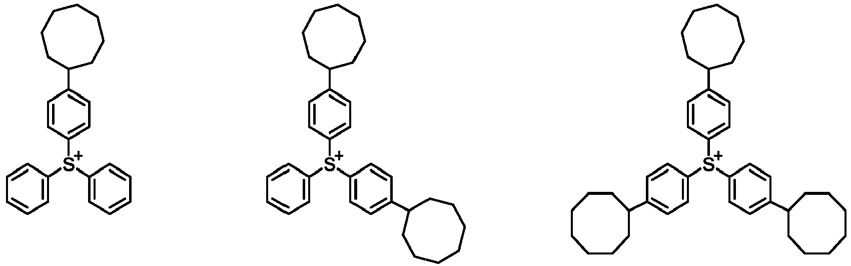

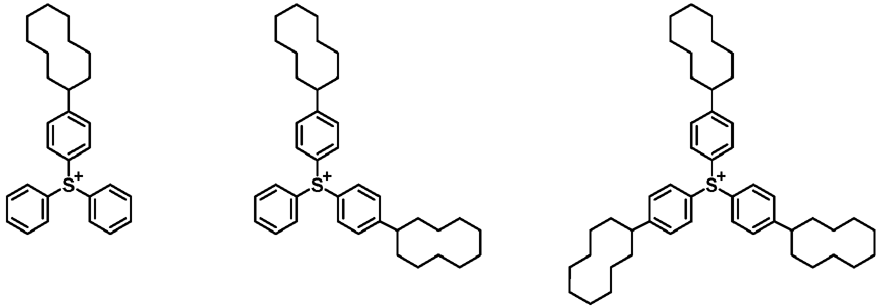

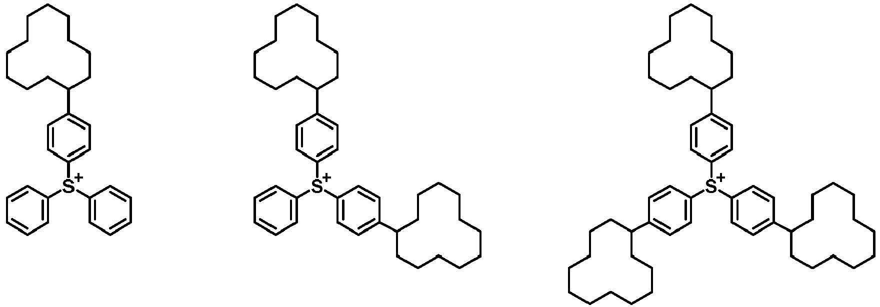

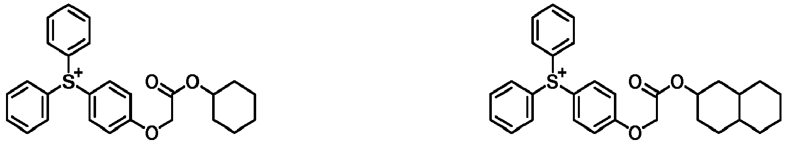

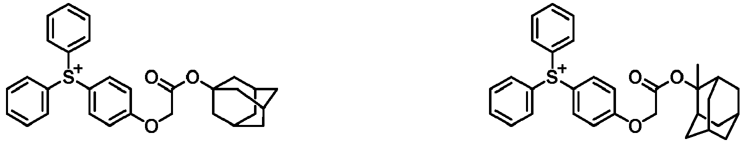

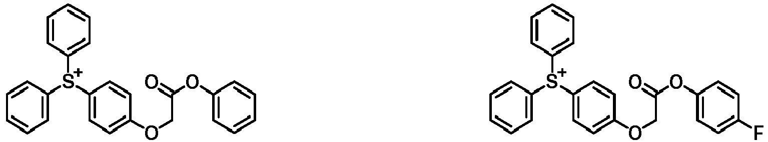

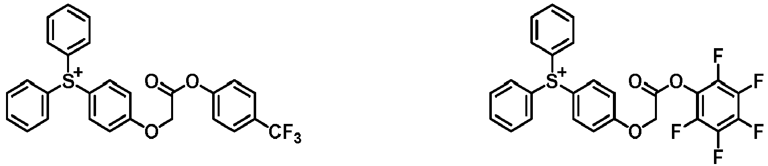

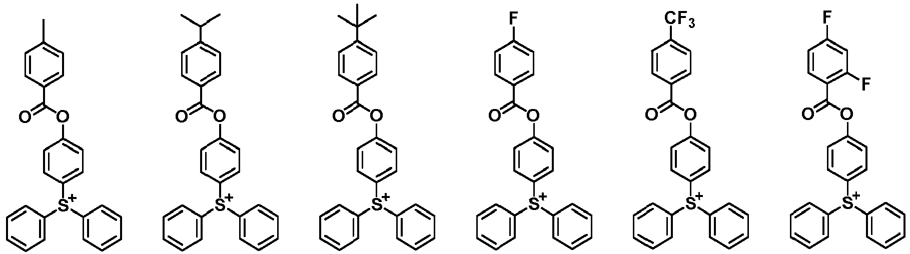

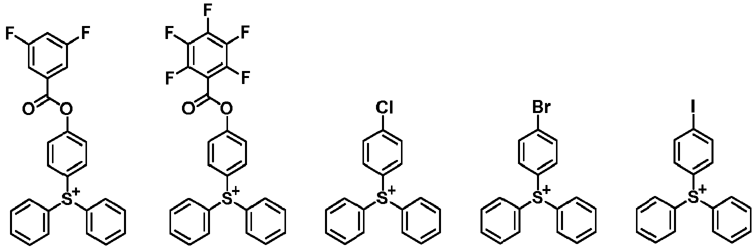

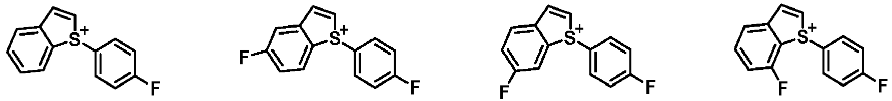

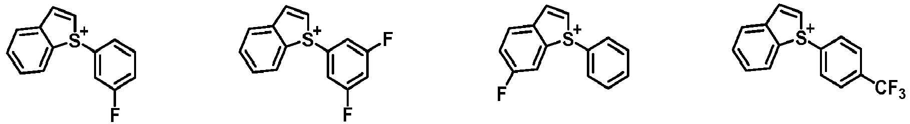

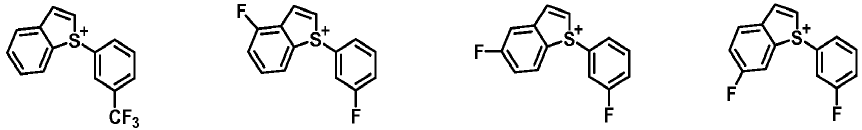

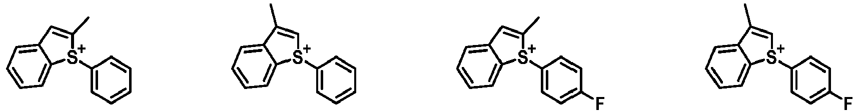

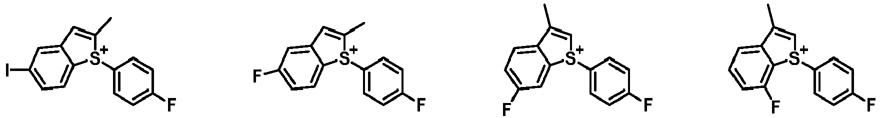

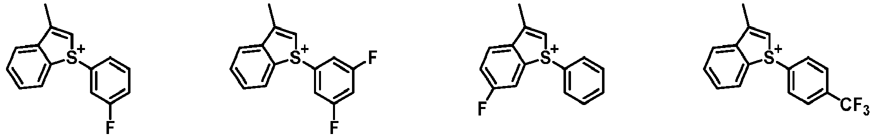

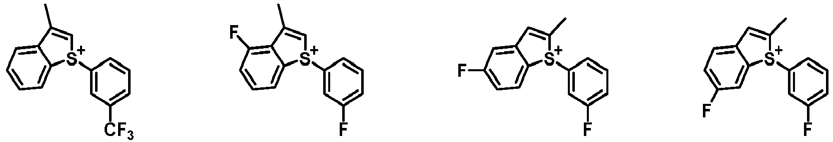

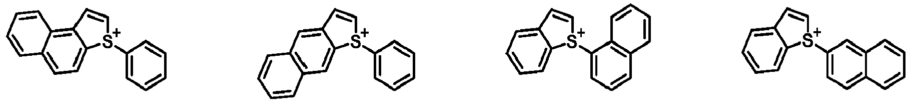

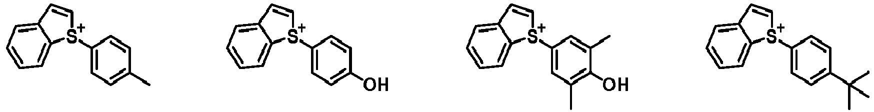

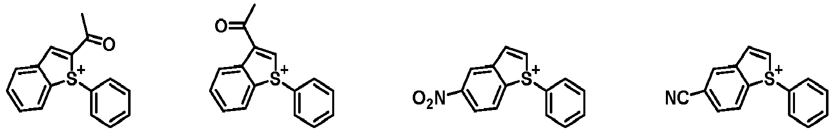

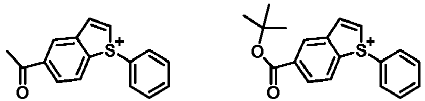

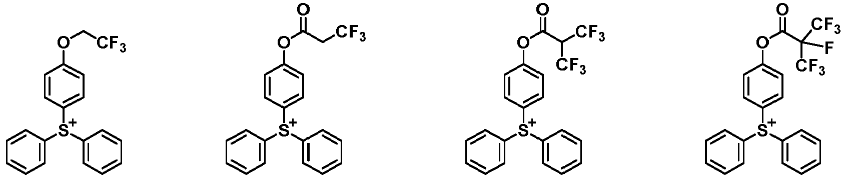

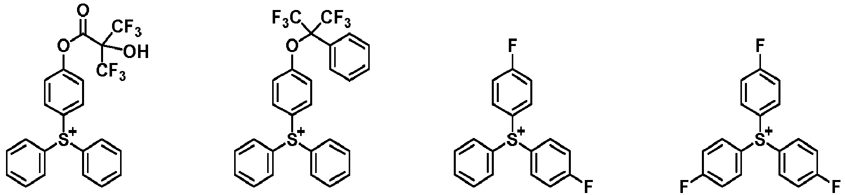

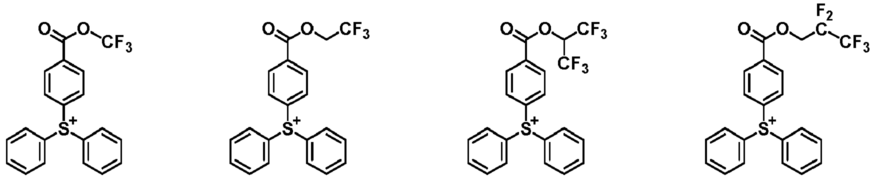

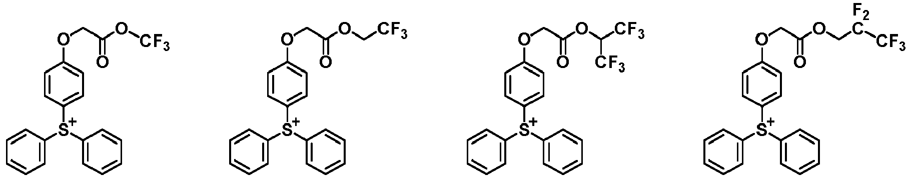

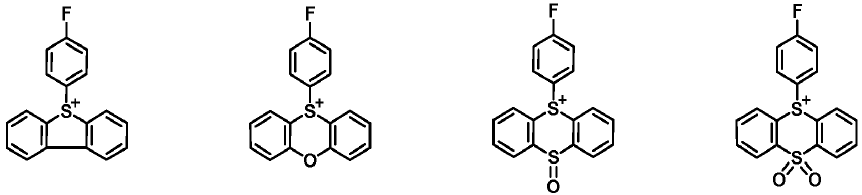

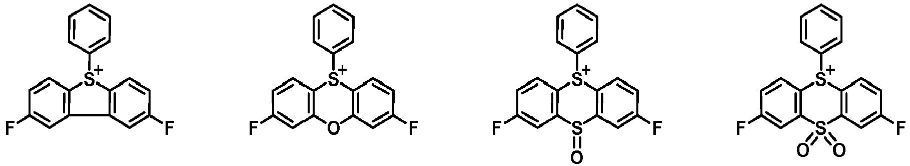

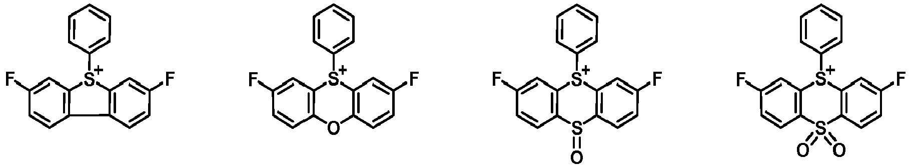

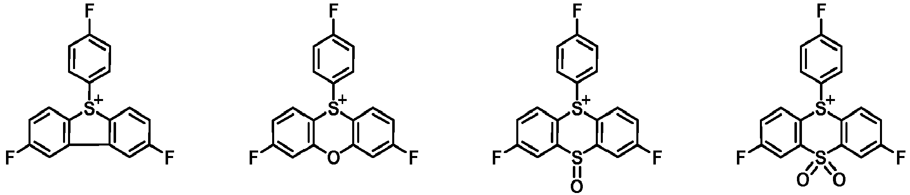

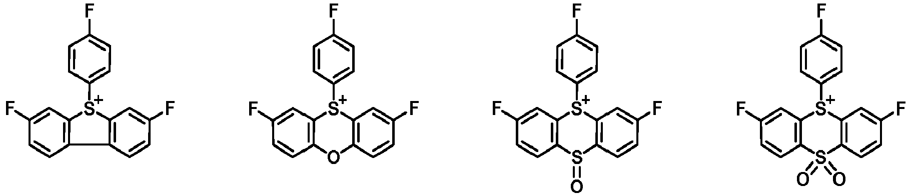

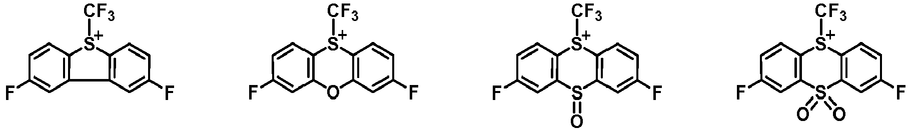

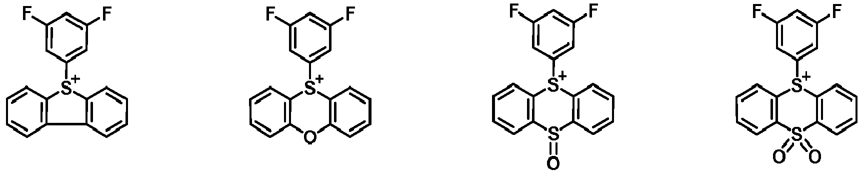

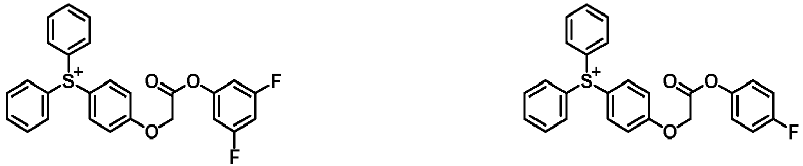

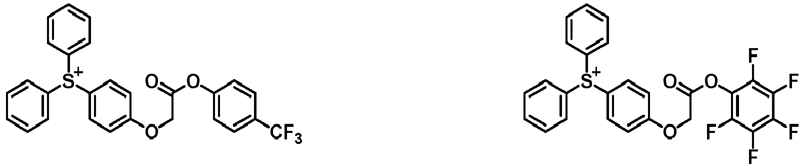

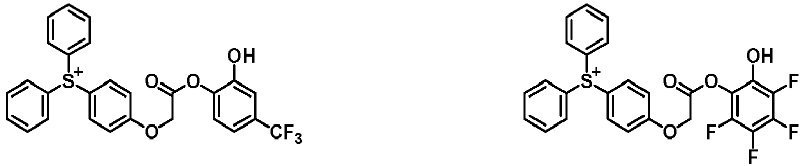

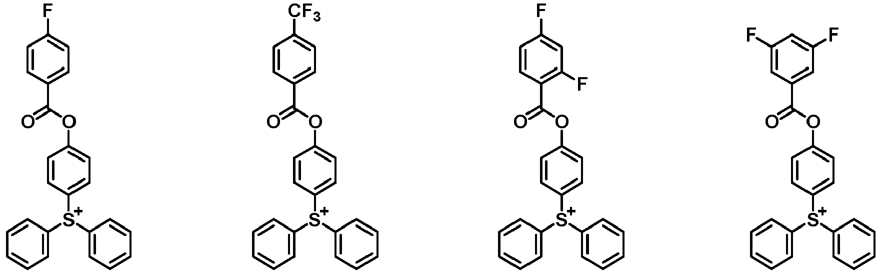

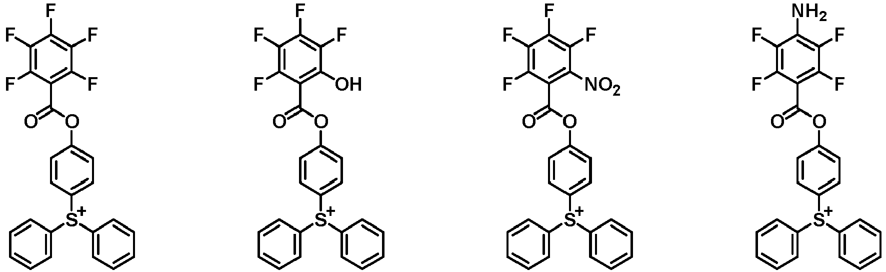

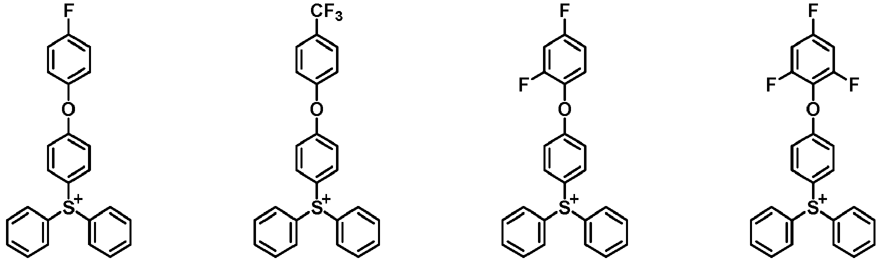

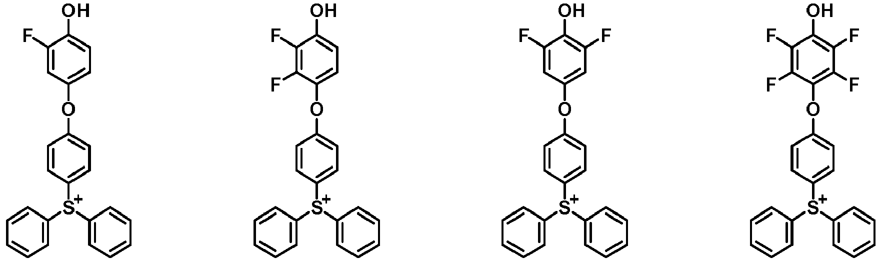

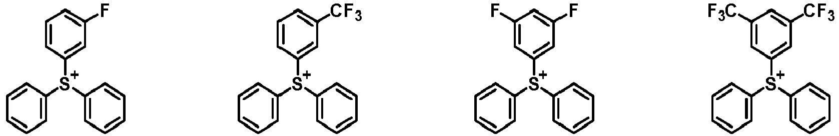

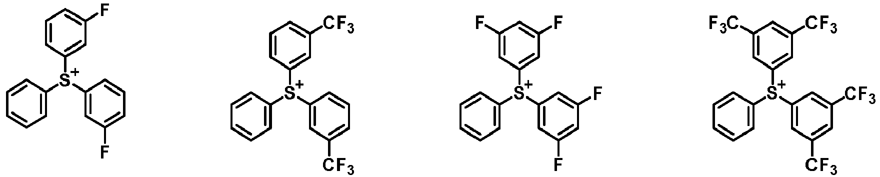

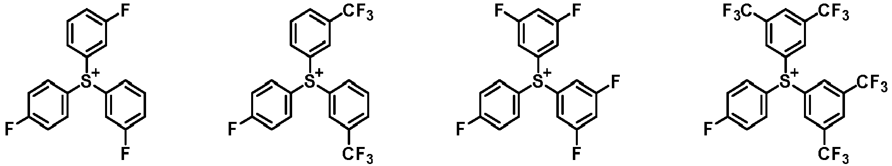

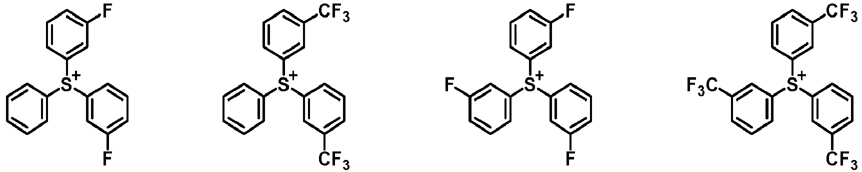

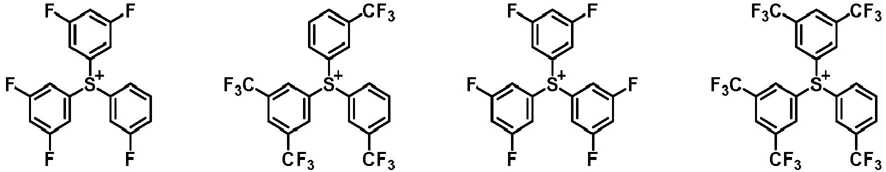

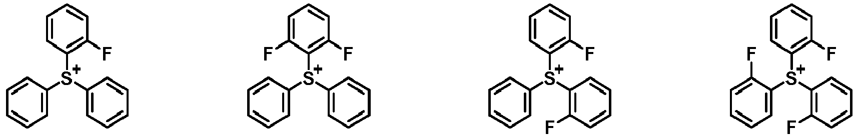

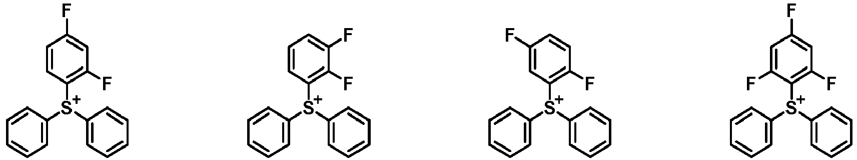

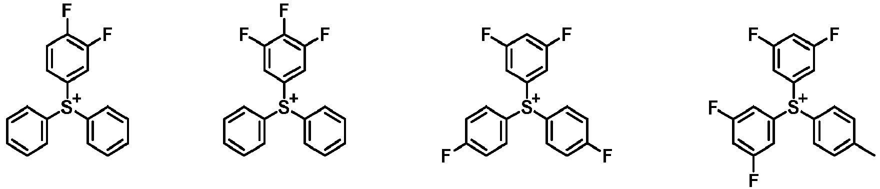

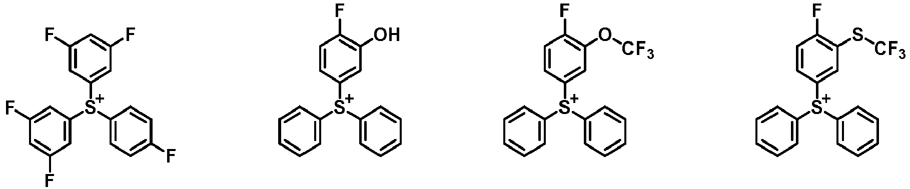

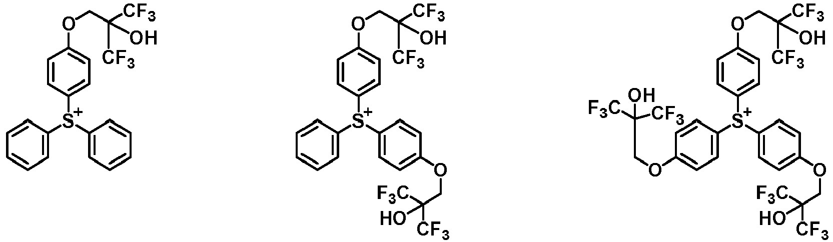

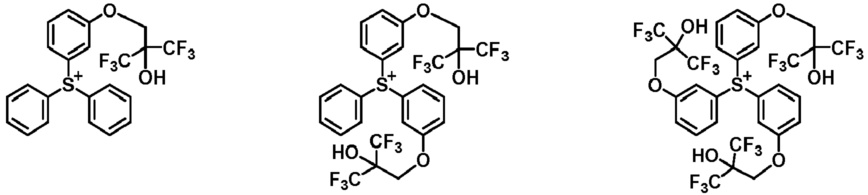

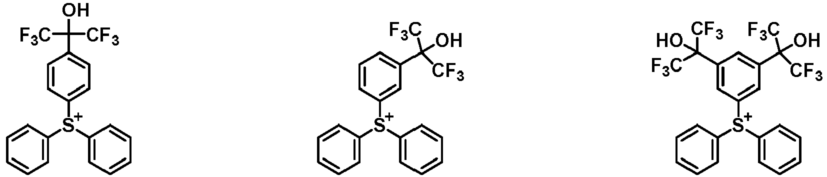

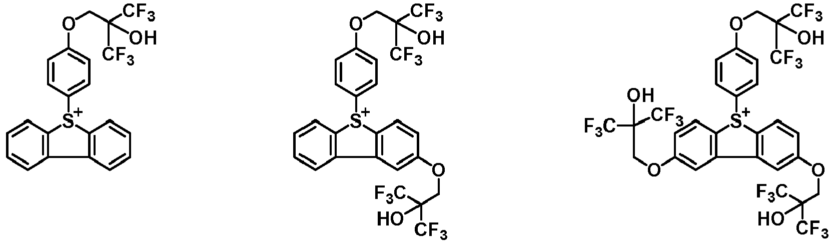

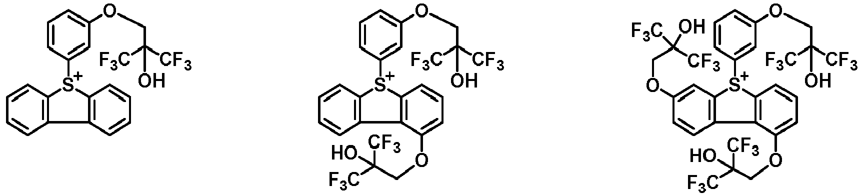

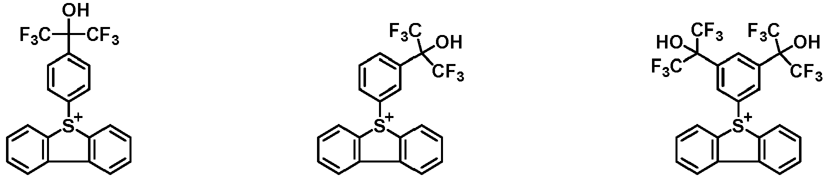

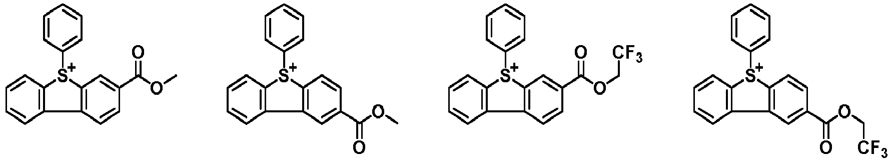

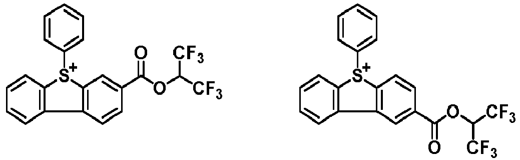

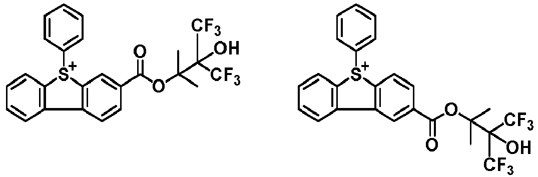

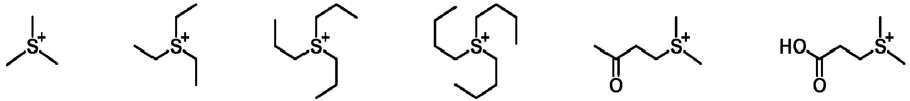

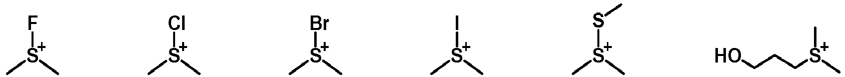

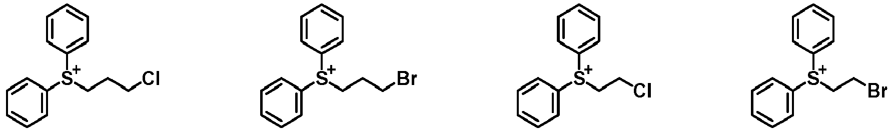

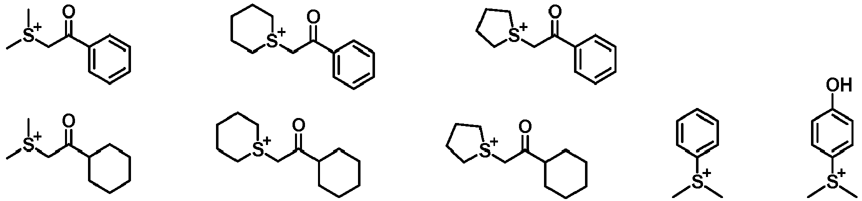

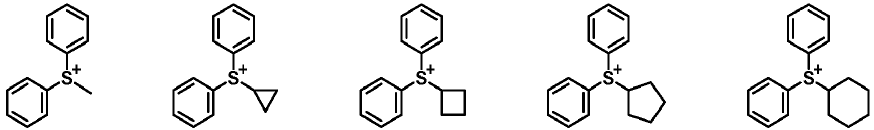

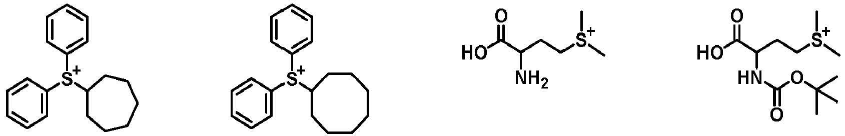

Examples of the iodonium cation having formula (cation-2) are shown below, but not limited thereto.

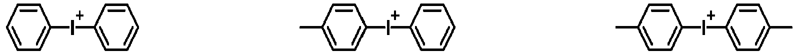

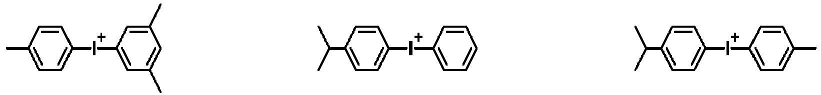

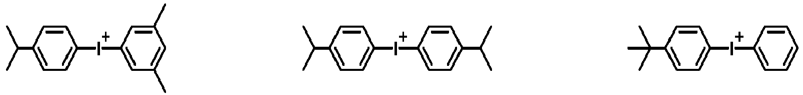

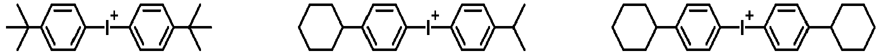

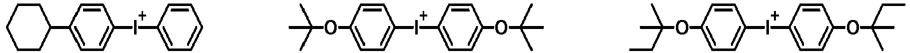

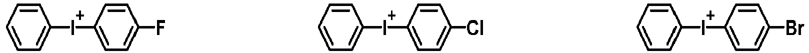

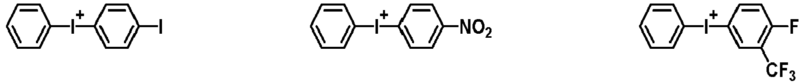

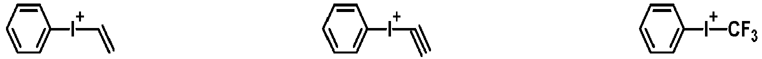

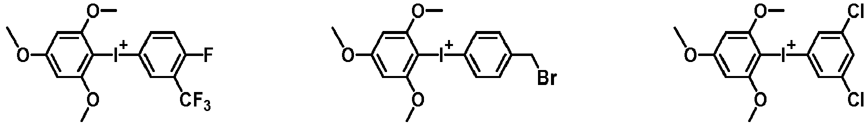

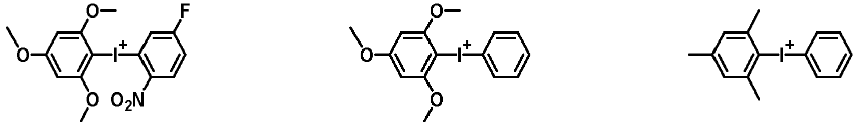

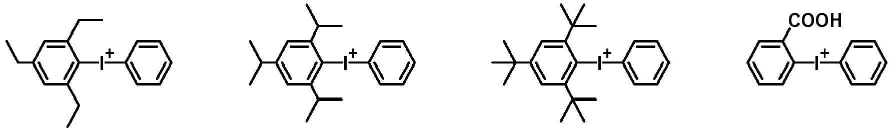

Specific structures of the onium salt having formula (A) include arbitrary combinations of the anion with the cation, both as exemplified above.

The onium salt having formula (A) may be synthesized by any well-known methods. Reference is now made to the synthesis of an onium salt having formula (A) wherein L is a sulfonate ester bond although the synthesis method is not limited thereto.

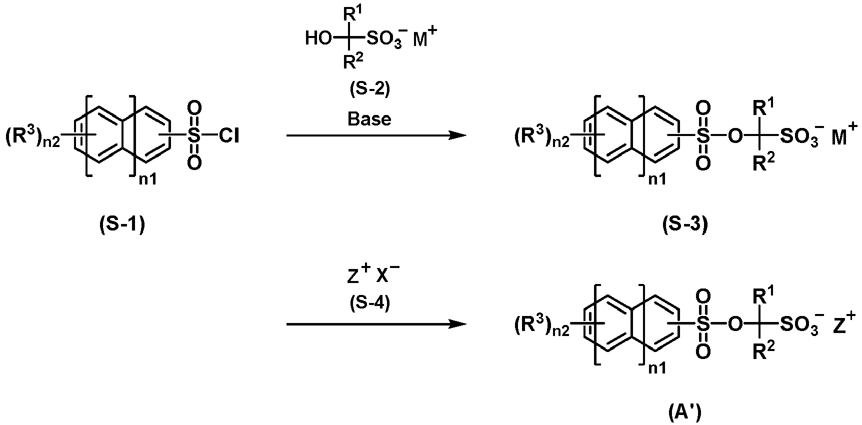

Herein, n1, n2, R¹, R², R³ and Z⁺ are as defined above. M⁺ is a lithium, sodium or potassium ion. X⁻ is a halide or methyl sulfate ion.

The first step is to react sulfonic chloride (S-1) with hydroxysulfonic salt (S-2) to form sulfonate salt (S-3). The reaction may be carried out in a standard way. Sulfonic chloride (S-1), hydroxysulfonic salt (S-2), and a base are sequentially or simultaneously added to a solvent while cooling or heating the reaction system, if necessary.

Examples of the solvent which can be used in the first step include water, tetrahydrofuran (THF), ethers such as diethyl ether, diisopropyl ether, di-n-butyl ether, and 1,4-dioxane, hydrocarbons such as n-hexane, n-heptane, benzene, toluene and xylene, aprotic polar solvents such as acetonitrile, dimethyl sulfoxide (DMSO), and N,N-dimethylformamide (DMF), chlorinated organic solvents such as methylene chloride, chloroform and carbon tetrachloride. Any of these solvents may be selected in accordance with reaction conditions while they may be used alone or in admixture.

Examples of the base which can be used in the first step include amines such as ammonia, triethylamine, pyridine, lutidine, collidine, and N,N-dimethylaniline, hydroxides such as sodium hydroxide, potassium hydroxide, and tetramethylammonium hydroxide; and carbonate salts such as potassium carbonate and sodium hydrogencarbonate. The bases may be used alone or in admixture.

The second step is ion exchange reaction of sulfonate salt (S-3) with onium salt (S-4) to form an onium salt (A'). The sulfonate salt (S-3) obtained from the reaction of the first step is subjected to standard aqueous workup and isolated prior to use. Also, the sulfonate salt (S-3) at the end of reaction may be used as such without post-treatment.

When sulfonate salt (S-3) as isolated is used, it is dissolved in a solvent, and mixed with onium salt (S-4) to form a reaction mixture, which may be cooled or heated if necessary. Examples of the solvent which can be used herein include water, THF, ethers such as diethyl ether, diisopropyl ether, di-n-butyl ether, and 1,4-dioxane, hydrocarbons such as n-hexane, n-heptane, benzene, toluene and xylene, aprotic polar solvents such as acetonitrile, DMSO, and DMF, and chlorinated organic solvents such as methylene chloride, chloroform and carbon tetrachloride. Thereafter, onium salt (A') is recovered from the reaction mixture via standard aqueous workup. If necessary, the onium salt (A') may be purified by a conventional method such as distillation, recrystallization or chromatography.

When sulfonate salt (S-3) obtained at the end of synthesis reaction is used without post-treatment, onium salt (S-4) is added to the reaction mixture at the end of synthesis reaction of sulfonate salt (S-3). The reaction mixture may be cooled or heated if necessary, obtaining onium salt (A'). At this point, a solvent may be added to the reaction mixture, if necessary. Exemplary solvents include water, THF, ethers such as diethyl ether, diisopropyl ether, di-n-butyl ether, and 1,4-dioxane, hydrocarbons such as n-hexane, n-heptane, benzene, toluene and xylene, aprotic polar solvents such as acetonitrile, DMSO, and DMF, chlorinated organic solvents such as methylene chloride, chloroform and carbon tetrachloride. Thereafter, onium salt (A') is recovered from the reaction mixture via standard aqueous workup. If necessary, onium salt (A') may be purified by a conventional method such as recrystallization or chromatography.

Since the onium salt having formula (A) has an onium salt structure of non-fluorinated sulfonic acid, it generates an acid having an appropriate strength upon exposure to high-energy radiation. The bulky substituent positioned at α-position of -SO₃⁻ becomes a shield in the proximity of the generated sulfonic acid. The bulky substituent at α-position and another bulky substituent on an aromatic ring serve to restrain rotation of a bond axis of L for linking them due to steric hindrance. This restrains excessive diffusion of the generated acid. By the synergy of these effects, a pattern having a satisfactory contrast between exposed and unexposed regions can be formed and even a pattern of small feature size can be formed at a minimal roughness. Due to these effects, an acid having an appropriate strength and controlled diffusion is generated in the resist film. A small size pattern can be formed with satisfactory resolution and reduced LER. When the negative resist composition is developed in an alkaline developer, a pattern of satisfactory rectangularity can be formed by virtue of appropriate dissolution inhibition.

In the chemically amplified negative resist composition, the onium salt having formula (A) is preferably present in an amount of 0.001 to 50 parts by weight, more preferably 0.01 to 40 parts by weight per 80 parts by weight of the base polymer (B), in view of sensitivity and acid diffusion-suppressing effect.

In the resist composition, an acid generator other than the onium salt having formula (A), which is referred to as other acid generator, hereinafter, may be added for the purpose of correcting the profile of patterns. The other acid generator may be selected from well-known acid generators for resist compositions. The amount of the other acid generator is preferably 0 to 40 parts by weight, more preferably 0 to 30 parts by weight per 80 parts by weight of the base polymer (B) in view of sensitivity and acid diffusion-suppressing effect. The other acid generator may be used alone or in admixture.

### (B) Base polymer

The base polymer as component (B) contains a polymer comprising repeat units having the following formula (B1). Notably, the polymer is referred to as polymer B and the units having formula (B1) are also referred to as units B1. The repeat units B1 are effective for providing etch resistance, adhesion to substrates, and solubility in alkaline developer.

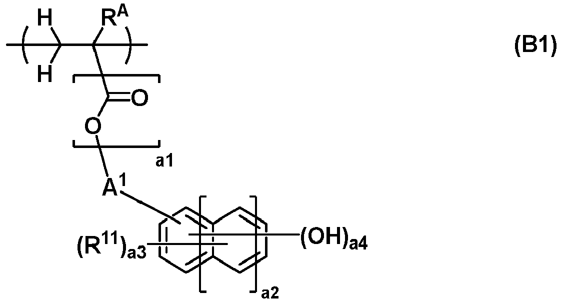

In formula (B 1), a1 is 0 or 1. The subscript a2 is an integer of 0 to 2. The corresponding structure represents a benzene skeleton when a2=0, a naphthalene skeleton when a2=1, and an anthracene skeleton when a2=2. The subscript a3 is an integer in the range: 0 ≤ a3 ≤ 5+2(a2)-a4, and a4 is an integer of 1 to 3. In case of a2=0, preferably a3 is an integer of 0 to 3, and a4 is an integer of 1 to 3. In case of a2=1 or 2, preferably a3 is an integer of 0 to 4, and a4 is an integer of 1 to 3.

In formula (B1), R^{A} is hydrogen, fluorine, methyl or trifluoromethyl.

In formula (B1), R¹¹ is halogen, an optionally halogenated C₁-C₆ saturated hydrocarbyl group, optionally halogenated C₁-C₆ saturated hydrocarbyloxy group or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic. Examples thereof include alkyl groups such as methyl, ethyl, n-propyl, isopropyl, butyl, pentyl, hexyl and structural isomers thereof; cycloalkyl groups such as cyclopropyl, cyclobutyl, cyclopentyl and cyclohexyl; and combinations thereof. A carbon count within the upper limit ensures a sufficient solubility in alkaline developer. When a3 is 2 or more, a plurality of groups R¹¹ may be identical or different.

In formula (B 1), A¹ is a single bond or a C₁-C₁₀ saturated hydrocarbylene group in which any constituent -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of a1=1 in formula (B 1), the ether bond may be incorporated at any position excluding the position between the α- and β-carbons relative to the ester oxygen. In case of a1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B1 wherein a1=0 and A¹ is a single bond (meaning that the aromatic ring is directly bonded to the main chain of the polymer), that is, repeat units free of a linker: -C(=O)-O-A¹- include units derived from 3-hydroxystyrene, 4-hydroxystyrene, 5-hydroxy-2-vinylnaphthalene, and 6-hydroxy-2-vinylnaphthalene. More preferred are repeat units having the formula (B 1-1). 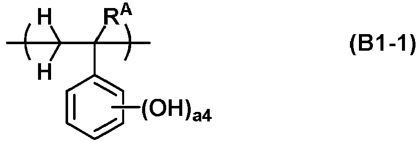 Herein R^{A} and a4 are as defined above.

Preferred examples of the repeat units B1 wherein a1=1, that is, having a linker: -CO-O-A¹- are shown below, but not limited thereto. 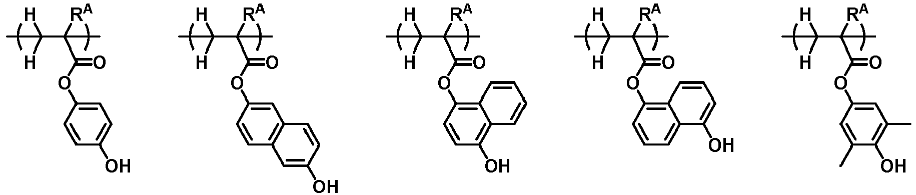 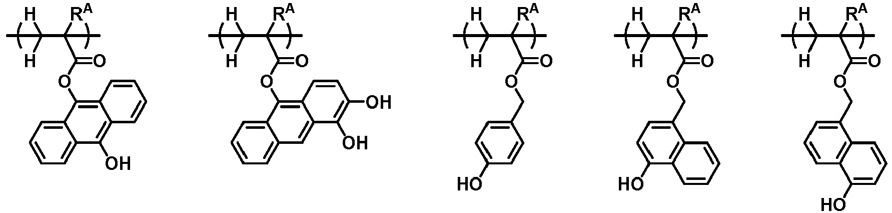 Herein R^{A} is as defined above.

The repeat units B 1 may be of one type or a combination of plural types.

The polymer B may further comprise repeat units having the formula (B2). Notably the repeat units having formula (B2) are simply referred to as repeat units B2. Of the polymers B, a polymer further comprising repeat units B2 is referred to as polymer B'. 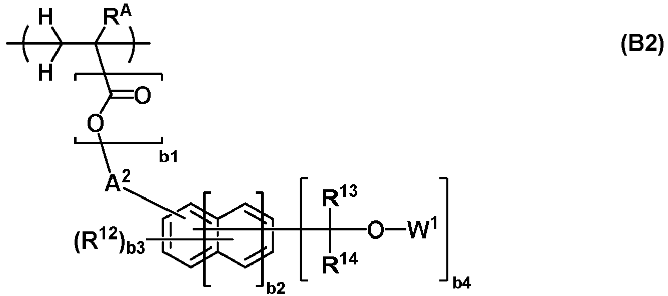 Upon exposure to high-energy radiation, the repeat unit B2 functions such that -O-W¹ undergoes elimination reaction under the action of an acid which is generated by the acid generator. That is, the unit B2 induces insolubilization in alkaline developer and crosslinking reaction between polymer molecules. The repeat unit B2 provides for efficient progress of negative-working reaction, leading to an improvement in resolution performance.

In formula (B2), b 1 is 0 or 1, b2 is an integer of 0 to 2, b3 is an integer in the range: 0 ≤ b3 ≤ 5+2(b2)-b4, and b4 is an integer of 1 to 3.

In formula (B2), R^{A} is hydrogen, fluorine, methyl or trifluoromethyl.

In formula (B2), R¹² is each independently halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic. Examples thereof include alkyl groups such as methyl, ethyl, propyl, isopropyl, butyl, pentyl, hexyl and structural isomers thereof; cycloalkyl groups such as cyclopropyl, cyclobutyl, cyclopentyl, and cyclohexyl; and combinations thereof. When b3 is 2 or more, a plurality of groups R¹² may be identical or different.

In formula (B2), R¹³ and R¹⁴ are each independently hydrogen, a C₁-C₁₅ saturated hydrocarbyl group which may be substituted with hydroxy or saturated hydrocarbyl moiety, or an optionally substituted aryl group. It is excluded that R¹³ and R¹⁴ are hydrogen at the same time. R¹³ and R¹⁴ may bond together to form a ring with the carbon atom to which they are attached. R¹³ and R¹⁴ are preferably selected from alkyl groups such as methyl, ethyl, propyl, butyl and structural isomers thereof, and substituted forms of the foregoing alkyl groups in which some hydrogen is substituted by a hydroxy or saturated hydrocarbyloxy moiety.

In formula (B2), A² is a single bond or C₁-C₁₀ saturated hydrocarbylene group in which some constituent -CH₂- may be replaced by -O-. The saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of b1=1 in formula (B2), the ether bond may be incorporated at any position excluding the position between the α- and β-carbons relative to the ester oxygen. In case of b1=0, the atom bonding to the backbone becomes an ether oxygen atom, and a second ether bond may be incorporated at any position excluding the position between the α- and β-carbons relative to the ether oxygen.

In formula (B2), W¹ is hydrogen, a C₁-C₁₀ aliphatic hydrocarbyl group, or an optionally substituted aryl group. The aliphatic hydrocarbyl group may be straight, branched or cyclic and examples thereof include alkyl groups such as methyl, ethyl, propyl, and isopropyl; and cyclic aliphatic hydrocarbyl groups such as cyclopentyl, cyclohexyl, and adamantyl. Typical of the aryl groups is phenyl. In the aliphatic hydrocarbyl group, some constituent -CH₂- may be replaced by -O-, -C(=O)-, -O-C(=O)- or -C(=O)-O-. The constituent -CH₂- in the hydrocarbyl group may be one bonded to the oxygen atom in formula (B2). Typical of the replaced group is methylcarbonyl.

Of the repeat units B2, repeat units having formula (B2-1) or (B2-2) are preferred. 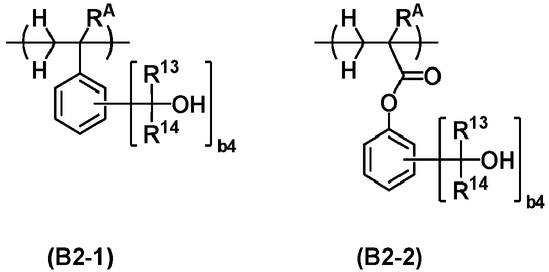 Herein R^{A}, R¹³, R¹⁴, and b4 are as defined above.

Preferred examples of the repeat unit B2 are given below, but not limited thereto. Herein R^{A} is as defined above.

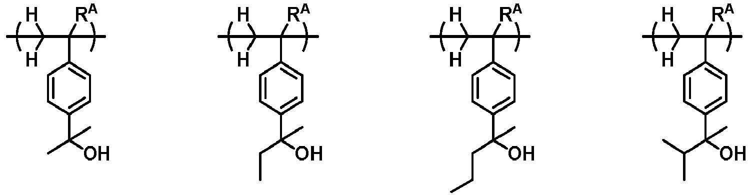

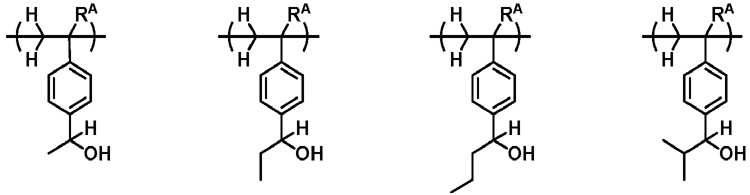

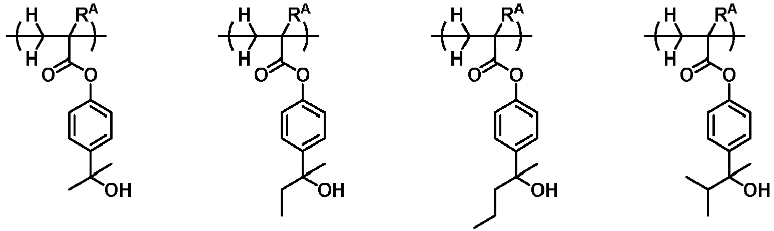

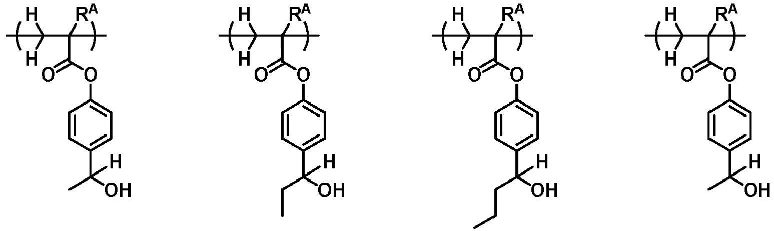

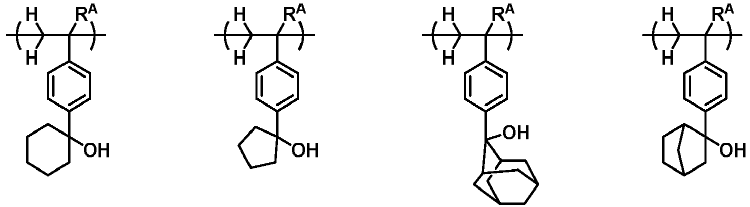

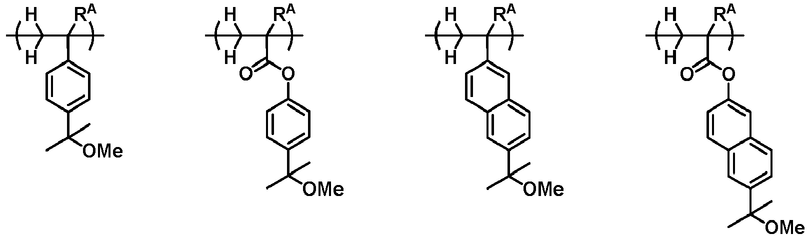

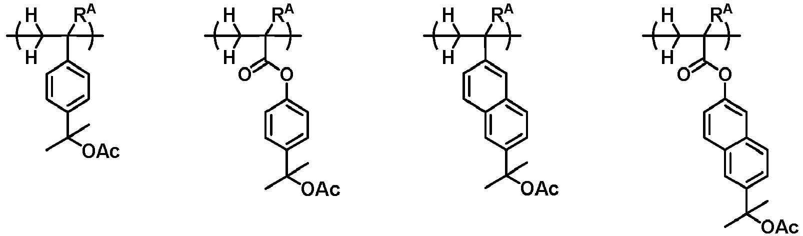

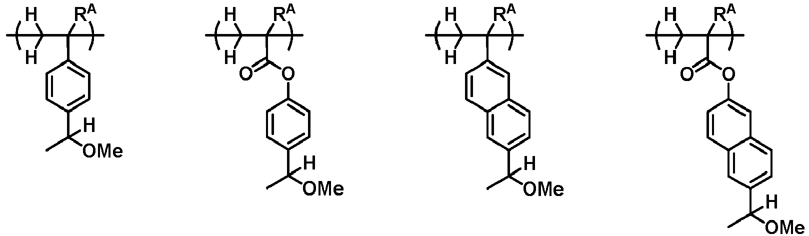

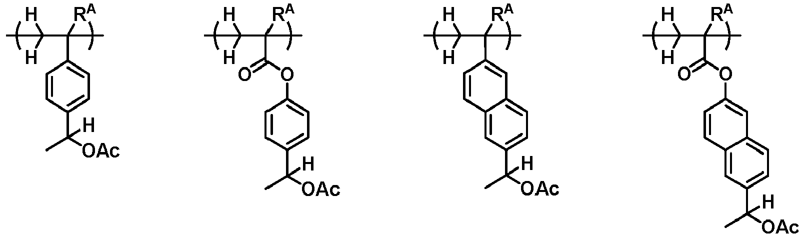

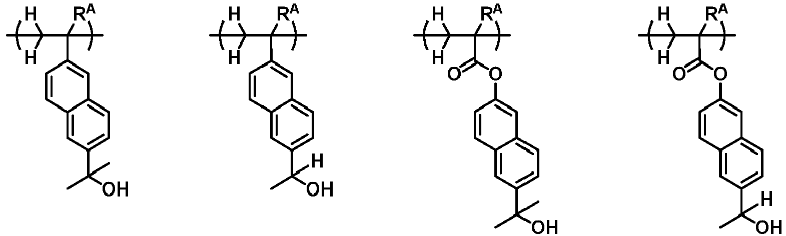

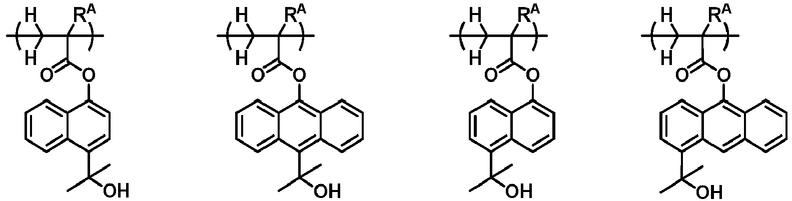

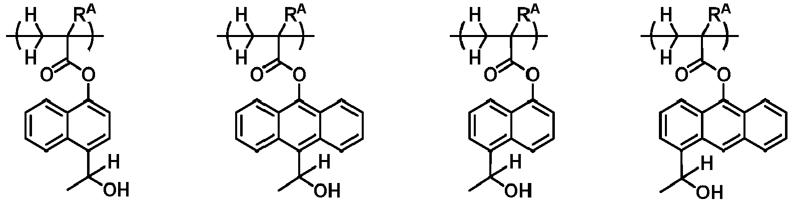

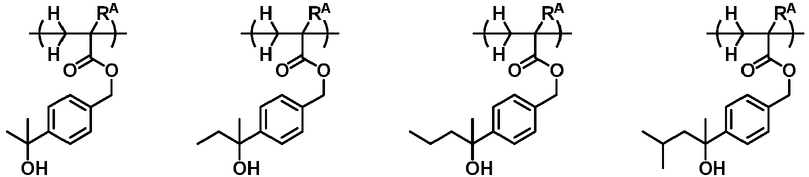

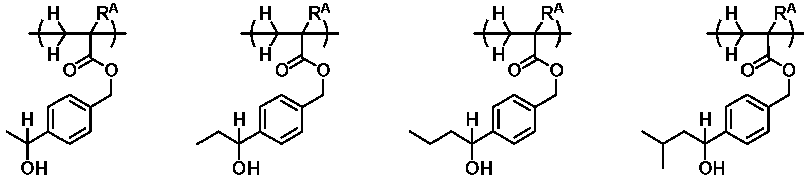

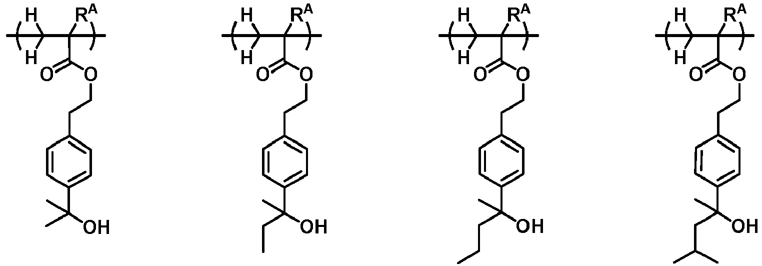

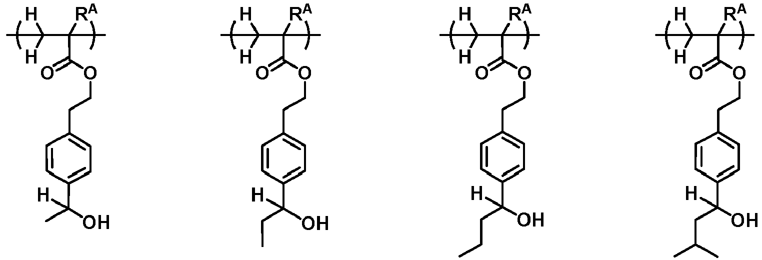

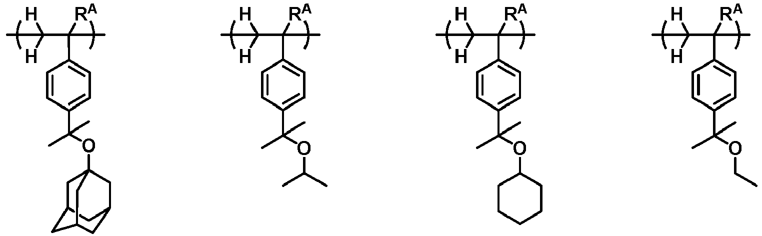

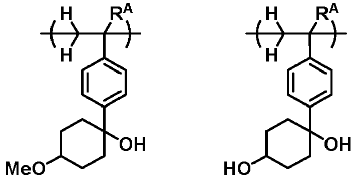

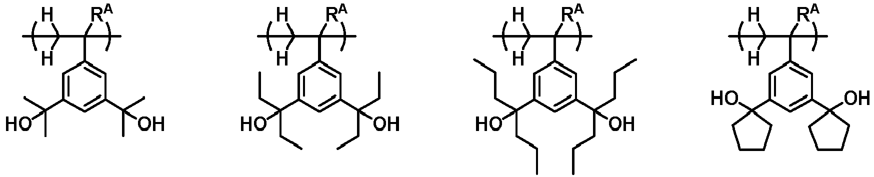

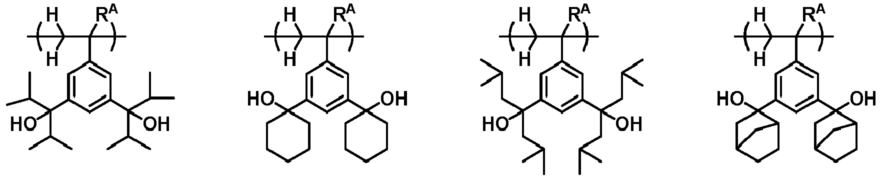

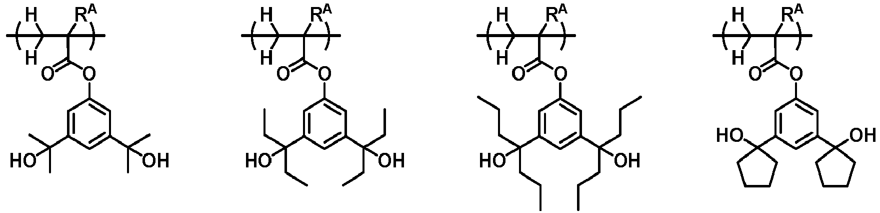

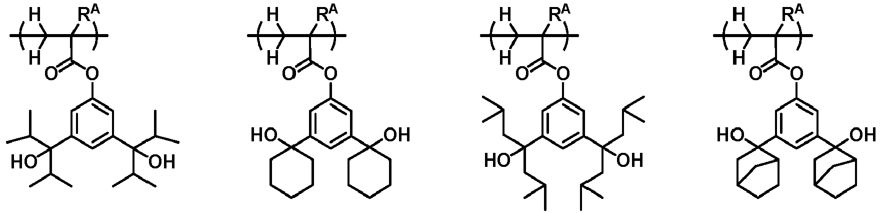

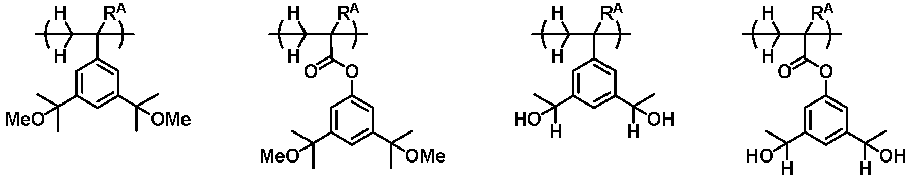

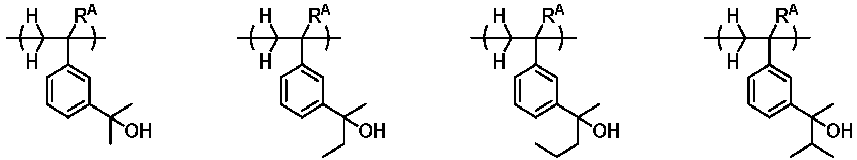

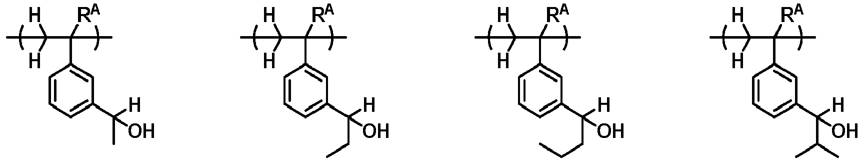

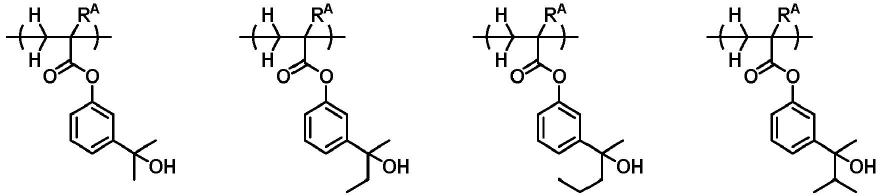

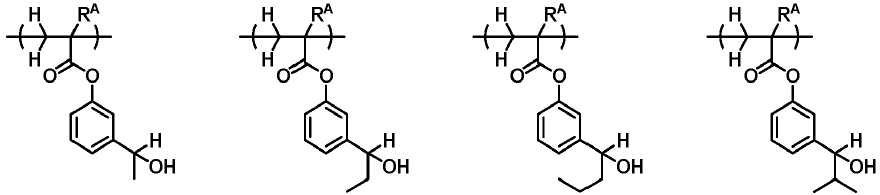

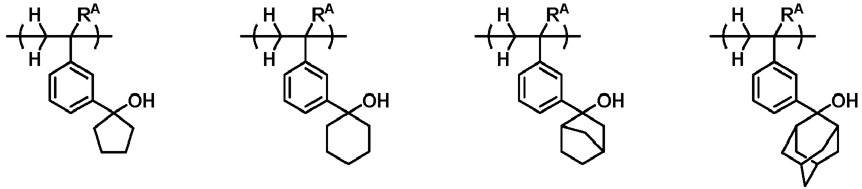

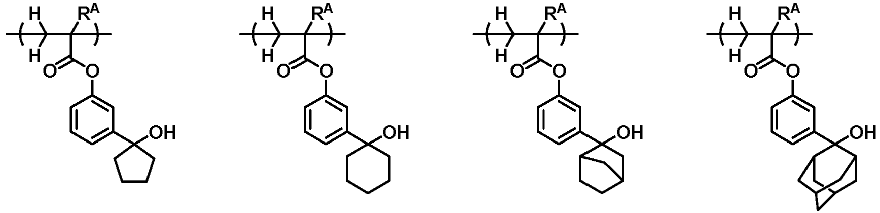

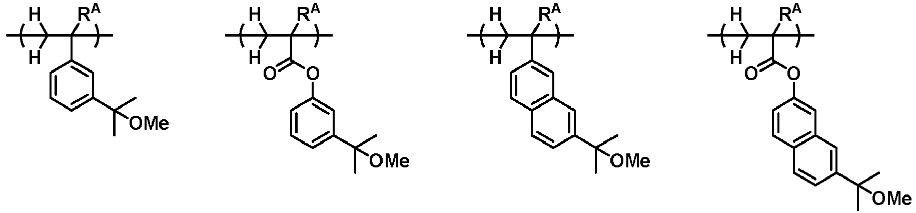

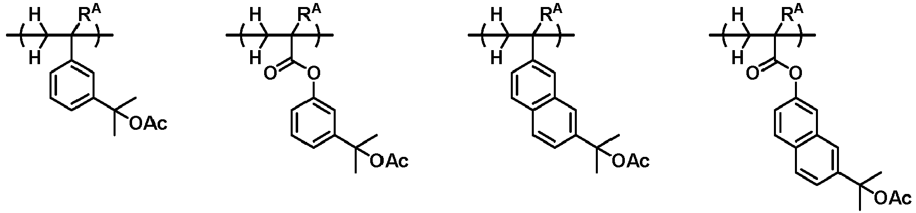

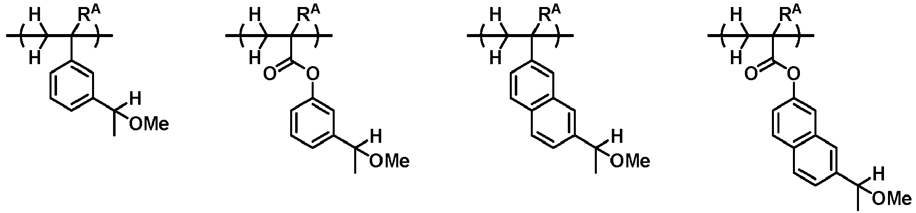

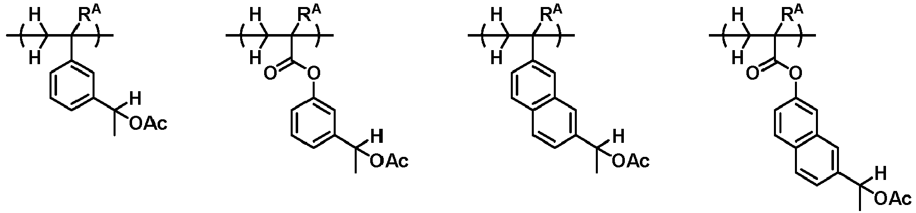

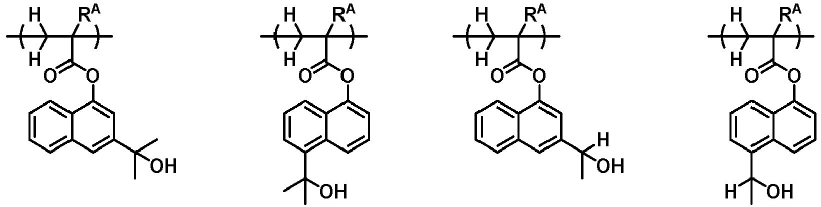

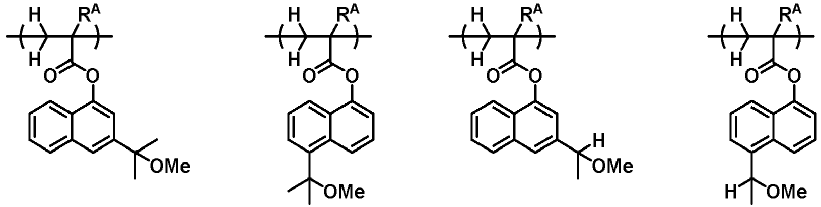

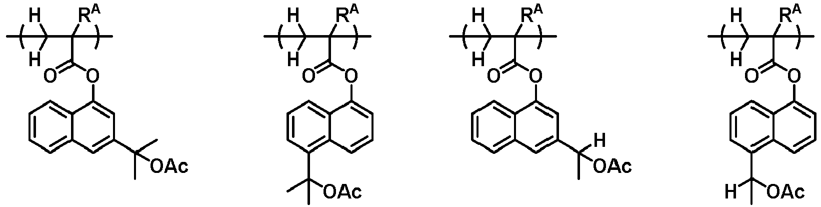

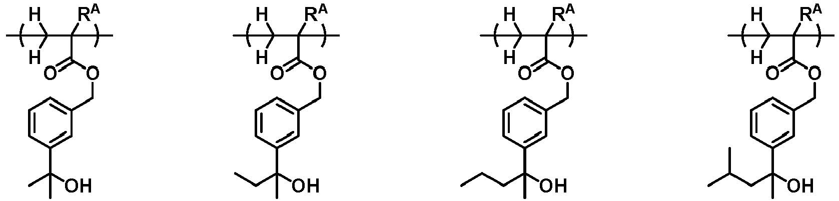

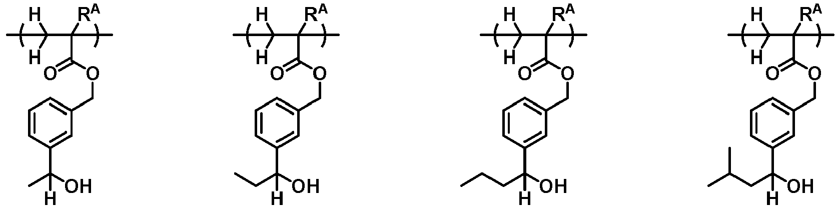

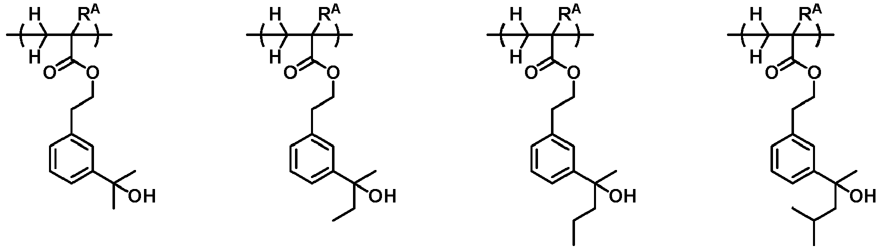

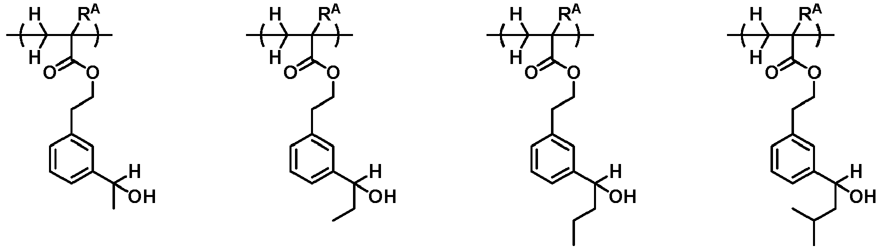

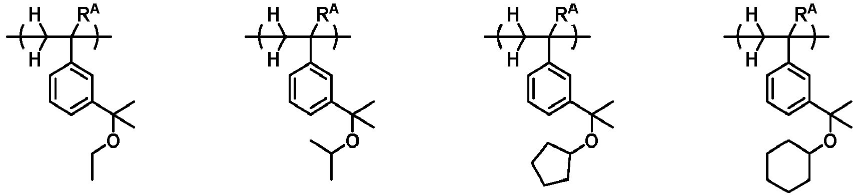

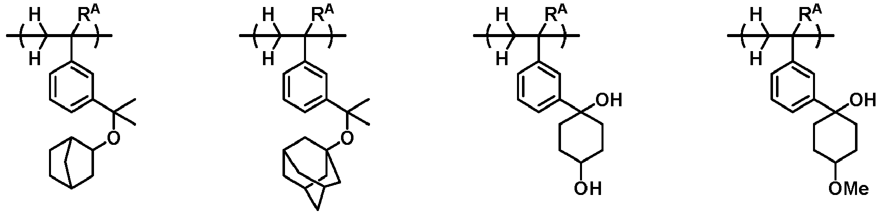

The repeat unit B2 may be of one type or a combination of plural types.

For the purpose of improving etch resistance, preferably the polymer B or B' further comprises repeat units of at least one type selected from repeat units having the formula (B3), repeat units having the formula (B4) and repeat units having the formula (B5). Notably these units are simply referred to as repeat units B3, B4 and B5.

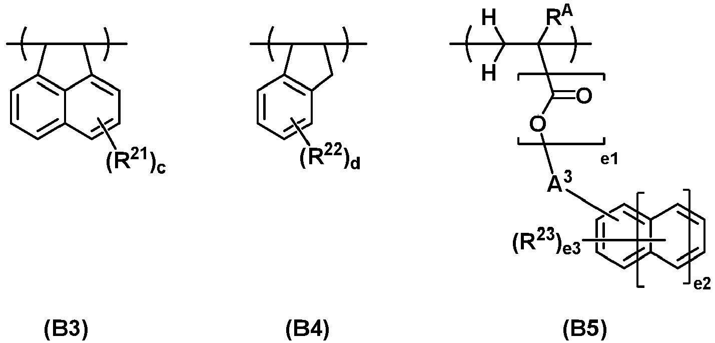

In formulae (B3) and (B4), c and d are each independently an integer of 0 to 4.

In formulae (B3) and (B4), R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group. The saturated hydrocarbyl group, saturated hydrocarbyloxy group, and saturated hydrocarbylcarbonyloxy group may be straight, branched or cyclic. When c is 2 or more, a plurality of groups R²¹ may be identical or different. When d is 2 or more, a plurality of groups R²² may be identical or different.

In formula (B5), e1 is 0 or 1. The subscript e2 is an integer of 0 to 2; the corresponding structure represents a benzene skeleton when e2=0, a naphthalene skeleton when e2=1, and an anthracene skeleton when e2=2. The subscript e3 is an integer of 0 to 5. In case of e2=0, preferably e3 is an integer of 0 to 3. In case of e2=1 or 2, preferably e3 is an integer of 0 to 4.

In formula (B5), R^{A} is hydrogen, fluorine, methyl or trifluoromethyl. R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen atom, nitro group, cyano group, C₁-C₂₀ saturated hydrocarbylsulfinyl group, or C₁-C₂₀ saturated hydrocarbylsulfonyl group. The saturated hydrocarbyl group, saturated hydrocarbyloxy group, saturated hydrocarbylcarbonyloxy group, saturated hydrocarbyloxyhydrocarbyl group, saturated hydrocarbylthiohydrocarbyl group, saturated hydrocarbylsulfinyl group, and saturated hydrocarbylsulfonyl group may be straight, branched or cyclic. When e3 is 2 or more, a plurality of groups R²³ may be identical or different.

R²³ is preferably selected from halogen atoms such as chlorine, bromine and iodine; saturated hydrocarbyl groups such as methyl, ethyl, propyl, butyl, pentyl, hexyl, cyclopentyl, cyclohexyl, and structural isomers thereof; and saturated hydrocarbyloxy groups such as methoxy, ethoxy, propoxy, butoxy, pentyloxy, hexyloxy, cyclopentyloxy, cyclohexyloxy, and structural isomers of their hydrocarbon moiety. Inter alia, methoxy and ethoxy are most useful.

The saturated hydrocarbylcarbonyloxy group may be readily introduced into a polymer even after polymerization, by a chemical modification method and is advantageously utilized for fine adjustment of the solubility of the polymer in alkaline developer. Examples of the saturated hydrocarbylcarbonyloxy group include methylcarbonyloxy, ethylcarbonyloxy, propylcarbonyloxy, butylcarbonyloxy, pentylcarbonyloxy, hexylcarbonyloxy, cyclopentylcarbonyloxy, cyclohexylcarbonyloxy, benzoyloxy, and structural isomers of their hydrocarbon moiety. As long as the carbon count is equal to or less than 20, an appropriate effect of controlling or adjusting (typically reducing) the solubility of the polymer in alkaline developer is obtainable, and the generation of scum or development defects may be suppressed.

Of the foregoing preferred substituent groups, such substituent groups as chlorine, bromine, iodine, methyl, ethyl and methoxy are useful because the corresponding monomers may be readily prepared.

In formula (B5), A³ is a single bond or C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of e1=1 in formula (B5), the ether bond may be incorporated at any position excluding the position between the α- and β-carbons relative to the ester oxygen. In case of e1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B5 wherein e1 is 0 and A³ is a single bond (meaning that the aromatic ring is directly bonded to the main chain of the polymer), that is, repeat units free of the linker: -C(=O)-O-A³- include units derived from styrene, 4-chlorostyrene, 4-bromostyrene, 4-methylstyrene, 4-methoxystyrene, 4-acetoxystyrene, 2-hydroxypropylstyrene, 2-vinylnaphthalene, and 3-vinylnaphthalene.

Preferred examples of the repeat units B5 wherein e1 is 1, that is, having the linker: -C(=O)-O-A³- are shown below, but not limited thereto. R^{A} is as defined above.

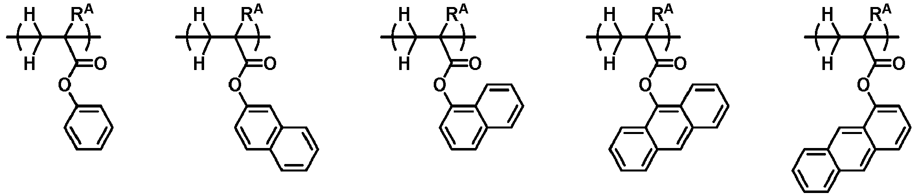

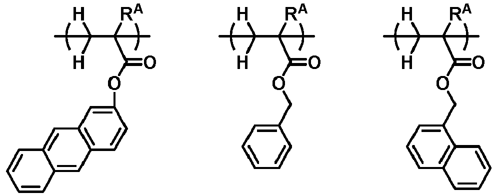

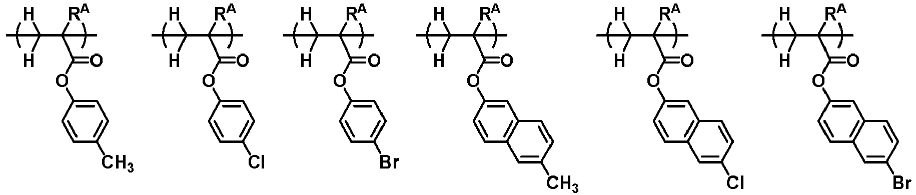

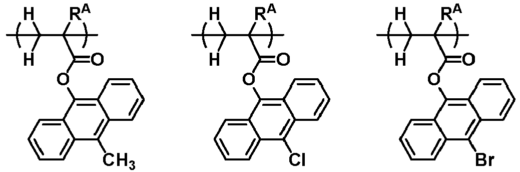

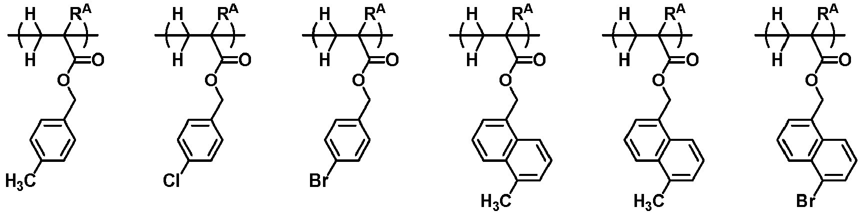

When repeat units of at least one type selected from repeat units B3 to B5 are incorporated, better performance is obtained because not only the aromatic ring possesses etch resistance, but the cyclic structure incorporated into the main chain also exerts the effect of improving resistance to etching and EB irradiation during pattern inspection step.

The repeat units B3 to B5 may be of one type or a combination of plural types.

The polymer B' may further comprise repeat units of at least one type selected from repeat units having the formula (B6), repeat units having the formula (B7), repeat units having the formula (B8), repeat units having the formula (B9), repeat units having the formula (B10), repeat units having the formula (B11), repeat units having the formula (B12), and repeat units having the formula (B13). Notably these repeat units are also referred to as repeat units B6 to B 13. The polymer B' in this embodiment is more effective for restraining acid diffusion and ensures to form a pattern with improved resolution and reduced LER. 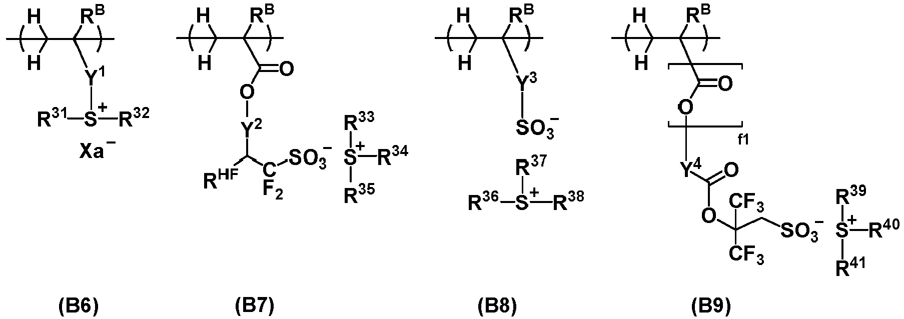 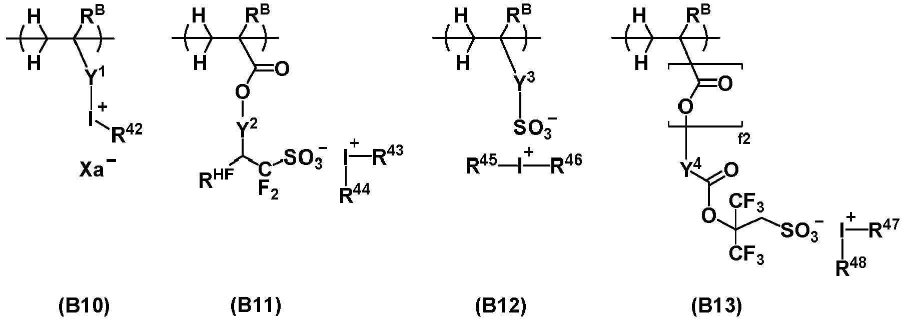 In formulae (B6) to (B13), R^{B} is each independently hydrogen or methyl. Y¹ is a single bond, a C₁-C₆ aliphatic hydrocarbylene group, phenylene group, naphthylene group, or C₇-C₁₈ group obtained by combining the foregoing, *-O-Y¹¹-, *-C(=O)-O-Y¹¹-, or *-C(=O)-NH-Y¹¹-, wherein Y¹¹ is a C₁-C₆ aliphatic hydrocarbylene group, phenylene group, naphthylene group, or C₇-C₁₈ group obtained by combining the foregoing, which may contain a carbonyl moiety, ester bond, ether bond or hydroxy moiety. Y² is a single bond or **-Y²¹-C(=O)-O-, wherein Y²¹ is a C₁-C₂₀ hydrocarbylene group which may contain a heteroatom. Y³ is a single bond, methylene, ethylene, phenylene, fluorinated phenylene, trifluoromethyl-substituted phenylene group, *-O-Y³¹-, *-C(=O)-O-Y³¹-, or *-C(=O)-NH-Y³¹-, wherein Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety. Herein * designates a point of attachment to the carbon atom in the backbone and ** designates a point of attachment to the oxygen atom in the formula. Y⁴ is a single bond or a C₁-C₃₀ hydrocarbylene group which may contain a heteroatom. The subscripts f1 and f2 are each independently 0 or 1. When Y⁴ is a single bond, f1 and f2 are 0.

In formulae (B6) and (B10), Xa⁻ is a non-nucleophilic counter ion, examples of which include those described in JP-A 2010-113209 and JP-A 2007-145797.

In formulae (B7) and (B11) wherein Y² is -Y²¹-C(=O)-O-, Y²¹ is a C₁-C₂₀ hydrocarbylene group which may contain a heteroatom, examples of which are shown below, but not limited thereto.

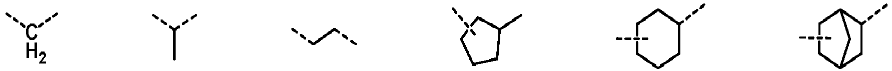

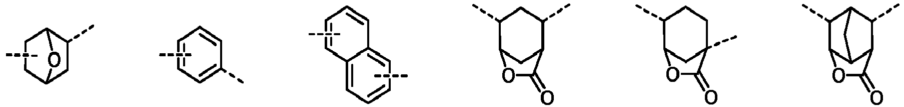

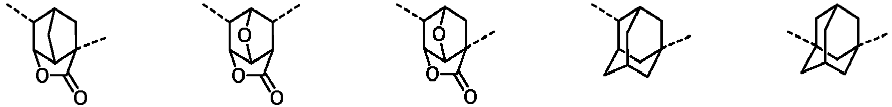

In formulae (B7) and (B11), R^{HF} is hydrogen or trifluoromethyl. Examples of the repeat units B7 and B11 wherein R^{HF} is hydrogen include those described in JP-A 2010-116550. Examples of the repeat units B7 and B11 wherein R^{HF} is trifluoromethyl include those described in JP-A 2010-077404. Examples of the repeat units B8 and B12 include those described in JP-A 2012-246265 and JP-A 2012-246426.

Preferred examples of the anion in the monomers from which repeat units B9 and B13 are derived are shown below, but not limited thereto.

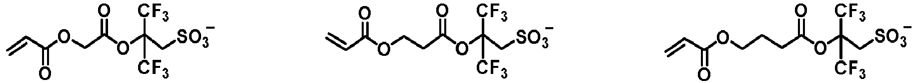

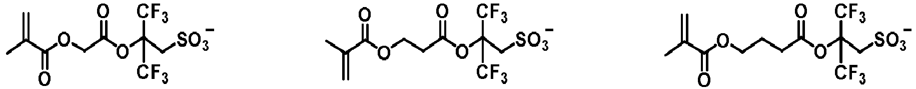

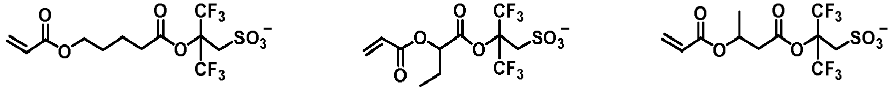

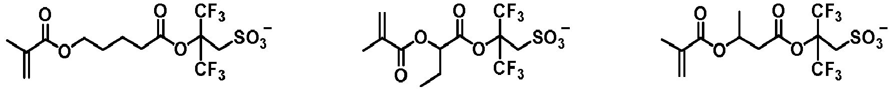

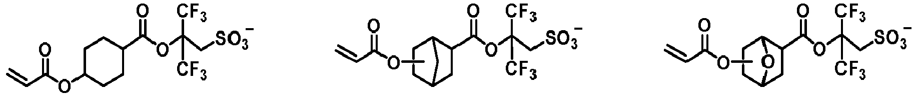

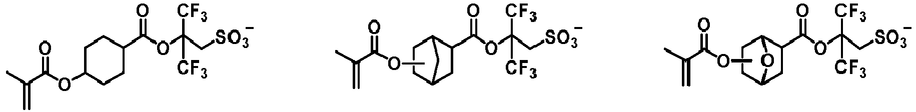

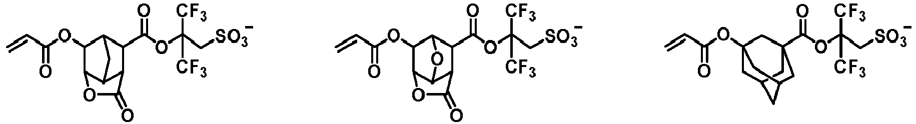

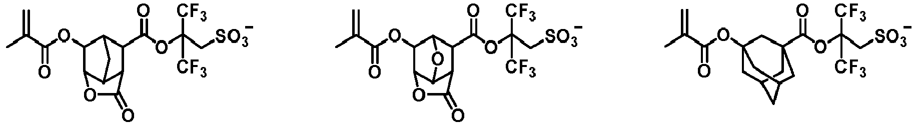

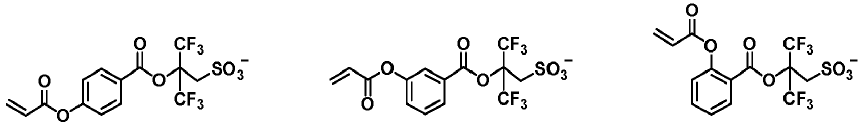

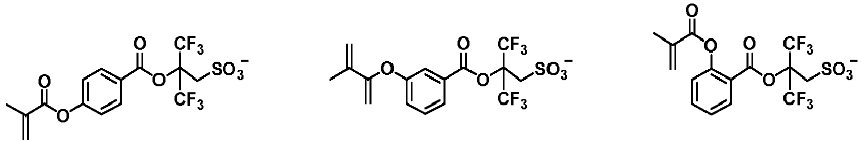

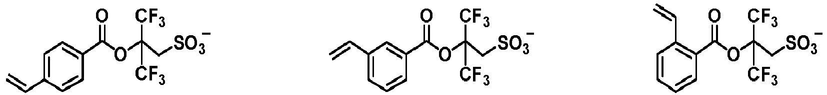

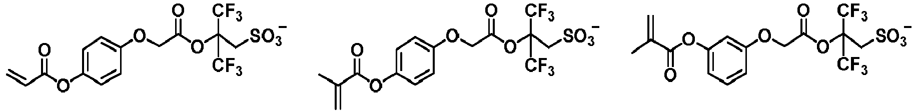

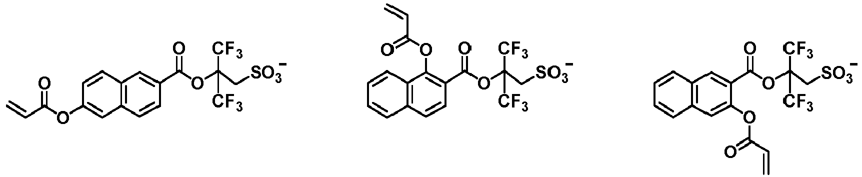

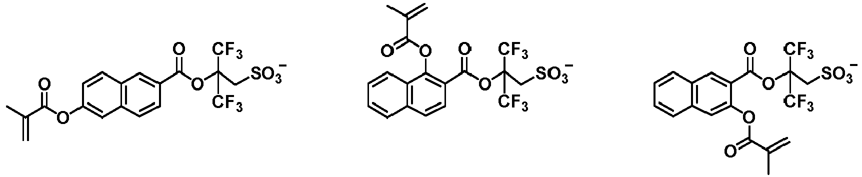

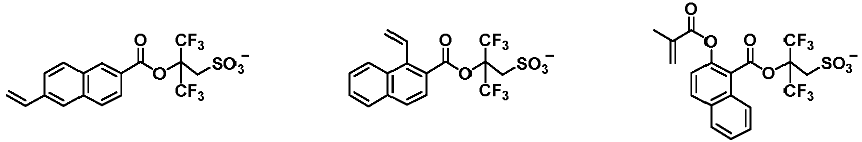

In formulae (B6) to (B13), R³¹ to R⁴⁸ are each independently halogen or a C₁-C₂₀ hydrocarbyl group which may contain a heteroatom. The hydrocarbyl group may be saturated or unsaturated and straight, branched or cyclic. Examples of the halogen and hydrocarbyl group are as exemplified above for R^{ct1} to R^{ct5} in formulae (cation-1) and (cation-2). In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, fluorine, chlorine, bromine, iodine, cyano moiety, nitro moiety, carbonyl moiety, ether bond, ester bond, sulfonate ester bond, carbonate bond, lactone ring, sultone ring, carboxylic anhydride (-C(=O)-O-C(=O)-) or haloalkyl moiety.

A pair of R³¹ and R³² may bond together to form a ring with the sulfur atom to which they are attached. Also, R³³ and R³⁴, R³⁶ and R³⁷, or R³⁹ and R⁴⁰ may bond together to form a ring with the sulfur atom to which they are attached. Examples of the ring are as exemplified for the ring that R^{ct1} and R^{ct2} in formula (cation-1), taken together, form with the sulfur atom to which they are attached.

Examples of the sulfonium cation in repeat units B7 to B9 are as exemplified for the sulfonium cation having formula (cation-1). Examples of the iodonium cation in repeat units B 11 to B 13 are as exemplified for the iodonium cation having formula (cation-2).

The repeat units B6 to B 13 are capable of generating an acid upon receipt of high-energy radiation. With the relevant units bound into a polymer, an appropriate control of acid diffusion becomes possible, and a pattern with reduced LER can be formed. Since the acid-generating unit is bound to a polymer, the phenomenon that acid volatilizes from the exposed region and re-deposits on the unexposed region during bake in vacuum is suppressed. This is effective for reducing LER and for suppressing unwanted negative-working reaction in the unexposed region for thereby reducing defects.

Each of the repeat units B6 to B13 may be of one type or a combination of plural types.

In the polymer B or B', (meth)acrylate and other repeat units having an adhesive group such as lactone structure or hydroxy group other than phenolic hydroxy may be incorporated for fine adjustment of properties of a resist film.

Examples of the (meth)acrylate unit having an adhesive group include repeat units having the following formulae (B14) to (B16), which are also referred to as repeat units B14 to B 16. While these units do not exhibit acidity, they may be used as auxiliary units for providing adhesion to substrates or adjusting solubility.

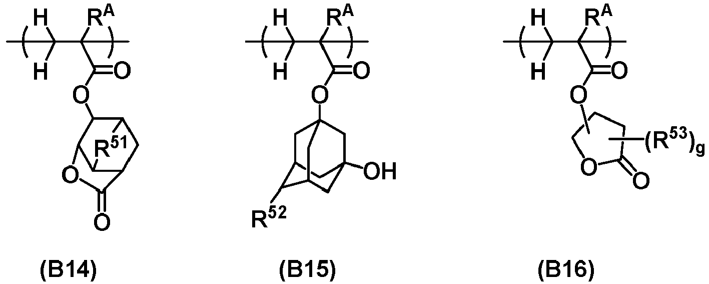

In formulae (B14) to (B16), R^{A} is each independently hydrogen, fluorine, methyl or trifluoromethyl. R⁵¹ is -O- or methylene. R⁵² is hydrogen or hydroxy. R⁵³ is a C₁-C₄ saturated hydrocarbyl group, and g is an integer of 0 to 3. Each of the repeat units B 14 to B 16 may be of one type or a combination of plural types.

In polymer B, an appropriate content of repeat units B1 is 30 to 95 mol%, more preferably 50 to 85 mol% for establishing a high contrast between a region which is exposed to high-energy radiation and turns negative and the unexposed region (which does not turn negative) for the purpose of achieving high resolution. An appropriate content of repeat units B2 is 5 to 70 mol%, more preferably 10 to 60 mol% for gaining the effect of promoting negative-working reaction. An appropriate content of repeat units B3 to B5 is 0 to 30 mol%, more preferably 3 to 20 mol% for gaining the effect of improving etch resistance. The other repeat units may be incorporated in a range of 0 to 30 mol%, preferably 0 to 20 mol%.

Where the polymer B' is free of repeat units B6 to B13, the polymer B' preferably contains 25 to 95 mol%, more preferably 40 to 85 mol% of repeat units B1. An appropriate content of repeat units B3 to B5 is 0 to 30 mol%, more preferably 3 to 20 mol%. An appropriate content of repeat units B2 is 5 to 70 mol%, more preferably 10 to 60 mol%. The other repeat units may be incorporated in a range of 0 to 30 mol%, preferably 0 to 20 mol%.

Where the polymer B' contains repeat units B6 to B13, the polymer B' preferably contains 25 to 94.5 mol%, more preferably 36 to 85 mol% of repeat units B1. An appropriate content of repeat units B3 to B5 is 0 to 30 mol%, more preferably 3 to 20 mol%. An appropriate content of repeat units B2 is 5 to 70 mol%, more preferably 10 to 60 mol%. The total content of repeat units B1 to B5 is preferably 60 to 99.5 mol%. An appropriate content of repeat units B6 to B13 is 0.5 to 20 mol%, more preferably 1 to 10 mol%. The other repeat units may be incorporated in a range of 0 to 30 mol%, preferably 0 to 20 mol%.

It is noted that the repeat units B1 to B5 preferably account for at least 60 mol%, more preferably at least 70 mol%, even more preferably at least 80 mol% of the overall repeat units of the polymer. This range ensures that the polymer has necessary properties as the chemically amplified negative resist composition.

Preferably, the polymer B' comprises repeat units having the formula (B1-1), repeat units having the formula (B2-1) or (B2-2), and repeat units having the formula (B7). 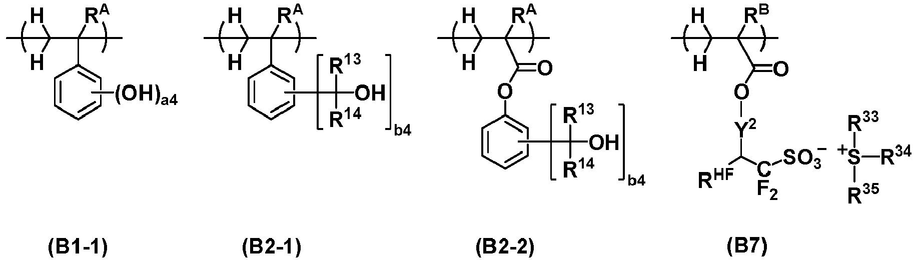 Herein R^{A}, R^{B}, Y², R¹³, R¹⁴, R³³, R³⁴, R³⁵, R^{HF}, a4, and b4 are as defined above.

Where the polymer B' is used as the base polymer (B), it may be a mixture of a polymer free of repeat units B6 to B 13 and a polymer comprising repeat units B6 to B13. In this embodiment, the polymer free of repeat units B6 to B13 is preferably used in an amount of 2 to 5,000 parts, more preferably 10 to 1,000 parts by weight per 100 parts by weight of the polymer comprising repeat units B6 to B13.

Reference is now made to the use of the chemically amplified negative resist composition in the fabrication of photomasks. The lithography of the advanced generation employs a coating film having a thickness of up to 150 nm, preferably up to 100 nm. Since an intense development process is often employed to minimize defects resulting from resist residues, the base polymer should preferably have a dissolution rate in alkaline developer (typically 2.38 wt% tetramethylammonium hydroxide (TMAH) aqueous solution) of up to 80 nm/sec, more preferably up to 50 nm/sec in order to form a small size pattern. When the chemically amplified negative resist composition is used in the EUV lithography process for fabricating an LSI chip from a wafer, for example, the coating film often has a thickness of up to 100 nm, in view of the necessity of patterning narrow lines of 50 nm or less. In consideration of the risk that the pattern of such thin film can be degraded by development, the polymer preferably has a dissolution rate of up to 80 nm/sec, more preferably up to 50 nm/sec.

The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to WO 2006/121096, JP-A 2004-115630, JP-A 2008-102383, and JP-A 2008-304590.

The polymer should preferably have a Mw of 1,000 to 50,000, and more preferably 2,000 to 20,000. A Mw of at least 1,000 eliminates the risk that pattern features are rounded at their top, inviting degradations of resolution and LER. A Mw of up to 50,000 eliminates the risk that LER is increased when a pattern with a line width of up to 100 nm is formed. As used herein, Mw is measured by GPC versus polystyrene standards using tetrahydrofuran (THF) or dimethylformamide (DMF).

The polymer preferably has a narrow molecular weight distribution or dispersity (Mw/Mn) of 1.0 to 2.0, more preferably 1.0 to 1.8. A polymer with such a narrow dispersity eliminates the risk that foreign particles are left on the pattern after development and the pattern profile is aggravated.

### (C) Crosslinker

When the base polymer (B) does not contain polymer B', the negative resist composition preferably comprises a crosslinker as component (C). When the base polymer (B) contains polymer B', a crosslinker need not be added.

Suitable crosslinkers which can be used herein include epoxy compounds, melamine compounds, guanamine compounds, glycoluril compounds and urea compounds having substituted thereon at least one group selected from among methylol, alkoxymethyl and acyloxymethyl groups, isocyanate compounds, azide compounds, and compounds having a double bond such as an alkenyloxy group. These compounds may be used as an additive or introduced into a polymer side chain as a pendant. Hydroxy-containing compounds may also be used as the crosslinker.

Of the foregoing crosslinkers, examples of suitable epoxy compounds include tris(2,3-epoxypropyl) isocyanurate, trimethylolmethane triglycidyl ether, trimethylolpropane triglycidyl ether, and triethylolethane triglycidyl ether.

Examples of the melamine compound include hexamethylol melamine, hexamethoxymethyl melamine, hexamethylol melamine compounds having 1 to 6 methylol groups methoxymethylated and mixtures thereof, hexamethoxyethyl melamine, hexaacyloxymethyl melamine, hexamethylol melamine compounds having 1 to 6 methylol groups acyloxymethylated and mixtures thereof.

Examples of the guanamine compound include tetramethylol guanamine, tetramethoxymethyl guanamine, tetramethylol guanamine compounds having 1 to 4 methylol groups methoxymethylated and mixtures thereof, tetramethoxyethyl guanamine, tetraacyloxyguanamine, tetramethylol guanamine compounds having 1 to 4 methylol groups acyloxymethylated and mixtures thereof.

Examples of the glycoluril compound include tetramethylol glycoluril, tetramethoxyglycoluril, tetramethoxymethyl glycoluril, tetramethylol glycoluril compounds having 1 to 4 methylol groups methoxymethylated and mixtures thereof, tetramethylol glycoluril compounds having 1 to 4 methylol groups acyloxymethylated and mixtures thereof.

Examples of the urea compound include tetramethylol urea, tetramethoxymethyl urea, tetramethylol urea compounds having 1 to 4 methylol groups methoxymethylated and mixtures thereof, and tetramethoxyethyl urea.

Suitable isocyanate compounds include tolylene diisocyanate, diphenylmethane diisocyanate, hexamethylene diisocyanate and cyclohexane diisocyanate.

Suitable azide compounds include 1,1'-biphenyl-4,4'-bisazide, 4,4'-methylidenebisazide, and 4,4'-oxybisazide.

Examples of the alkenyloxy-containing compound include ethylene glycol divinyl ether, triethylene glycol divinyl ether, 1,2-propanediol divinyl ether, 1,4-butanediol divinyl ether, tetramethylene glycol divinyl ether, neopentyl glycol divinyl ether, trimethylol propane trivinyl ether, hexanediol divinyl ether, 1,4-cyclohexanediol divinyl ether, pentaerythritol trivinyl ether, pentaerythritol tetravinyl ether, sorbitol tetravinyl ether, sorbitol pentavinyl ether, and trimethylol propane trivinyl ether.

An appropriate amount of the crosslinker (C) used is 0.1 to 50 parts, and more preferably 1 to 30 parts by weight per 80 parts by weight of the base polymer (B). As long as the amount of the crosslinker is in the range, the risk of resolution being reduced by forming bridges between pattern features is mitigated. The crosslinkers may be used alone or in admixture.

### (D) Fluorinated polymer

The negative resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (D1), repeat units having the formula (D2), repeat units having the formula (D3), and repeat units having the formula (D4), and may contain repeat units of at least one type selected from repeat units having the formula (D5) and repeat units having the formula (D6). It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

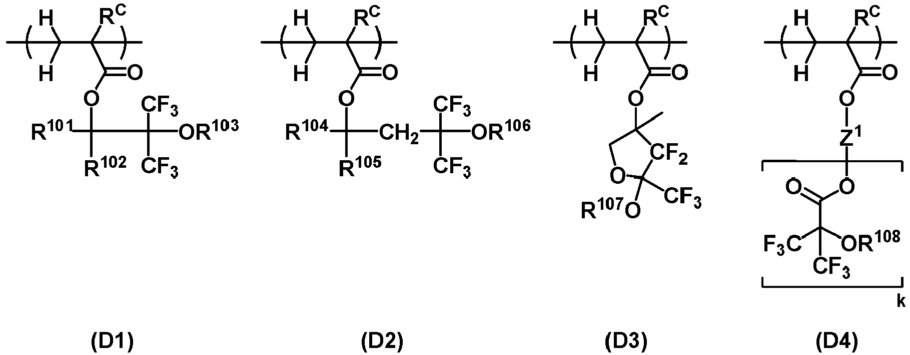

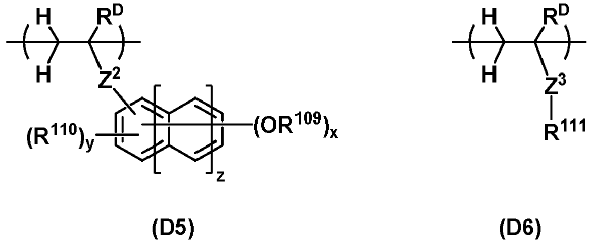

In formulae (D1) to (D6), x is an integer of 1 to 3, y is an integer satisfying: 0 ≤ y ≤ 5+2z-x, z is 0 or 1, and k is an integer of 1 to 3. R^{C} is each independently hydrogen, fluorine, methyl or trifluoromethyl. R^{D} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. Z¹ is a C₁-C₂₀ (k+1)-valent hydrocarbon group or C₁-C₂₀ (k+1)-valent fluorinated hydrocarbon group. Z² is a single bond, *-C(=O)-O- or *-C(=O)-NH- wherein * designates a point of attachment to the carbon atom in the backbone. Z³ is a single bond, -O-, *-C(=O)-O-Z³¹-Z³²- or *-C(=O)-NH-Z³¹-Z³²-, wherein Z³¹ is a single bond or a C₁-C₁₀ saturated hydrocarbylene group, Z³² is a single bond, ester bond, ether bond or sulfonamide bond, and * designates a point of attachment to the carbon atom in the backbone.

In formulae (D1) and (D2), examples of the C₁-C₁₀ saturated hydrocarbyl group represented by R¹⁰¹, R¹⁰², R¹⁰⁴ and R¹⁰⁵ include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), the C₁-C₁₅ hydrocarbyl group represented by R¹⁰³, R¹⁰⁶, R¹⁰⁷ and R¹⁰⁸ may be straight, branched or cyclic and examples thereof include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (k+1)-valent hydrocarbon group Z¹ include the foregoing C₁-C₂₀ alkyl groups and C₃-C₂₀ cyclic saturated hydrocarbyl groups, with k number of hydrogen atoms being eliminated. Examples of the C₁-C₂₀ (k+1)-valent fluorinated hydrocarbon group Z¹ include the foregoing (k+1)-valent hydrocarbon groups in which at least one hydrogen atom is substituted by fluorine.

Examples of the repeat units D 1 to D4 are given below, but not limited thereto. Herein R^{C} is as defined above.

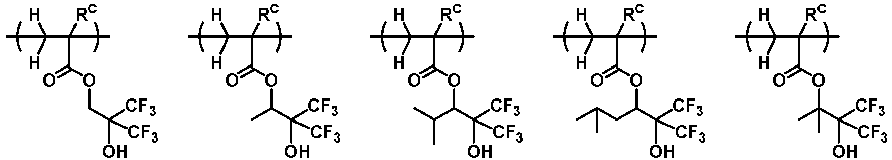

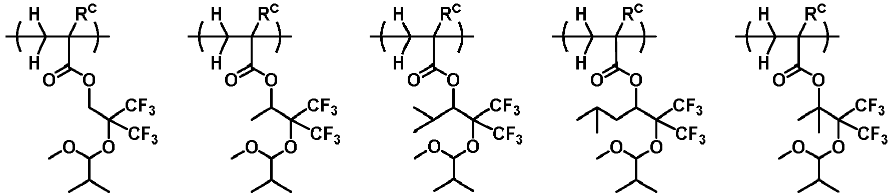

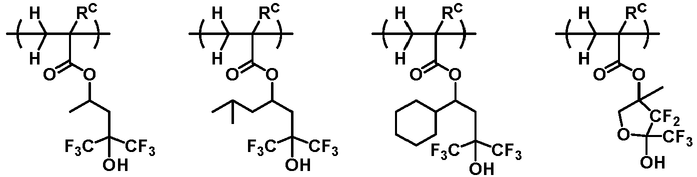

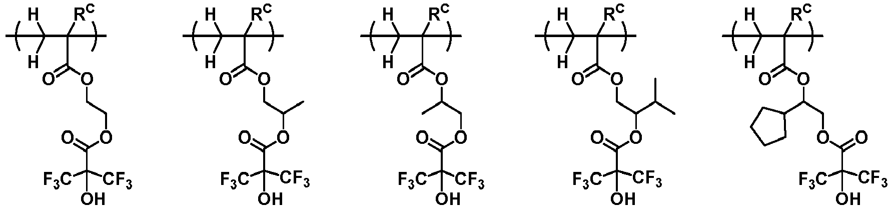

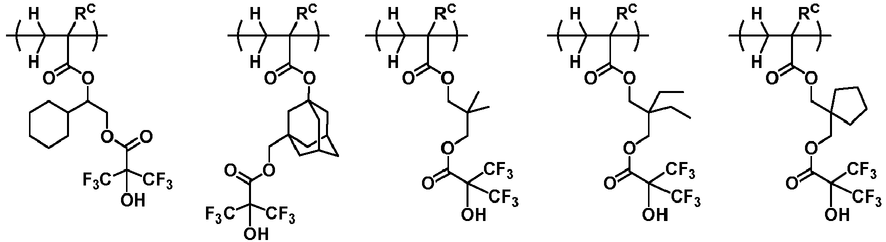

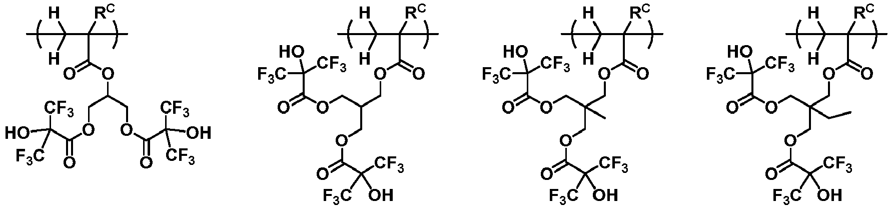

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (D5), Z² is preferably *-C(=O)-O- or *-C(=O)-NH-. Also preferably R^{D} is methyl. The inclusion of carbonyl in Z² enhances the ability to trap the acid originating from the anti-charging film. A polymer wherein R^{D} is methyl is a robust polymer having a high glass transition temperature which is effective for suppressing acid diffusion. As a result, the resist film is improved in stability with time, and neither resolution nor pattern profile is degraded.

Examples of the repeat unit D5 are given below, but not limited thereto. Herein R^{D} is as defined above.

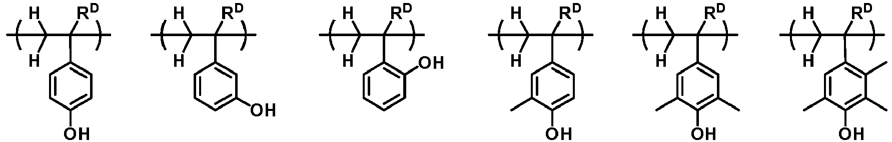

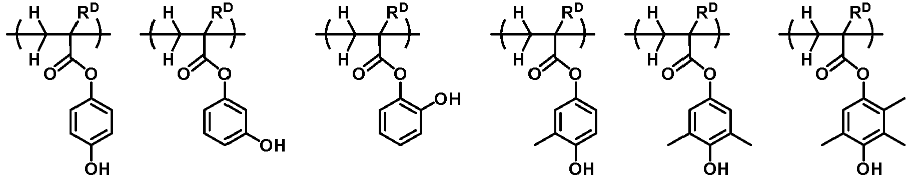

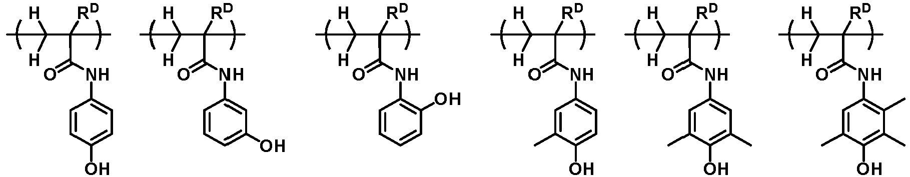

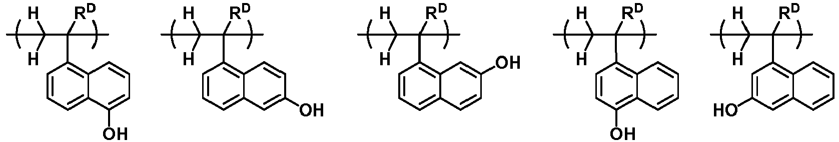

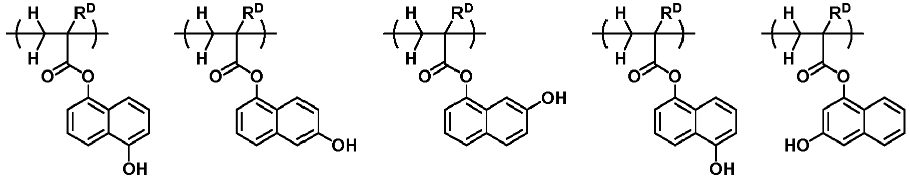

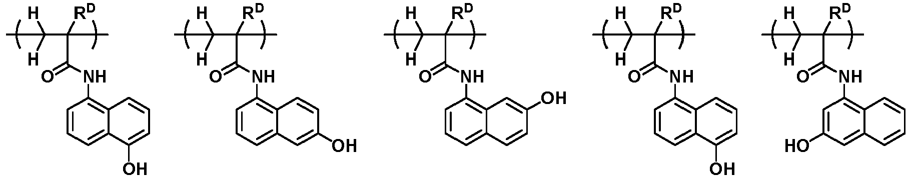

In formula (D6), the C₁-C₁₀ saturated hydrocarbylene group Z³ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{D} is as defined above.

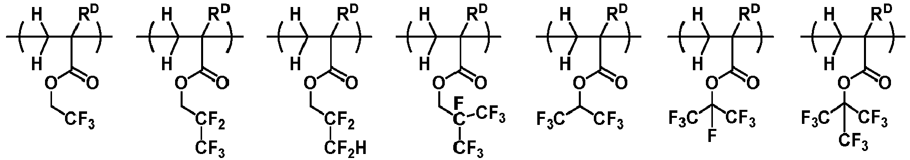

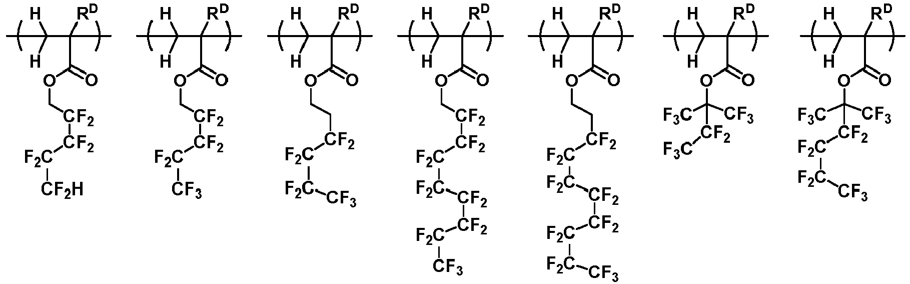

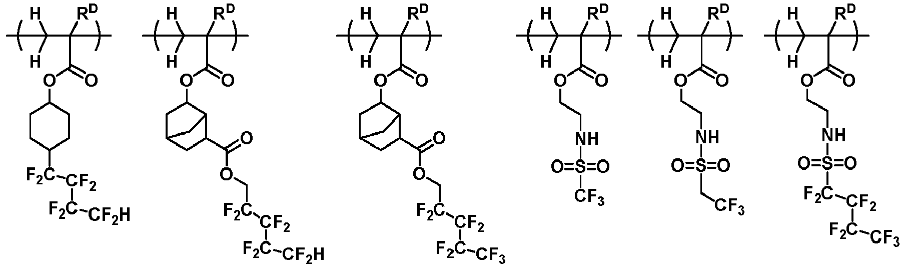

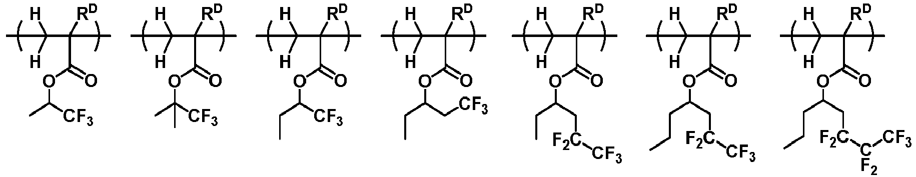

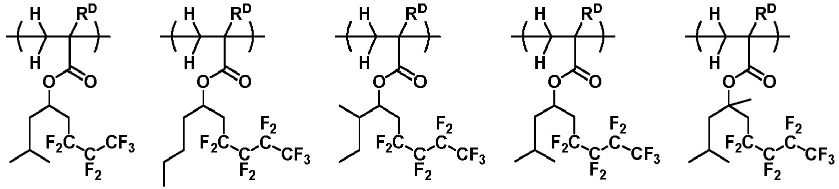

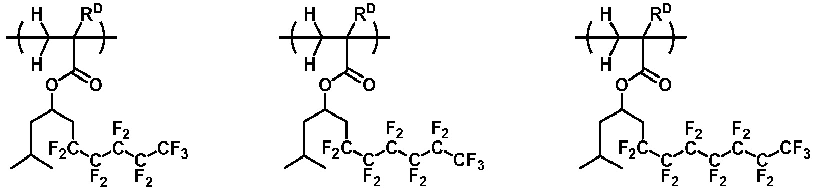

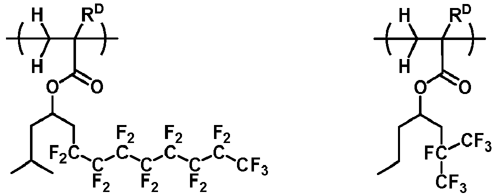

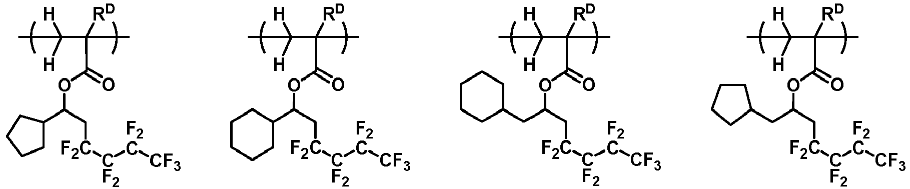

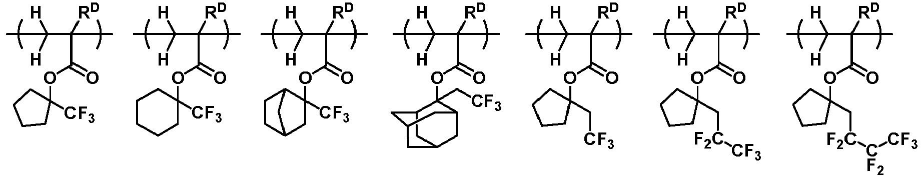

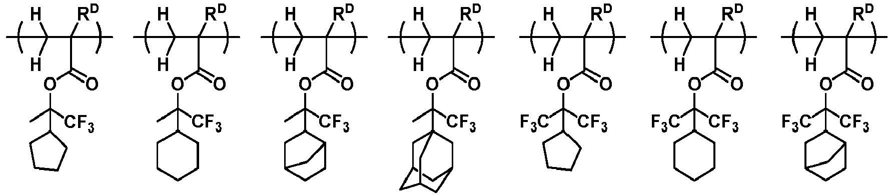

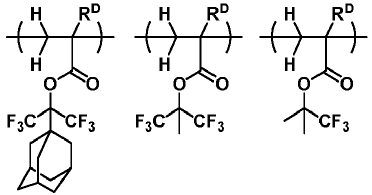

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the negative resist composition, the fluorinated polymer (D) is preferably used in an amount of 0.01 to 30 parts, more preferably 0.1 to 20 parts, even more preferably 0.5 to 10 parts by weight per 80 parts by weight of the base polymer (B). The fluorinated polymer may be used alone or in admixture.

### (E) Quencher

The negative resist composition preferably contains a quencher as component (E). As used herein, the quencher refers to a compound capable of trapping the acid generated by the PAG in the resist composition to prevent the acid from diffusing to the unexposed region for thereby forming the desired pattern.

The quencher is typically selected from conventional basic compounds. Conventional basic compounds include primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, and carbamate derivatives. Also included are primary, secondary, and tertiary amine compounds, specifically amine compounds having a hydroxy group, ether bond, ester bond, lactone ring, cyano group, or sulfonate ester bond as described in JP-A 2008-111103, paragraphs [0146]-[0164], and compounds having a carbamate group as described in JP 3790649. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound is effective for further suppressing the diffusion rate of acid in the resist film or correcting the pattern profile.

Onium salts such as sulfonium, iodonium and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. An α-non-fluorinated carboxylic acid functions as a quencher because it does not induce substantial deprotection reaction.

Examples of the onium salt of α-non-fluorinated carboxylic acid include compounds having the formula (E1).

R²⁰¹-CO₂⁻Mq_{A}⁺ (E1)

In formula (E1), R²⁰¹ is hydrogen or a C₁-C₄₀ hydrocarbyl group which may contain a heteroatom, exclusive of the hydrocarbyl group in which the hydrogen bonded to the carbon atom at α-position of the carboxy group is substituted by fluorine or fluoroalkyl.

The hydrocarbyl group R²⁰¹ may be saturated or unsaturated and straight, branched or cyclic. Examples thereof include C₁-C₄₀ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), dialkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In the foregoing hydrocarbyl groups, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, carbonyl moiety, ether bond, thioether bond, ester bond, sulfonate ester bond, carbonate bond, lactone ring, sultone ring, carboxylic anhydride (-C(=O)-O-C(=O)-) or haloalkyl moiety. Suitable heteroatom-containing hydrocarbyl groups include heteroaryl groups such as thienyl; alkoxyphenyl groups such as 4-hydroxyphenyl, 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (E1), Mq_{A}⁺ is an onium cation. The onium cation is preferably selected from sulfonium, iodonium and ammonium cations, more preferably sulfonium and iodonium cations. Exemplary sulfonium cations are as exemplified above for the sulfonium cation having formula (cation-1). Exemplary iodonium cations are as exemplified above for the iodonium cation having formula (cation-2).

Examples of the anion in the onium salt having formula (E1) are shown below, but not limited thereto.

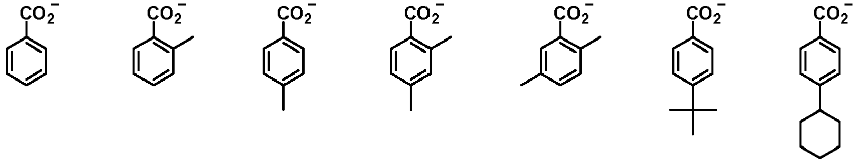

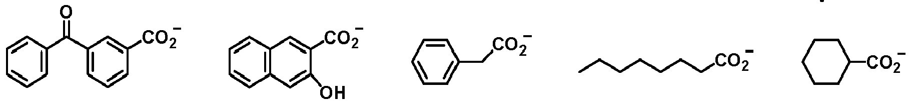

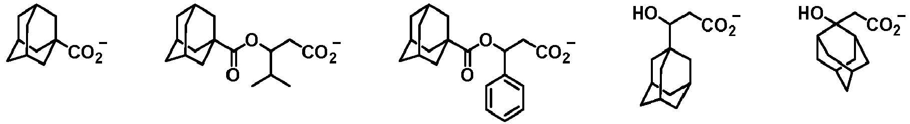

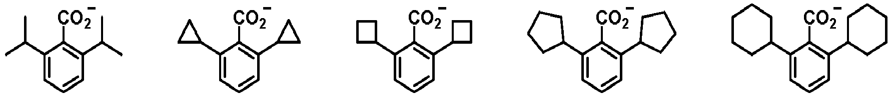

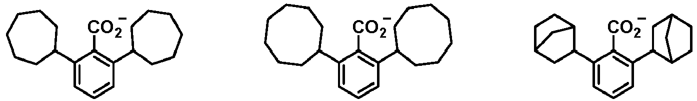

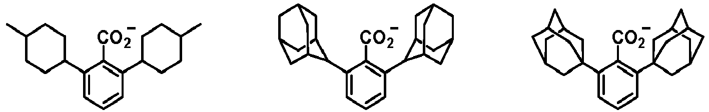

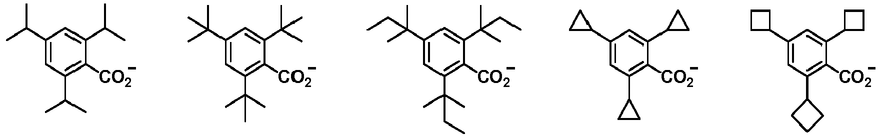

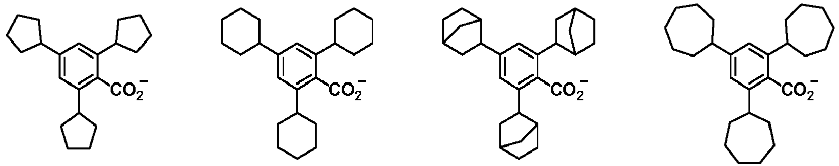

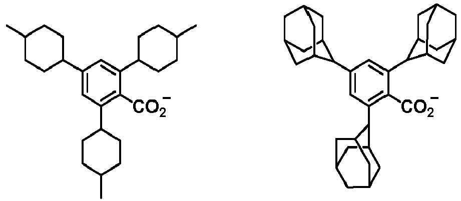

A sulfonium salt of iodized benzene ring-containing carboxylic acid having the formula (E2) is also useful as the quencher.

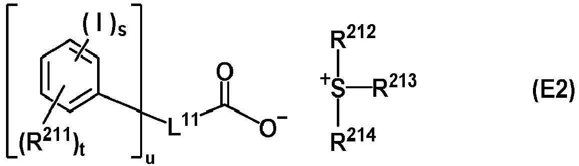

In formula (E2), s is an integer of 1 to 5, t is an integer of 0 to 3, s+u is from 1 to 5, and u is an integer of 1 to 3.

In formula (E2), R²¹¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy or C₁-C₄ saturated hydrocarbylsulfonyloxy group, in which some or all hydrogen may be substituted by halogen, or -N(R^{211A})-C(=O)-R^{211B}, or -N(R²¹¹A)-C(=O)-O-R^{211B}. R^{211A} is hydrogen or a C₁-C₆ saturated hydrocarbyl group. R^{211B} is a C₁-C₆ saturated hydrocarbyl or C₂-C₈ unsaturated aliphatic hydrocarbyl group. When t and/or u is 2 or 3, a plurality of R²¹¹ may be the same or different.

In formula (E2), L¹¹ is a single bond, or a C₁-C₂₀ (u+1)-valent linking group which may contain at least one moiety selected from ether bond, carbonyl moiety, ester bond, amide bond, sultone ring, lactam ring, carbonate bond, halogen, hydroxy moiety, and carboxy moiety. The saturated hydrocarbyl, saturated hydrocarbyloxy, saturated hydrocarbylcarbonyloxy, and saturated hydrocarbylsulfonyloxy groups may be straight, branched or cyclic.

In formula (E2), R²¹², R²¹³ and R²¹⁴ are each independently halogen, or a C₁-C₂₀ hydrocarbyl group which may contain a heteroatom. The hydrocarbyl group may be saturated or unsaturated and straight, branched or cyclic. Examples thereof include C₁-C₂₀ alkyl, C₂-C₂₀ alkenyl, C₆-C₂₀ aryl, and C₇-C₂₀ aralkyl groups. In these groups, some or all hydrogen may be substituted by hydroxy moiety, carboxy moiety, halogen, oxo moiety, cyano moiety, nitro moiety, sultone ring, sulfo moiety, or sulfonium salt-containing moiety, or some constituent -CH₂- may be replaced by an ether bond, ester bond, carbonyl moiety, amide bond, carbonate bond or sulfonate ester bond. Also R²¹² and R²¹³ may bond together to form a ring with the sulfur atom to which they are attached.

Examples of the compound having formula (E2) include those described in USP 10,295,904 (JP-A 2017-219836). These compounds exert a sensitizing effect due to remarkable absorption and an acid diffusion-controlling effect.

A nitrogen-containing carboxylic acid salt compound having the formula (E3) is also useful as the quencher.

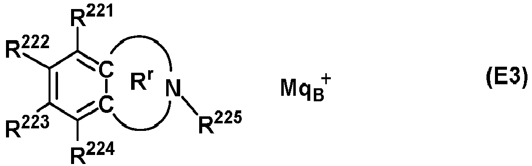

In formula (E3), R²²¹ to R²²⁴ are each independently hydrogen, -L¹²-CO₂⁻, or a C₁-C₂₀ hydrocarbyl group which may contain a heteroatom. R²²¹ and R²²², R²²² and R²²³, or R²²³ and R²²⁴ may bond together to form a ring with the carbon atom to which they are attached. L¹² is a single bond or a C₁-C₂₀ hydrocarbylene group which may contain a heteroatom. R²²⁵ is hydrogen or a C₁-C₂₀ hydrocarbyl group which may contain a heteroatom.

In formula (E3), the ring R^{r} is a C₂-C₆ ring containing the carbon and nitrogen atoms in the formula, in which some or all of the carbon-bonded hydrogen atoms may be substituted by a C₁-C₂₀ hydrocarbyl group or -L¹²-CO₂⁻ and in which some -CH₂- may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (E3) has at least one -L¹²-CO₂⁻. That is, at least one of R²²¹ to R²²⁴ is -L¹²-CO₂⁻, and/or at least one of hydrogen atoms bonded to carbon atoms in the ring R^{r} is substituted by -L¹²-CO₂⁻.

In formula (E3), Mq_{B}⁺ is a sulfonium, iodonium or ammonium cation, with the sulfonium cation being preferred. Examples of the sulfonium cation are as exemplified above for the sulfonium cation having formula (cation-1).

Examples of the anion in the compound having formula (E3) are shown below, but not limited thereto.

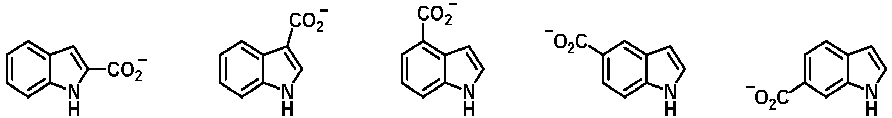

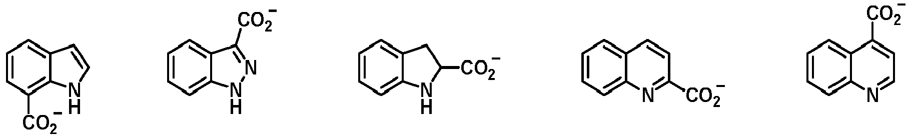

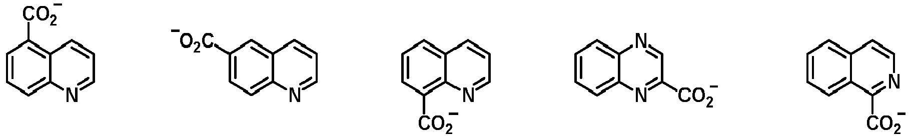

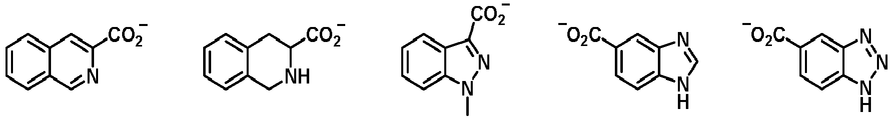

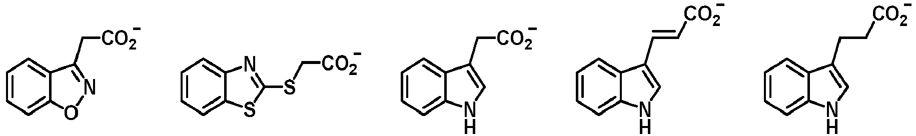

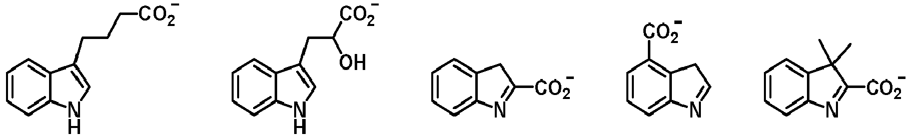

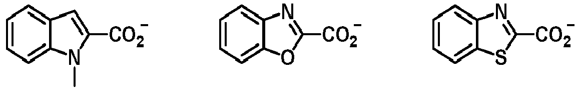

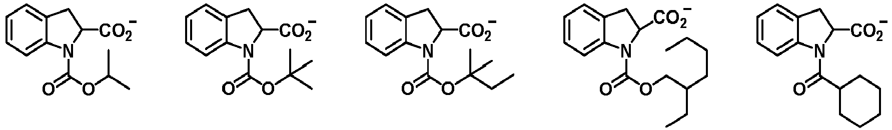

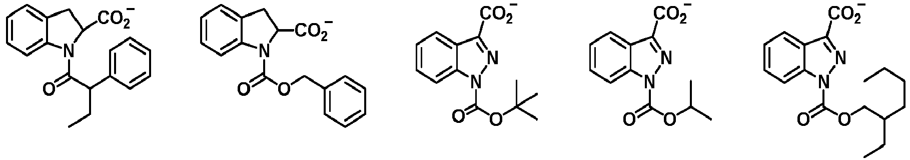

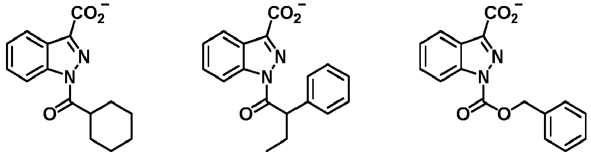

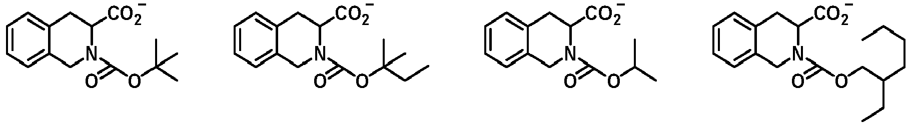

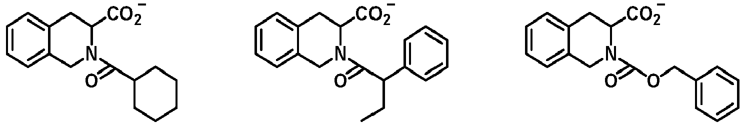

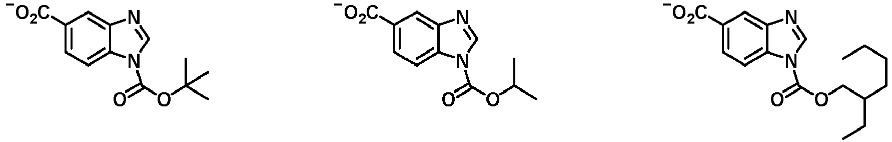

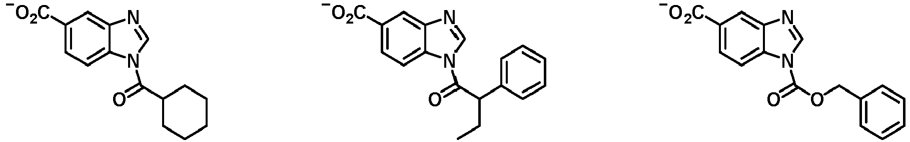

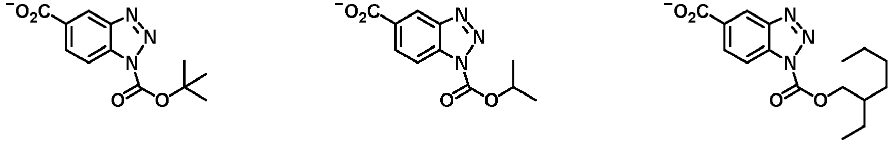

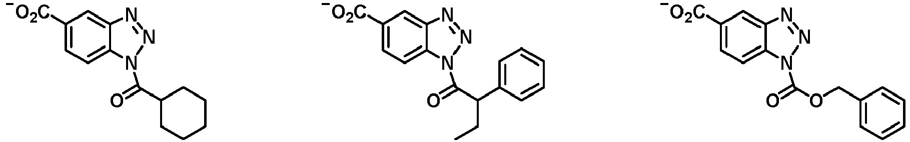

Weak acid betaine compounds are also useful as the quencher. Non-limiting examples thereof are shown below.

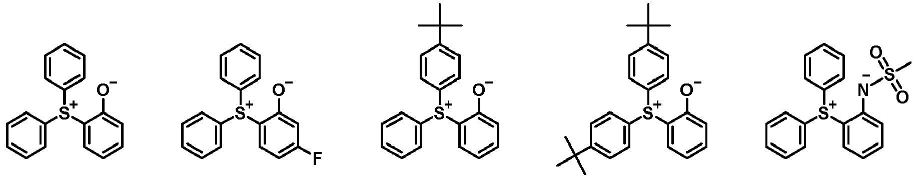

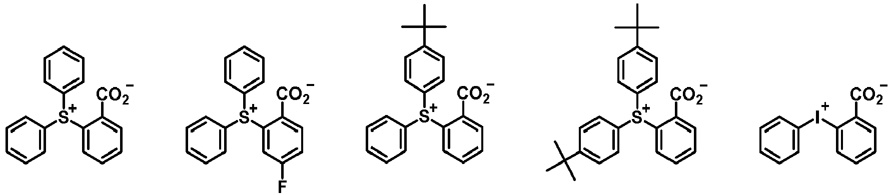

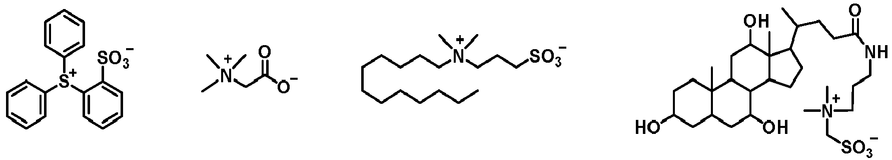

Also useful are quenchers of polymer type as described in USP 7,598,016 (JP-A 2008-239918). The polymeric quencher segregates at the resist surface after coating and thus enhances the rectangularity of resist pattern. When a protective film is applied as is often the case in the immersion lithography, the polymeric quencher is also effective for preventing a film thickness loss of resist pattern or rounding of pattern top.

When used, the quencher (E) is preferably added in an amount of 0 to 50 parts, more preferably 0.1 to 40 parts by weight per 80 parts by weight of the base polymer (B). The quencher may be used alone or in admixture.

In the embodiment wherein the chemically amplified negative resist composition contains the acid generator (A) and the quencher (E), the acid generator (A) and the quencher (E) are preferably present in a weight ratio (A/E) of less than 6/1, more preferably less than 5/1, even more preferably less than 4/1. As long as the ratio of acid generator (A) to quencher (E) is in the range, it is possible to fully suppress acid diffusion, leading to improved resolution and dimensional uniformity.

### (F) Organic solvent

The chemically amplified negative resist composition may further comprise an organic solvent as component (F). The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof.

Of the above organic solvents, it is recommended to use 1-ethoxy-2-propanol, PGMEA, PGME, cyclohexanone, EL, GBL, and mixtures thereof.

In the negative resist composition, the organic solvent (F) is preferably used in an amount of 200 to 10,000 parts, more preferably 400 to 6,000 parts by weight per 80 parts by weight of the base polymer (B). The organic solvent may be used alone or in admixture.

### (G) Surfactant

The negative resist composition may contain any conventional surfactants for facilitating to coat the composition to the substrate. Exemplary surfactants include PF-636 (Omnova Solutions Inc.) and FC-4430 (3M) as well as a number of known surfactants as described in JP-A 2004-115630. Any suitable one may be chosen therefrom. The amount of the surfactant (G) added is preferably 0 to 5 parts by weight per 80 parts by weight of the base polymer (B). The surfactant may be used alone or in admixture.

### Process

Another embodiment of the invention is a resist pattern forming process comprising the steps of applying the negative resist composition defined above onto a substrate to form a resist film thereon, exposing the resist film patternwise to high-energy radiation, and developing the resist film in an alkaline developer to form a resist pattern.

Pattern formation using the negative resist composition of the invention may be performed by well-known lithography processes. In general, the resist composition is first applied onto a substrate for IC fabrication (e.g., Si, SiO, SiO₂, SiN, SiON, TiN, WSi, BPSG, SOG, organic antireflective coating, etc.) or a substrate for mask circuit fabrication (e.g., Cr, CrO, CrON, MoSi₂, Si, SiO, SiO₂, SiON, SiONC, CoTa, NiTa, TaBN, SnO₂, etc.) by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed patternwise to high-energy radiation such as UV, deep-UV, excimer laser (KrF, ArF), EUV, x-ray, γ-ray or synchrotron radiation or EB. The resist composition of the invention is especially effective in the EUV or EB lithography.

On use of UV, deep-UV, EUV, excimer laser, x-ray, γ-ray or synchrotron radiation as the high-energy radiation, the resist film is exposed through a mask having a desired pattern, preferably in a dose of 1 to 500 mJ/cm², more preferably 10 to 400 mJ/cm². On use of EB, a pattern may be written directly in a dose of preferably 1 to 500 µC/cm², more preferably 10 to 400 µC/cm².

The exposure may be performed by conventional lithography whereas the immersion lithography of holding a liquid, typically water between the mask and the resist film may be employed if desired. In the case of immersion lithography, a protective film which is insoluble in water may be used.

The resist film is then baked (PEB) on a hotplate preferably at 60 to 150°C for 1 to 20 minutes, more preferably at 80 to 140°C for 1 to 10 minutes.

Thereafter, the resist film is developed with a developer in the form of an aqueous base solution, for example, 0.1 to 5 wt%, preferably 2 to 3 wt% aqueous solution of tetramethylammonium hydroxide (TMAH) preferably for 0.1 to 3 minutes, more preferably 0.5 to 2 minutes by conventional techniques such as dip, puddle and spray techniques. In this way, a desired resist pattern is formed on the substrate.

From the negative resist composition, a pattern with a high resolution and minimal LER can be formed. The resist composition is effectively applicable to a substrate, specifically a substrate having a surface layer of material to which a resist film is less adherent and which is likely to invite pattern stripping or pattern collapse, and particularly a substrate having sputter deposited on its outermost surface metallic chromium or a chromium compound containing at least one light element selected from oxygen, nitrogen and carbon or a substrate having an outermost surface layer of SiO, SiOₓ, or a tantalum, molybdenum, cobalt, nickel, tungsten or tin compound. The substrate to which the negative resist composition is applied is most typically a photomask blank which may be either of transmission or reflection type.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

The resist pattern forming process is successful in forming patterns having a very high resolution, reduced LER, rectangularity, and fidelity even on a substrate (typically mask blank of transmission or reflection type) whose outermost surface is made of a material tending to affect resist pattern profile such as a chromium, silicon or tantalum-containing material.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards using THF or DMF as developing solvent.

Polymers P-1 to P-30 used in resist compositions have the structure shown in Table 1.

**Table 1**

| | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-1 | A-1 | 80.0 | B-1 | 10.0 | B-5 | 10.0 | - | - | - | - | 4,500 | 1.65 |
| P-2 | A-1 | 80.0 | B-2 | 8.0 | B-4 | 12.0 | - | - | - | - | 4,400 | 1.64 |
| P-3 | A-1 | 60.0 | B-2 | 10.0 | C-1 | 30.0 | - | - | - | - | 3,700 | 1.62 |
| P-4 | A-1 | 70.0 | B-2 | 7.0 | C-2 | 23.0 | - | - | - | - | 3,600 | 1.63 |
| P-5 | A-1 | 70.0 | B-2 | 10.0 | C-3 | 20.0 | - | - | - | - | 3,900 | 1.65 |
| P-6 | A-1 | 30.0 | B-2 | 10.0 | C-4 | 60.0 | - | - | - | - | 3,900 | 1.62 |
| P-7 | A-1 | 45.0 | B-2 | 10.0 | C-5 | 45.0 | - | - | - | - | 4,100 | 1.63 |
| P-8 | A-1 | 55.0 | B-4 | 10.0 | C-1 | 35.0 | - | - | - | - | 4,000 | 1.63 |
| P-9 | A-1 | 66.0 | B-2 | 9.0 | C-1 | 21.5 | E-1 | 3.5 | - | - | 13,000 | 1.62 |
| P-10 | A-1 | 60.0 | B-2 | 4.0 | C-1 | 24.0 | E-1 | 12.0 | - | - | 15,000 | 1.65 |
| P-11 | A-1 | 67.0 | B-2 | 10.0 | C-1 | 18.5 | E-2 | 4.5 | - | - | 14,000 | 1.63 |
| P-12 | A-1 | 67.0 | B-2 | 9.3 | C-1 | 20.0 | E-3 | 3.7 | - | - | 13,500 | 1.63 |
| P-13 | A-1 | 67.3 | B-2 | 10.0 | C-1 | 17.5 | E-4 | 5.2 | - | - | 13,200 | 1.64 |
| P-14 | A-1 | 64.1 | B-2 | 9.5 | C-1 | 22.0 | E-5 | 4.4 | - | - | 12,800 | 1.62 |
| P-15 | A-1 | 64.0 | B-2 | 10.0 | C-1 | 22.8 | E-6 | 3.2 | - | - | 13,500 | 1.63 |
| P-16 | A-1 | 62.0 | B-3 | 10.0 | C-1 | 24.3 | E-1 | 3.7 | - | - | 12,400 | 1.66 |
| P-17 | A-2 | 60.5 | B-4 | 10.0 | C-1 | 24.4 | E-2 | 5.1 | - | - | 12,300 | 1.65 |
| P-18 | A-1 | 70.0 | C-1 | 30.0 | - | - | - | - | - | - | 4,200 | 1.69 |
| P-19 | A-1 | 80.0 | B-2 | 5.0 | C-1 | 15.0 | - | - | - | - | 4,300 | 1.67 |
| P-20 | A-1 | 80.0 | B-2 | 2.5 | C-1 | 15.0 | E-1 | 2.5 | - | - | 12,100 | 1.69 |
| P-21 | A-2 | 50.0 | C-1 | 30.0 | D-1 | 20.0 | - | - | - | - | 4,600 | 1.67 |
| P-22 | A-2 | 50.0 | B-2 | 2.5 | C-1 | 30.0 | D-1 | 15.0 | E-1 | 2.5 | 12,700 | 1.73 |
| P-23 | A-2 | 50.0 | C-1 | 30.0 | D-2 | 20.0 | - | - | - | - | 5,400 | 1.72 |
| P-24 | A-2 | 50.0 | C-1 | 30.0 | D-3 | 20.0 | - | - | - | - | 6,100 | 1.73 |
| P-25 | A-2 | 50.0 | C-1 | 30.0 | D-4 | 20.0 | - | - | - | - | 7,000 | 1.76 |
| P-26 | A-1 | 67.5 | B-2 | 2.5 | C-1 | 30.0 | - | - | - | - | 4,100 | 1.65 |
| P-27 | A-1 | 57.5 | B-2 | 2.5 | C-1 | 30.0 | E-5 | 10 | - | - | 11,000 | 1.65 |
| P-28 | A-1 | 65.0 | C-1 | 25.0 | E-7 | 10.0 | - | - | - | - | 13,000 | 1.80 |
| P-29 | A-1 | 65.0 | C-1 | 25.0 | E-8 | 10.0 | - | - | - | - | 12,500 | 1.80 |
| P-30 | A-3 | 76.0 | B-2 | 6.0 | C-1 | 18.0 | - | - | - | - | 4,500 | 1.68 |

The structure of each unit in Table 1 is shown below.

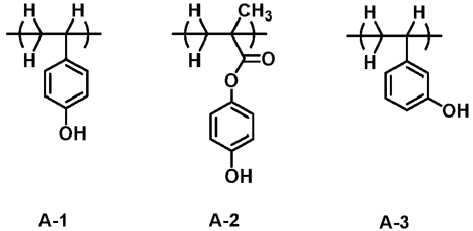

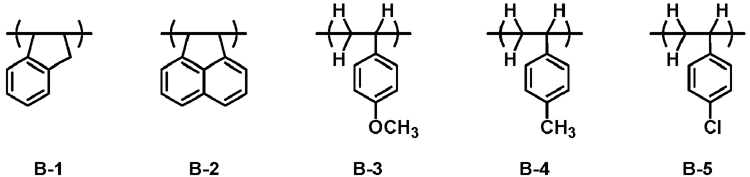

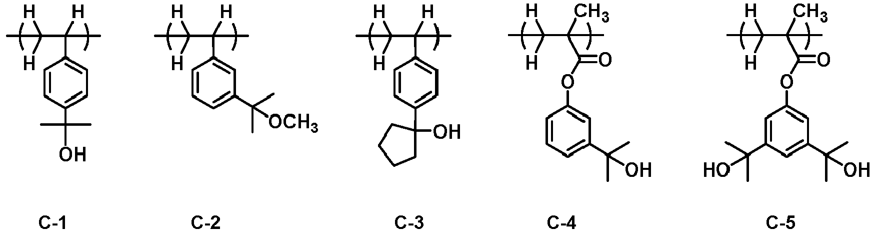

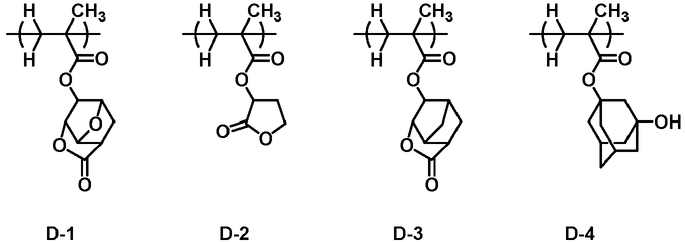

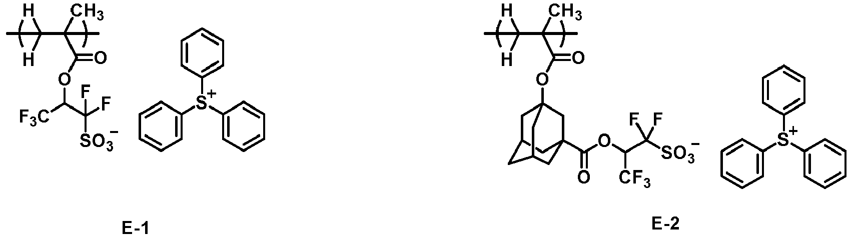

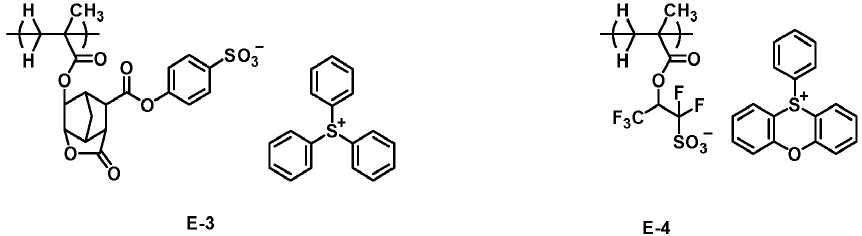

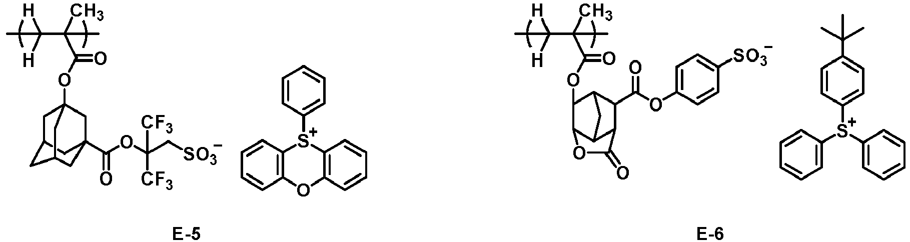

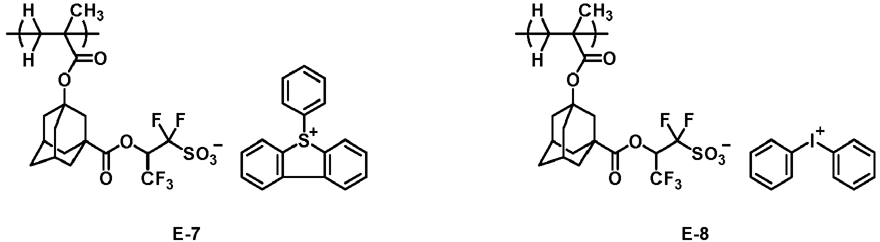

### [1] Preparation of chemically amplified negative resist compositions

### Examples 1-1 to 1-54 and Comparative Examples 1-1 to 1-10

Chemically amplified negative resist compositions (R-1 to R-54, CR-1 to CR-10) were prepared by dissolving selected components in an organic solvent in accordance with the formulation shown in Tables 2 to 4, and filtering the solution through a UPE filter or nylon filter with a pore size of 10 nm, 5 nm, 3 nm or 1 nm. The organic solvent was a mixture of 790 pbw of PGMEA, 1,580 pbw of EL, and 1,580 pbw of PGME. To some compositions, fluorinated polymer (Polymers FP-1 to FP-5) as additive, tetramethoxymethylglycoluril (TMGU) as crosslinker, and PF-636 (Omnova Solutions Inc.) as surfactant were added.

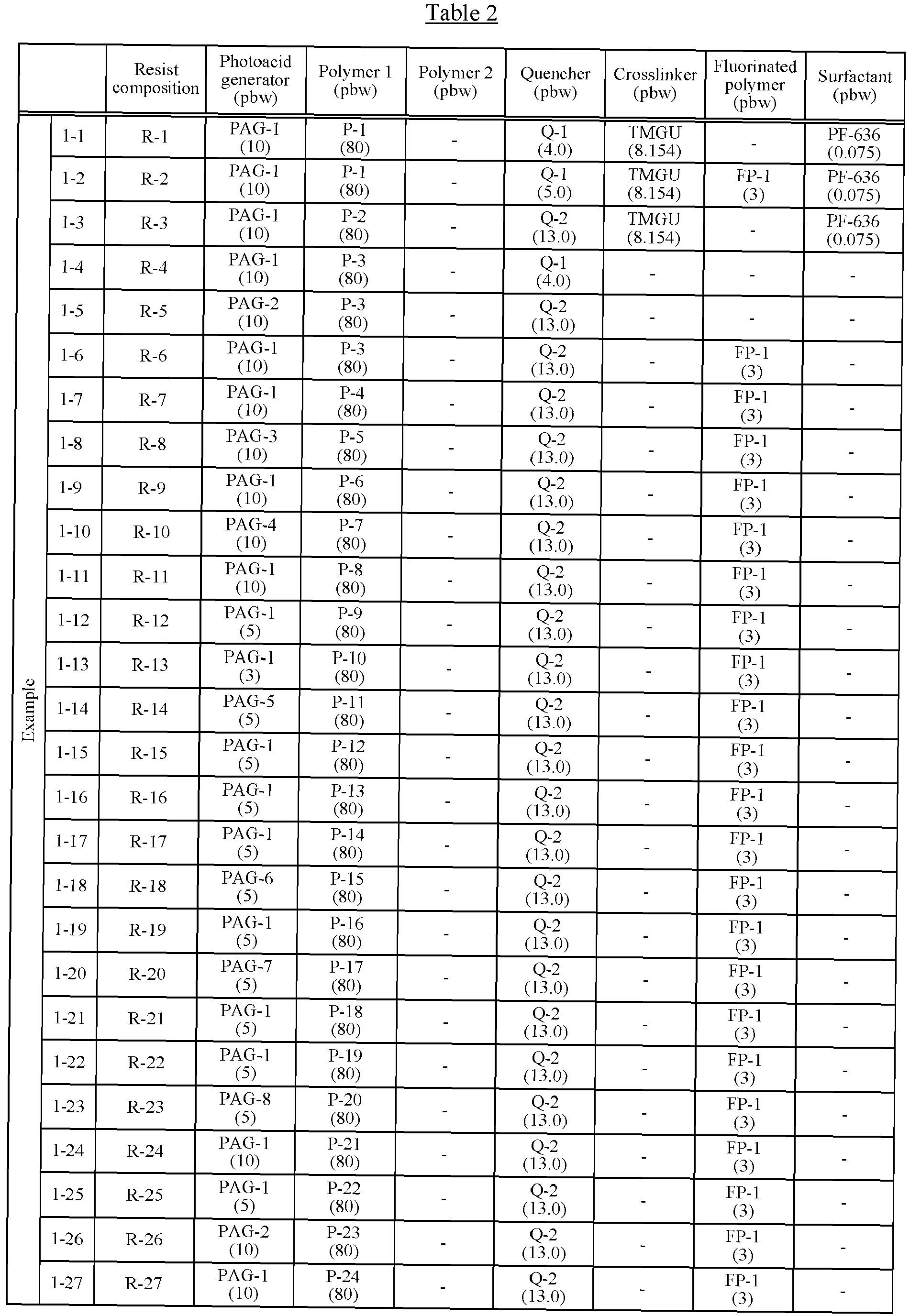

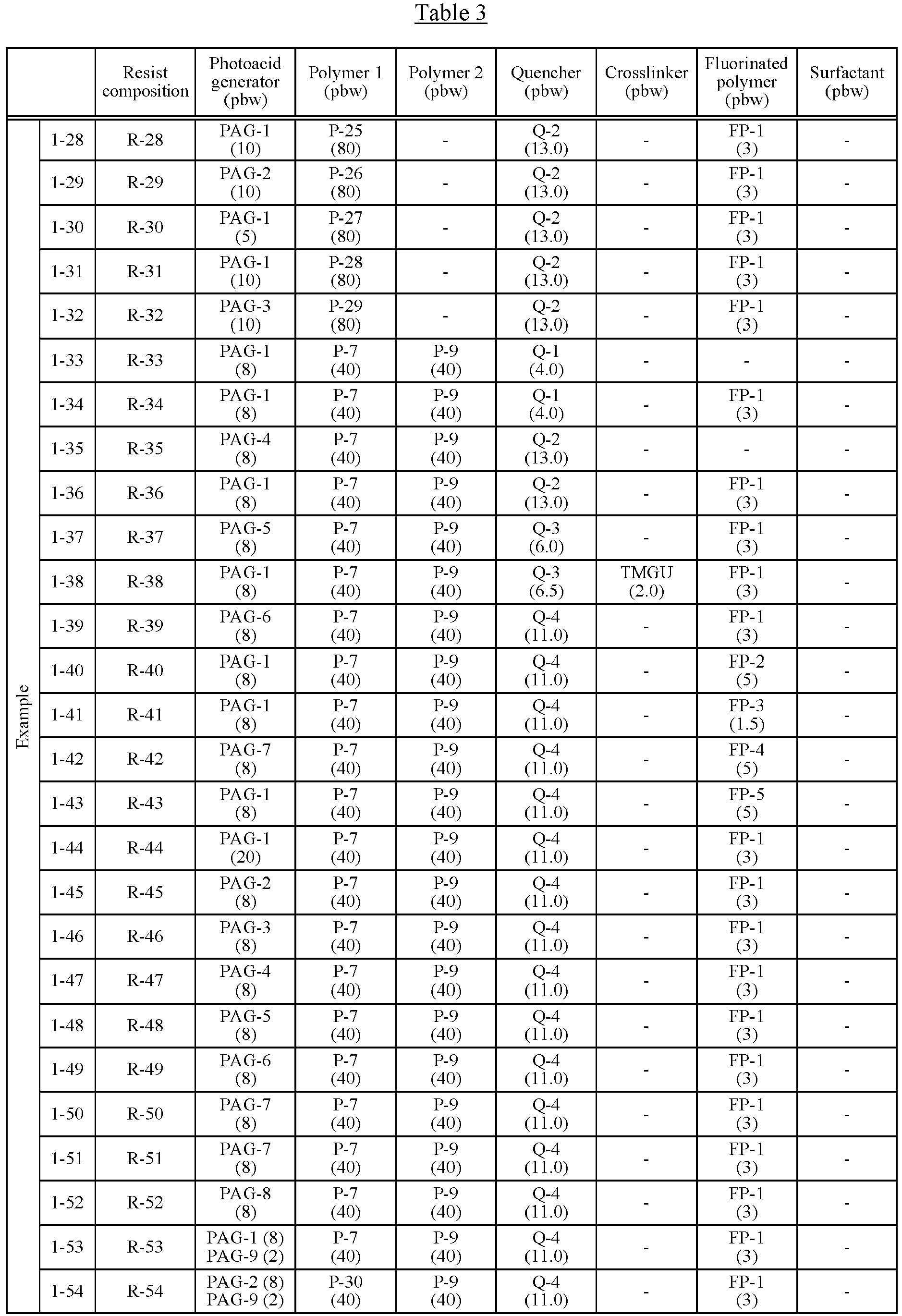

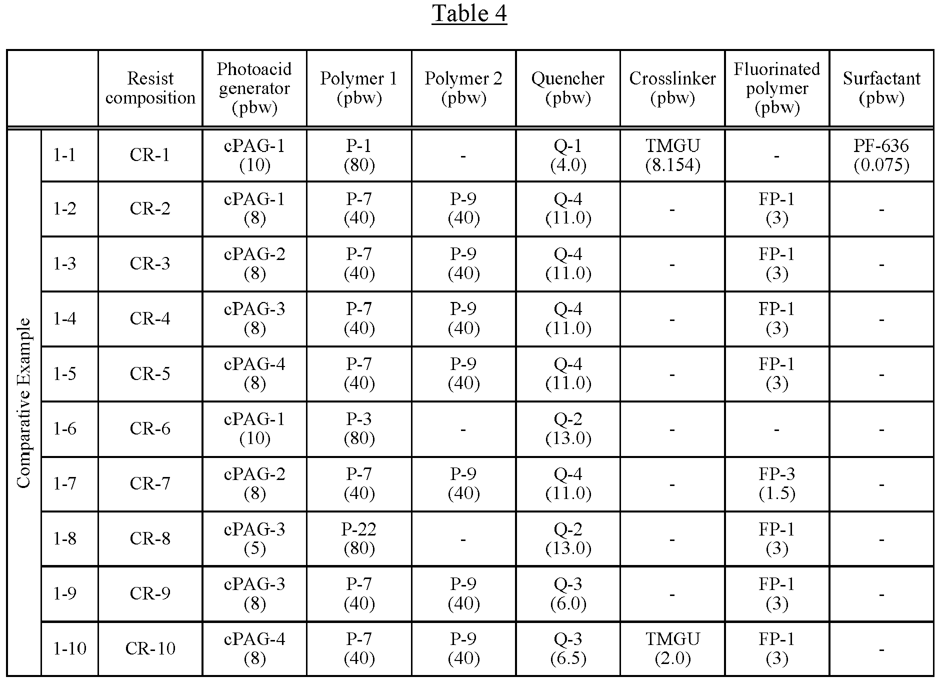

In Tables 2 to 4, photoacid generators PAG-1 to PAG-9, comparative photoacid generators cPAG-1 to cPAG-4, quenchers Q-1 to Q-4, and fluorinated polymers FP-1 to FP-5 have the following structure.

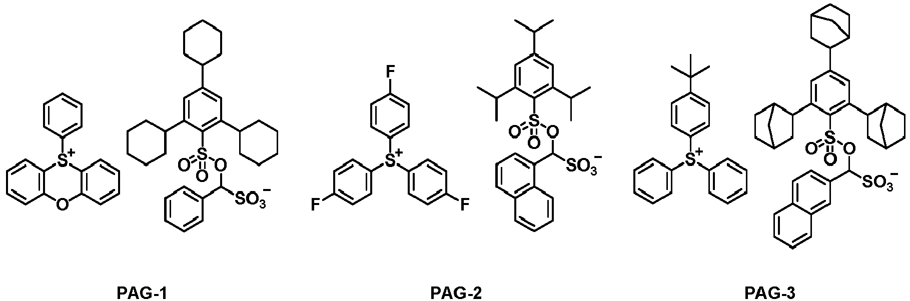

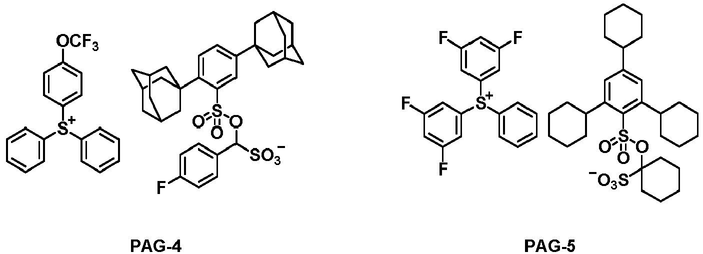

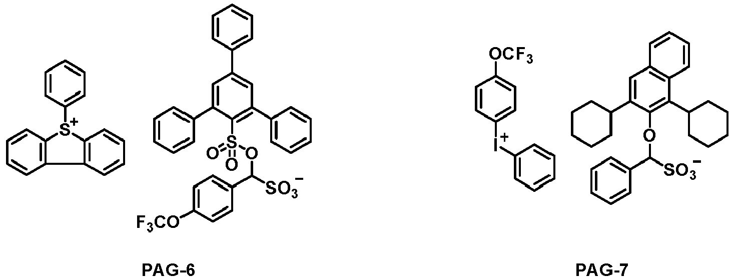

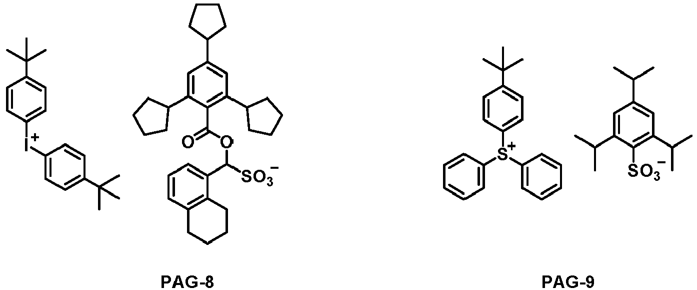

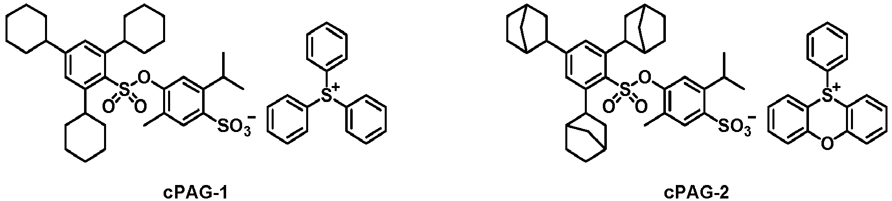

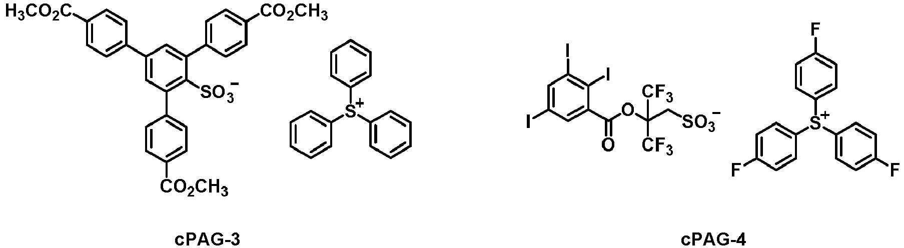

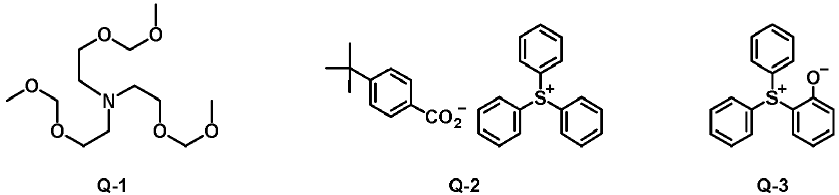

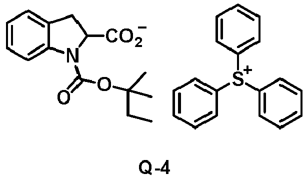

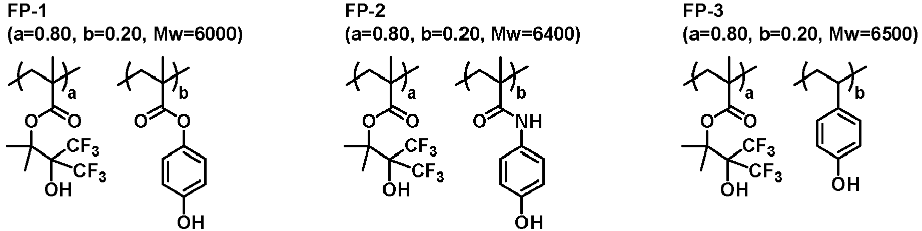

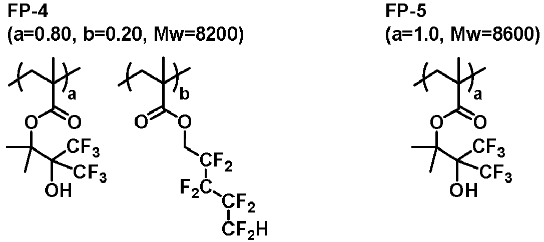

### [2] EB lithography test

### Examples 2-1 to 2-54 and Comparative Examples 2-1 to 2-10

Using a coater/developer system ACT-M (Tokyo Electron Ltd.), each of the negative resist compositions (R-1 to R-54 and CR-1 to CR-10) was spin coated onto a mask blank of 152 mm squares having the outermost surface of a silicon oxide film, which had been vapor primed with hexamethyldisilazane (HMDS), and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 120°C for 600 seconds, and developed in a 2.38 wt% TMAH aqueous solution, thereby yielding a negative pattern.

The resist pattern was evaluated as follows. The patterned mask blank was observed under a top-down scanning electron microscope (TDSEM). The optimum dose (Eop) was defined as the exposure dose (µC/cm²) which provided a 1:1 resolution at the top and bottom of a 200-nm 1:1 line-and-space (LS) pattern. The resolution (or maximum resolution) was defined as the minimum line width of a LS pattern that could be resolved at the optimum dose.

The 200-nm LS pattern printed by exposure at the optimum dose (Eop) was observed under SEM. For each of the edges of 32 lines of the LS pattern, edge detection was carried out at 80 points, from which a 3-fold value (3σ) of the standard deviation (σ) or variation was determined and reported as LER (nm). It was judged by visual observation whether or not the pattern profile was rectangular. For the evaluation of pattern fidelity, when a square dot pattern of size 120 nm and density 36% was placed, an area loss (%) at one corner of the square dot was computed. A smaller value indicates that the dot profile is more rectangular. The results are shown in Tables 5 to 7.

**Table 5**

| | | Resist composition | Eop (µC/cm²) | Maximum resolution (nm) | LER (nm) | Pattern profile | Area loss (%) |
|---|---|---|---|---|---|---|---|
| Example | 2-1 | R-1 | 100 | 42 | 5.1 | rectangular | 10 |
| | 2-2 | R-2 | 95 | 43 | 5.0 | rectangular | 10 |
| | 2-3 | R-3 | 105 | 42 | 5.1 | rectangular | 9 |
| | 2-4 | R-4 | 100 | 39 | 4.7 | rectangular | 10 |
| | 2-5 | R-5 | 105 | 37 | 4.6 | rectangular | 9 |
| | 2-6 | R-6 | 100 | 38 | 4.6 | rectangular | 9 |
| | 2-7 | R-7 | 110 | 38 | 4.4 | rectangular | 9 |
| | 2-8 | R-8 | 100 | 37 | 4.3 | rectangular | 9 |
| | 2-9 | R-9 | 100 | 39 | 4.7 | rectangular | 9 |
| | 2-10 | R-10 | 100 | 39 | 4.5 | rectangular | 9 |
| | 2-11 | R-11 | 95 | 37 | 4.3 | rectangular | 9 |
| | 2-12 | R-12 | 100 | 37 | 4.4 | rectangular | 9 |
| | 2-13 | R-13 | 105 | 36 | 4.5 | rectangular | 9 |
| | 2-14 | R-14 | 100 | 39 | 4.4 | rectangular | 9 |
| | 2-15 | R-15 | 110 | 37 | 4.3 | rectangular | 9 |
| | 2-16 | R-16 | 100 | 38 | 4.5 | rectangular | 9 |
| | 2-17 | R-17 | 105 | 39 | 4.4 | rectangular | 9 |
| | 2-18 | R-18 | 100 | 36 | 4.3 | rectangular | 9 |
| | 2-19 | R-19 | 95 | 37 | 4.2 | rectangular | 9 |
| | 2-20 | R-20 | 105 | 37 | 4.3 | rectangular | 9 |
| | 2-21 | R-21 | 95 | 39 | 4.4 | rectangular | 9 |
| | 2-22 | R-22 | 100 | 38 | 4.3 | rectangular | 9 |
| | 2-23 | R-23 | 105 | 37 | 4.5 | rectangular | 9 |
| | 2-24 | R-24 | 95 | 36 | 4.5 | rectangular | 9 |
| | 2-25 | R-25 | 105 | 39 | 4.3 | rectangular | 9 |
| | 2-26 | R-26 | 100 | 37 | 4.3 | rectangular | 9 |
| | 2-27 | R-27 | 95 | 36 | 4.4 | rectangular | 9 |

**Table 6**

| | | Resist composition | Eop (µC/cm²) | Maximum resolution (nm) | LER (nm) | Pattern profile | Area loss (%) |
|---|---|---|---|---|---|---|---|
| Example | 2-28 | R-28 | 100 | 39 | 4.4 | rectangular | 9 |
| | 2-29 | R-29 | 110 | 37 | 4.5 | rectangular | 9 |
| | 2-30 | R-30 | 100 | 39 | 4.3 | rectangular | 9 |
| | 2-31 | R-31 | 95 | 37 | 4.5 | rectangular | 9 |
| | 2-32 | R-32 | 100 | 35 | 4.3 | rectangular | 9 |
| | 2-33 | R-33 | 100 | 38 | 4.3 | rectangular | 9 |
| | 2-34 | R-34 | 95 | 38 | 4.4 | rectangular | 9 |
| | 2-35 | R-35 | 100 | 37 | 4.5 | rectangular | 9 |
| | 2-36 | R-36 | 110 | 36 | 4.4 | rectangular | 9 |
| | 2-37 | R-37 | 105 | 35 | 4.4 | rectangular | 9 |
| | 2-38 | R-38 | 100 | 35 | 4.5 | rectangular | 9 |
| | 2-39 | R-39 | 110 | 36 | 4.5 | rectangular | 9 |
| | 2-40 | R-40 | 105 | 35 | 4.4 | rectangular | 9 |
| | 2-41 | R-41 | 110 | 35 | 4.3 | rectangular | 9 |
| | 2-42 | R-42 | 110 | 36 | 4.5 | rectangular | 9 |
| | 2-43 | R-43 | 105 | 35 | 4.4 | rectangular | 9 |
| | 2-44 | R-44 | 110 | 35 | 4.4 | rectangular | 9 |
| | 2-45 | R-45 | 110 | 36 | 4.3 | rectangular | 9 |
| | 2-46 | R-46 | 105 | 35 | 4.4 | rectangular | 9 |
| | 2-47 | R-47 | 110 | 35 | 4.3 | rectangular | 9 |
| | 2-48 | R-48 | 110 | 35 | 4.4 | rectangular | 9 |
| | 2-49 | R-49 | 105 | 36 | 4.2 | rectangular | 9 |
| | 2-50 | R-50 | 110 | 35 | 4.5 | rectangular | 9 |
| | 2-51 | R-51 | 100 | 35 | 4.3 | rectangular | 9 |
| | 2-52 | R-52 | 110 | 35 | 4.4 | rectangular | 9 |
| | 2-53 | R-53 | 105 | 35 | 4.3 | rectangular | 9 |
| | 2-54 | R-54 | 110 | 35 | 4.4 | rectangular | 9 |

**Table 7**

| | | Resist composition | Eop (µC/cm²) | Maximum resolution (nm) | LER (nm) | Pattern profile | Area loss (%) |
|---|---|---|---|---|---|---|---|
| Comparative Example | 2-1 | CR-1 | 90 | 62 | 6.1 | undercut | 16 |
| | 2-2 | CR-2 | 110 | 51 | 5.7 | footing | 15 |
| | 2-3 | CR-3 | 110 | 52 | 5.4 | footing | 15 |
| | 2-4 | CR-4 | 105 | 48 | 5.4 | footing | 15 |
| | 2-5 | CR-5 | 110 | 50 | 5.5 | footing | 15 |
| | 2-6 | CR-6 | 110 | 48 | 5.3 | footing | 16 |
| | 2-7 | CR-7 | 110 | 52 | 5.7 | footing | 15 |
| | 2-8 | CR-8 | 105 | 52 | 5.5 | footing | 14 |
| | 2-9 | CR-9 | 110 | 52 | 5.6 | footing | 15 |
| | 2-10 | CR-10 | 110 | 50 | 5,6 | footing | 14 |

All the chemically amplified negative resist compositions (R-1 to R-54) within the scope of the invention show satisfactory resolution, reduced LER, pattern rectangularity, and pattern fidelity. The comparative resist compositions (CR-1 to CR-5) lack resolution, LER and pattern rectangularity because the acid generator is of insufficient design.

The resist pattern forming process using the negative resist composition is useful in photolithography for the fabrication of semiconductor devices and the processing of photomask blanks of transmission or reflection type.

## Claims

1. A chemically amplified negative resist composition comprising (A) a photoacid generator in the form of an onium salt having the formula (A) and (B) a base polymer containing a polymer comprising repeat units having the formula (B1), 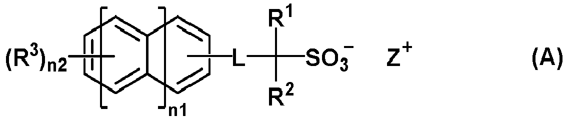 wherein n1 is an integer of 0 to 2, n2 is an integer of 2 to 5 in case of n1=0, an integer of 2 to 7 in case of n1=1, and an integer of 2 to 9 in case of n1=2,
L is a single bond, ether bond, ester bond, sulfonate ester bond, carbonate bond or carbamate bond,
R¹ and R² are each independently hydrogen or a C₃-C₂₀ branched or cyclic hydrocarbyl group which may contain a heteroatom, R¹ and R² are not hydrogen at the same time, and R¹ and R² may bond together to form a ring with the carbon atom to which they are attached,
R³ is each independently iodine or a C₃-C₂₀ branched or cyclic hydrocarbyl group which may contain a heteroatom, at least one R³ being attached to the carbon atom adjoining the carbon atom to which L is attached, and
Z⁺ is an onium cation, 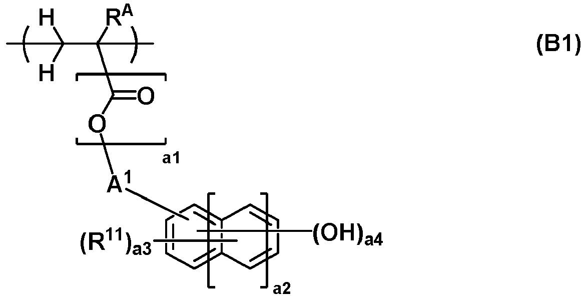
wherein a1 is 0 or 1, a2 is an integer of 0 to 2, a3 is an integer satisfying 0 ≤ a3 ≤ 5+2(a2)-a4, and a4 is an integer of 1 to 3,
R^{A} is hydrogen, fluorine, methyl or trifluoromethyl,
R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
A¹ is a single bond or a C₁-C₁₀ saturated hydrocarbylene group in which some -CH₂-may be replaced by -O-.

2. The negative resist composition of claim 1 wherein Z⁺ is a sulfonium cation having the formula (cation-1) or iodonium cation having the formula (cation-2): 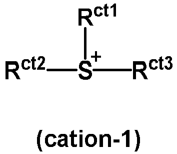 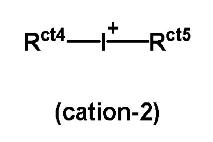 wherein R^{ct1} to R^{ct5} are each independently halogen or a C₁-C₃₀ hydrocarbyl group which may contain a heteroatom, R^{ct1} and R^{ct2} may bond together to form a ring with the sulfur atom to which they are attached.

3. The negative resist composition of claim 1 or 2 wherein the polymer further comprises repeat units having the formula (B2): 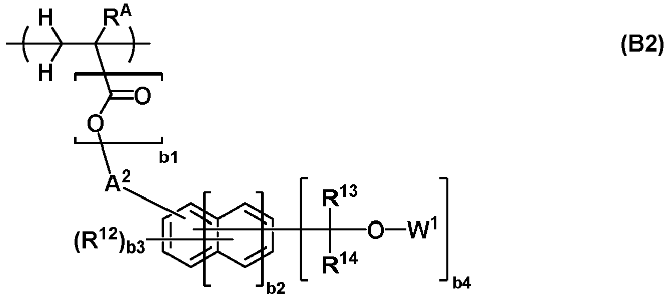 wherein b1 is 0 or 1, b2 is an integer of 0 to 2, b3 is an integer satisfying 0 ≤ b3 ≤ 5+2(b2)-b4, b4 is an integer of 1 to 3,
R^{A} is hydrogen, fluorine, methyl or trifluoromethyl,
R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
R¹³ and R¹⁴ are each independently hydrogen, a C₁-C₁₅ saturated hydrocarbyl group which may be substituted with a hydroxy or saturated hydrocarbyloxy moiety, or an optionally substituted aryl group, R¹³ and R¹⁴ are not hydrogen at the same time, R¹³ and R¹⁴ may bond together to form a ring with the carbon atom to which they are attached,
A² is a single bond or C₁-C₁₀ saturated hydrocarbylene group in which some -CH₂-may be replaced by -O-, and
W¹ is hydrogen, a C₁-C₁₀ aliphatic hydrocarbyl group or an optionally substituted aryl group.

4. The negative resist composition of any one of claims 1 to 3 wherein the polymer further comprises repeat units of at least one type selected from repeat units having the formula (B3), repeat units having the formula (B4), and repeat units having the formula (B5): 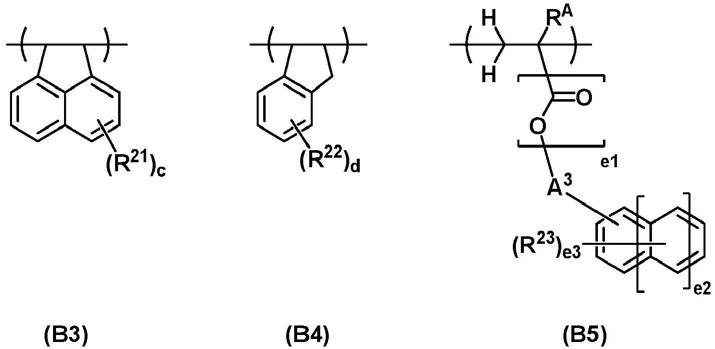 wherein c and d are each independently an integer of 0 to 4, e1 is 0 or 1, e2 is an integer of 0 to 5, and e3 is an integer of 0 to 2,
R^{A} is hydrogen, fluorine, methyl or trifluoromethyl,
R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, cyano group, C₁-C₂₀ saturated hydrocarbylsulfinyl group, or C₁-C₂₀ saturated hydrocarbylsulfonyl group, and
A³ is a single bond or C₁-C₁₀ saturated hydrocarbylene group in which some -CH₂-may be replaced by -O-.

5. The negative resist composition of claim 3 wherein the polymer further comprises repeat units of at least one type selected from repeat units having the formulae (B6) to (B 13): 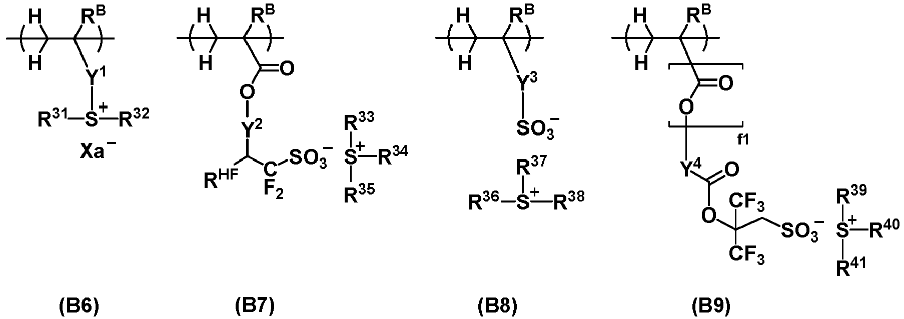 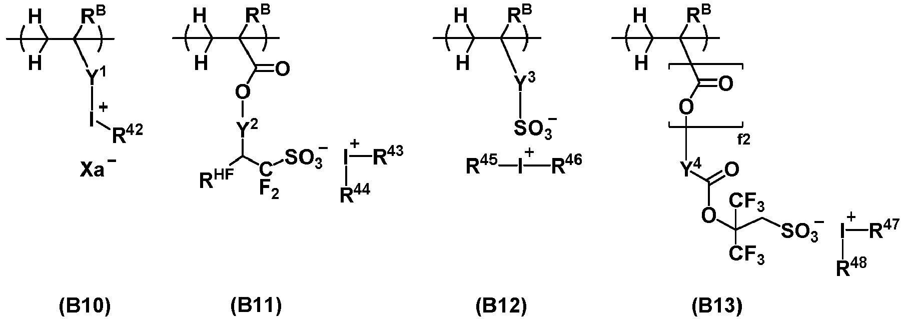 wherein R^{B} is each independently hydrogen or methyl,
Y¹ is a single bond, a C₁-C₆ aliphatic hydrocarbylene group, phenylene group, naphthylene group or C₇-C₁₈ group obtained by combining the foregoing, *-O-Y¹¹-, *-C(=O)-O-Y¹¹-, or *-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
Y² is a single bond or **-Y²¹-C(=O)-O-, Y²¹ is a C₁-C₂₀ hydrocarbylene group which may contain a heteroatom,
Y³ is a single bond, methylene, ethylene, phenylene, fluorinated phenylene, trifluoromethyl-substituted phenylene, *-O-Y³¹-, *-C(=O)-O-Y³¹-, or *-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
* designates a point of attachment to the carbon atom in the backbone, ** designates a point of attachment to the oxygen atom in the formula,
Y⁴ is a single bond or C₁-C₃₀ hydrocarbylene group which may contain a heteroatom, f1 and f2 are each independently 0 or 1, f1 and f2 are 0 when Y⁴ is a single bond, R³¹ to R⁴⁸ are each independently halogen or a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
R^{HF} is hydrogen or trifluoromethyl, and
Xa⁻ is a non-nucleophilic counter ion.

6. The negative resist composition of claim 5 wherein the polymer further comprises repeat units having the formula (B 1-1), repeat units having the formula (B2-1) or repeat units having the formula (B2-2), and repeat units having the formula (B7): 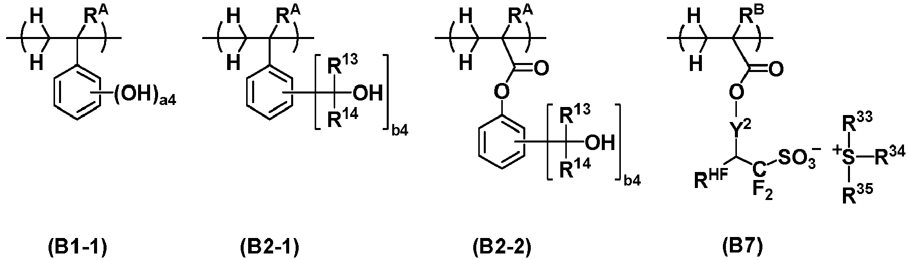 wherein a4, b4, R^{A}, R^{B}, Y², R¹³, R¹⁴, R³³, R³⁴, R³⁵, and R^{HF} are as defined above.

7. The negative resist composition of claim 5 wherein the base polymer (B) further contains a polymer comprising repeat units having formula (B1) and repeat units having formula (B2), but not repeat units having formulae (B6) to (B13).

8. The negative resist composition of any one of claims 1 to 7 wherein repeat units having an aromatic ring structure account for at least 60 mol% of the overall repeat units of the polymer in the base polymer.

9. The negative resist composition of any one of claims 1 to 8, further comprising (C) a crosslinker.

10. The negative resist composition of claim 3 which is free of a crosslinker.

11. The negative resist composition of any one of claims 1 to 10, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 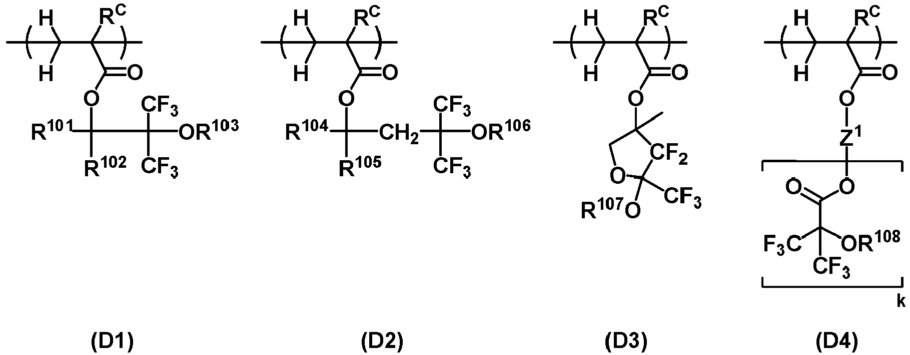 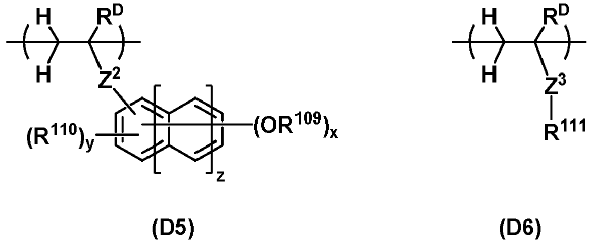 wherein x is an integer of 1 to 3, y is an integer satisfying 0 ≤ y ≤ 5+2z-x, z is 0 or 1, k is an integer of 1 to 3,
R^{C} is each independently hydrogen, fluorine, methyl or trifluoromethyl,
R^{D} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some -CH₂- may be replaced by an ester bond or ether bond,
Z¹ is a C₁-C₂₀ (k+1)-valent hydrocarbon group or C₁-C₂₀ (k+1)-valent fluorinated hydrocarbon group,
Z² is a single bond, *-C(=O)-O- or *-C(=O)-NH-, * designates a point of attachment to the carbon atom in the backbone,
Z³ is a single bond, -O-, *-C(=O)=O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.

12. The negative resist composition of any one of claims 1 to 11, further comprising (E) a quencher.

13. The negative resist composition of any one of claims 1 to 12, further comprising (E) an organic solvent.

14. A resist pattern forming process comprising the steps of:
applying the chemically amplified negative resist composition of any one of claims 1 to 13 onto a substrate to form a resist film thereon,
exposing the resist film patternwise to high-energy radiation, and
developing the exposed resist film in an alkaline developer.

15. A mask blank of transmission or reflection type which is coated with the chemically amplified negative resist composition of any one of claims 1 to 13.
